(19) Europäisches Patentamt
European Patent Office
Office européen des brevets

(11) EP 0 915 144 A1

(12) EUROPEAN PATENT APPLICATION

(43) Date of publication:
**12.05.1999 Bulletin 1999/19**

(51) Int. Cl.$^6$: **C09K 11/06**, H05B 33/14, C09K 19/00

(21) Application number: **98120668.3**

(22) Date of filing: **04.11.1998**

(84) Designated Contracting States:
**AT BE CH CY DE DK ES FI FR GB GR IE IT LI LU MC NL PT SE**
Designated Extension States:
**AL LT LV MK RO SI**

(30) Priority: **04.11.1997 JP 316654/97**
**04.11.1997 JP 316656/97**

(71) Applicant:
**DAI NIPPON PRINTING CO., LTD.**
**Tokyo 162-01 (JP)**

(72) Inventors:
- **Hanna, Junichi**
  **Yokohama-shi, Kanagawa-ken (JP)**
- **Kogo, Kyoko,**
  **Dai Nippon Printing Co.,Ltd.**
  **Shinjuku-ku, Tokyo-to (JP)**
- **Kafuku, Komei**
  **Las Vegas, Nevada 89113 (US)**

(74) Representative:
**Müller-Boré & Partner**
**Patentanwälte**
**Grafinger Strasse 2**
**81671 München (DE)**

(54) **Fluorescent liquid crystalline charge transfer materials**

(57) The present invention relates to novel charge transfer materials which have both the advantageous properties of amorphous materials such as structural flexibility and uniformity over large areas, and those of crystalline materials such as molecular orientation and which are excellent in charge transferability, thin-film formability, and durability of various types. The liquid crystalline charge transfer materials have the following structure (A) containing a fluorescent skeletal structure Y, and the core Z of a liquid crystal:

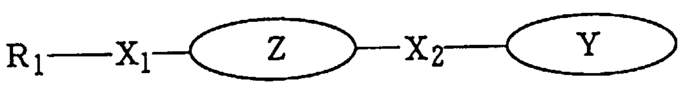

(A)

in which $R_1$, which may directly be combined with Z without interposing $X_1$, represents a saturated or unsaturated, and linear, branched or cyclic hydrocarbon group having 1 to 22 carbon atoms; and $X_1$ and $X_2$ represent oxygen atom, sulfur atom, or -CO-, -OCO-, -COO-, -N=CH-, -CONH-, -NH-, -NHCO- or -$CH_2$- group; or

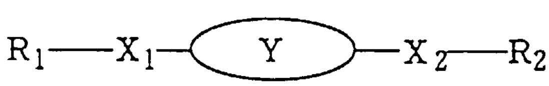

(B)

in which $R_1$ and $R_2$, which may directly be combined with Y without interposing $X_1$ and $X_2$, each represent a saturated or unsaturated, and linear, branched or cyclic hydrocarbon group having 1 to 22 carbon atoms; and $X_1$ and $X_2$ represent oxygen atom, sulfur atom, or -CO-, -OCO-, -COO-, -N=CH-, -CONH-, -NH-, -NHCO- or - $CH_2$- group.

EP 0 915 144 A1

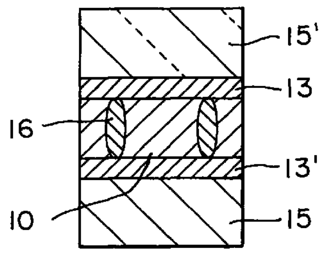


F I G. 1

## Description

The present invention relates to fluorescent liquid crystalline charge transfer materials. More particularly, the present invention relates to liquid crystalline organic materials having fluorescence and charge transferability, and to various elements or devices using these organic materials.

As charge transfer materials, there have conventionally been known those materials which are obtained by dissolving or dispersing charge transfer molecules, which will become charge transfer sites, in matrix materials such as polycarbonate resins; and those materials such as polyvinyl carbazole which have polymer backbones and charge transfer molecular structures as pendants to the backbones. These materials have widely been used for producing photoconductors for use in copying machines, printers, and the like.

In the case of the dispersion-type charge transfer materials in the above-described conventional charge transfer materials, it is desirable for improving charge transferability that charge transfer molecules be highly soluble in a matrix polymer. Practically, however, charge transfer molecules are crystallized in a matrix when the concentration of the charge transfer molecules in the matrix is made high. Therefore, the concentration of charge transfer molecules in a matrix is, in general, limited to 20 to 50% by weight although it depends on the type of the charge transfer molecules. Consequently, the amount of the matrix having no charge transferability becomes 50% by weight or more of the whole material; and, when such a material is made into a film, the sufficiently high charge transferability and speed of response of the charge transfer molecules are restricted by the matrix.

On the other hand, in the case of charge transfer polymers of the above-described pendant type, although the proportion of pendants having charge transferability is high, the polymers have many practical problems in film formability, and also in mechanical strength, environmental stability and durability when they are made into films. Further, in the charge transfer materials of this type, the charge transfer pendants are locally in close proximity. Such locally close pendants become stable sites when hopping of electric charges is conducted, and act as a land of traps. Consequently, the mobility of electric charges is lowered.

Furthermore, the features of the above-described amorphous materials, viewed from electrical characteristics are different from those of crystalline materials; and the amorphous materials have such a problem that hopping sites have fluctuation in terms of not only space but also energy. For this reason, the mobility of electric charges in the amorphous materials is highly dependent on the concentration of charge transfer sites; and it is generally from about $10^{-6}$ to $10^{-5}$ $cm^2/vs$. This value is much smaller than the mobility of electric charges in molecular crystals, which is in the range of 0.1 to 1 $cm^2/vs$. Moreover, there is such a problem that the charge transferabiltiy is highly dependent on both temperature and electric field strength. This is the great difference between the amorphous charge transfer materials and crystalline ones.

In addition, for such applications that require charge transfer layers having large areas, polycrystalline charge transfer materials are anticipated because they can uniformly be made into charge transfer films having large areas. However, polycrystalline materials are essentially unhomogeneous from the microscopical point of view. They have therefore some problems; for example, it is necessary to suppress those defects which will be formed on particle-particle interfaces.

An object of the present invention is therefore to solve the aforementioned problems in the prior art, thereby providing novel charge transfer materials which have both the advantageous properties of amorphous materials such as structural flexibility and uniformity over large areas, and those of crystalline materials such as molecular orientation and which are excellent in charge transferability, thin-film formability, and durability of various types.

Further, we also found that some of the above-described novel charge transfer materials themselves are fluorescent. When a display element such as an electro-luminescent element is composed by using such a charge transfer material, it is not necessary to introduce any fluorescent material which tends to impede the orientation of molecules in a liquid crystal. Therefore, the present invention also provides charge transfer materials which are free from lowering of charge transferability, which do not change the nature of liquid crystals and which can attain high mobility of electric charges.

Furthermore, the liquid crystalline materials of the present invention have both charge transferability and fluorescence. Therefore, when they are used, for example, as electro-luminescent elements, the electro-luminescent elements can be produced by using only the liquid crystalline materials, and the production process of the elements can thus be simplified, although it is necessary, for composing conventional electro-luminescent elements, to use two or three layers of an electron transfer layer; a hole transfer layer and a luminescent layer respectively made from materials having electron transferability, hole transferability or fluorescence.

The above-described object is attained by the present invention which will be described hereinafter. Namely, a first embodiment of the present invention is a liquid crystalline charge transfer material having the following structure (A) containing a fluorescent skeletal structure Y, and the core Z of a liquid crystal:

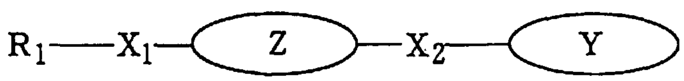 (A)

wherein $R_1$, which may directly be combined with Z without interposing $X_1$. represents a saturated or unsaturated, and linear, branched or cyclic hydrocarbon group having 1 to 22 carbon atoms; and $X_1$ and $X_2$ represent oxygen atom, sulfur atom, or -CO-, -OCO-, -COO-, -N=CH-, -CONH-, -NH-, -NHCO- or $-CH_2-$ group.

A second embodiment of the present invention is a liquid crystalline charge transfer material having the following skeletal structure (B) containing the fluorescent core Y of a liquid crystal:

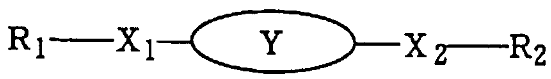 (B)

wherein $R_1$ and $R_2$, which may directly be combined with Y without interposing $X_1$ and $X_2$, each represent a saturated or unsaturated, and linear, branched or cyclic hydrocarbon group having 1 to 22 carbon atoms; and $X_1$ and $X_2$ represent oxygen atom, sulfur atom, or -CO-, -OCO-, -COO-, -N=CH-, -CONH-, -NH-, -NHCO- or - $CH_2$- group.

Liquid crystalline molecules have self-orienting property due to their structures. Therefore, in the case of charge transfer in which liquid crystalline molecules are used as hopping sites, scattering of hopping sites in terms of both space and energy is prevented unlike in the case of charge transfer utilizing the previously-mentioned molecule-dispersed materials, and band-like charge transfer which can be seen in molecular liquid crystals is thus attained. For this reason, the liquid crystalline molecules can attain extremely high mobility of electric charges as compared with the conventional molecule-dispersed materials; and, moreover, the mobility is not dependent on electric field. In addition, by introducing fluorescent skeletal structures to the above-described liquid crystalline molecules having self-orienting property, there can be obtained liquid crystalline charge transfer materials whose self-orienting property is not adversely affected by the addition of fluorescent materials.

In the drawings,

Fig. 1 is a schematic view showing an electro-luminescent element;
Fig. 2 is a schematic view showing an electro-luminescent element (an example of electrode pattern);
Fig. 3 is a schematic view showing an electro-luminescent element;
Fig. 4 is a schematic view showing an electro-luminescent element;
Fig. 5 is a schematic view showing an optical sensor;
Fig. 6 is a schematic view showing an optical sensor;
Fig. 7 is a schematic view showing an optical sensor;
Fig. 8 is a schematic view showing an image-displaying element;
Fig. 9 is a schematic view showing an image-recording device;
Fig. 10 is a schematic view showing an image-recording device;
Fig. 11 is a schematic view showing a spacial optical modulator; and
Fig. 12 is a schematic view showing a thin-film transistor.

By showing preferable embodiments of the present invention, the present invention will be described more specifically.

Liquid crystalline charge transfer materials of the present invention will be enumerated below. Among the following charge transfer materials, preferable ones are those liquid crystalline charge transfer materials which fulfill the previously-mentioned requirements, and, at the same time, have the core ($6\pi$ electron system aromatic ring)$_l$, ($10\pi$ electron system aromatic ring)$_m$ or ($14\pi$ electron system aromatic ring)$_n$ (where l, m and n are an integer of 0 to 4, provided that $l + m + n = 1$ to 4), the $6\pi$ electron system aromatic ring being combined through a combining group having carbon-carbon double bond or carbon-carbon triple bond. The number of the aromatic rings combined are restricted by taking mobility of electric charges into consideration. Examples of $6\pi$ electron system aromatic rings include benzene, pyridine, pyrimidine, pyridazine, pyrazine and tropolone rings; examples of $10\pi$ electron system aromatic rings include naphthalene, azulene, benzofuran, indole, indazole, berizothiazole, benzoxazole, benzimidazole, quinoline, isoquinoline, quinazoline and quinoxaline rings; and $14\pi$ electron system aromatic rings include phenanthrene and anthracene

rings. It has been known that these π electron system aromatic rings show fluorescence when voltage or light is applied thereto. Those charge transfer materials which are preferably used in the present invention have structures combined with these π electron system aromatic rings, so that they are more preferable from the viewpoint of fluorescence.

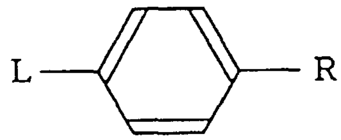

| L | R | Cr | LC |
|---|---|---|---|
| $C_5H_{11}$- | -CO-NH-NH-CO-$CH_2$-CN | K 124 | S 141 I |
| $C_6H_{13}$- | -CO-NH-NH-CO-$CH_2$-CN | K 121 | S 162 I |
| $C_7H_{15}$- | -CO-NH-NH-CO-$CH_2$-CN | K 125 | S 184 I |
| $C_8H_{17}$- | -CO-NH-NH-CO-$CH_2$-CN | K 130 | S 178 I |
| $C_4H_9$-O- | -CO-NH-NH-CO-$CH_2$-CN | K 141 | S 130 I |
| $C_5H_{11}$-O- | -CO-NH-NH-CO-$CH_2$-CN | K 138 | S 149 I |
| $C_6H_{13}$-O- | -CO-NH-NH-CO-$CH_2$-CN | K 133 | S 167 I |
| $C_7H_{15}$-O- | -CO-NH-NH-CO-$CH_2$-CN | K 134 | S 179 I |
| $C_8H_{17}$-O- | -CO-NH-NH-CO-$CH_2$-CN | K 131 | S 188 I |
| $C_9H_{19}$-O- | -CH=CH-CO-NH-NH-CO-$CH_2$-CN | K 142 | S 215 I |

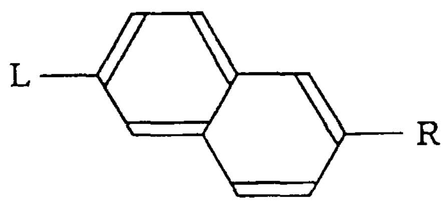

| L | R | | Cr | LC |
|---|---|---|---|---|
| $C_{10}H_{21}$-O- | -COO-$C_3H_6$-SiMe$_2$$C_4H_9$ | | K 1 | A 27 I |
| $C_{10}H_{21}$-O- | -$C_4H_8$-CHMe-O-$C_3H_7$ | 1 | K ? | S 20 S 21 C* 31 A 37 U |

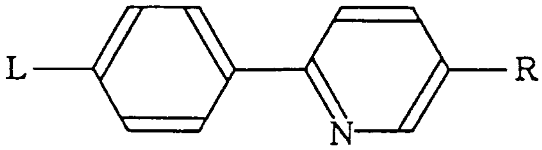

| L | R | Cr | LC |
|---|---|---|---|
| $C_6H_{13}$- | -O-$C_4H_9$ | K 26 | S 44.5 I |
| $C_8H_{17}$- | -O-$C_6H_{13}$ | K 57 | I 37 C 58 A 79 I |
| $C_8H_{17}$- | -O-$C_8H_{17}$ | K 22 | S 37 G 51 F 62 C 77 A 85 I |
| $C_8H_{17}$- | -OOC-$C_5H_{11}$ | K 64 | C 69 N 70 I |
| $C_8H_{17}$- | -OOC-$C_6H_{13}$ | K 61 | C 77 I |
| $C_8H_{17}$- | -OOC-$C_7H_{15}$ | K 41 | F 77 C 85 I |
| $C_8H_{17}$- | -OOC-$C_8H_{17}$ | K 58 | G 48 F 85 C 88 I |
| $C_8H_{17}$- | -OOC-$C_9H_{19}$ | K 36 | G 60 F 92 I |
| $C_8H_{17}$- | -OOC-$C_{10}H_{21}$ | K 13 | G 66 F 93 I |
| $C_8H_{17}$- | -OOC-$C_{11}H_{23}$ | K 26 | G 43 F 96 I |
| $C_4H_9$-O- | -$C_4H_9$ | K 43 | S 62 I |
| $C_4H_9$-O- | -$C_6H_{13}$ | K 50 | S 54 N 61 I |
| $C_4H_9$-O- | -$C_8H_{17}$ | K 33 | B 57.3 C 66.8 A 69.4 I |
| $C_5H_{11}$-O- | -$C_6H_{13}$ | K 20.5 | H 31.5 G 45 F 48.5 C 58 N 60.8 I |
| $C_5H_{11}$-O- | -$C_7H_{15}$ | K 26.5 | G 35 F 48 C 67.5 N 68.7 I |
| $C_5H_{11}$-O- | -$C_8H_{17}$ | K 37.4 | B 52 C 70.1 I |
| $C_5H_{11}$-O- | -$C_9H_{19}$ | K 42.5 | B 65 C 72.4 A 74.5 I |
| $C_5H_{11}$-O- | -$C_{10}H_{21}$ | K 44.4 | B 66.7 C 70.4 A 74.7 I |
| $C_6H_{13}$-O- | -$C_3H_7$ | K 50 | S 72 I |
| $C_6H_{13}$-O- | -$C_6H_{13}$ | K 22 | C 66 N 69 B |
| $C_6H_{13}$-O- | -$C_7H_{15}$ | K 34 | H 31.2 G 44.4 F 53 C 74.4 N 75.2 I |
| $C_6H_{13}$-O- | -$C_8H_{17}$ | K 30 | G 23 I 58 C 77 I |
| $C_6H_{13}$-O- | -$C_9H_{19}$ | K 36 | B 64.4 C 80.5 I |
| $C_6H_{13}$-O- | -$C_{10}H_{21}$ | K 30 | B 67.6 C 80 I |
| $C_7H_{15}$-O- | -$C_5H_{11}$ | K 56.9 | S 61.8 N 68.2 I |
| $C_7H_{15}$-O- | -$C_6H_{13}$ | K 40 | C 68 B |
| $C_7H_{15}$-O- | -$C_7H_{15}$ | K 31 | G 40 I 52 C 77 I |
| $C_7H_{15}$-O- | -$C_8H_{17}$ | K 38.5 | F 56 C 76.5 I |
| $C_7H_{15}$-O- | -$C_9H_{19}$ | K 33 | B 64 C 81.5 I |
| $C_7H_{15}$-O- | -$C_{10}H_{21}$ | K 41 | B 67.8 C 80.8 I |

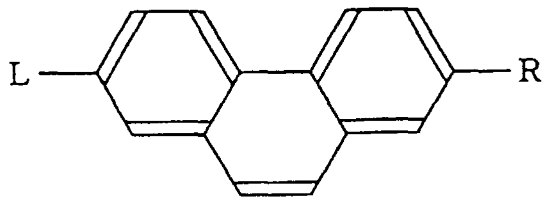

| L | R | Cr | LC |
|---|---|---|---|
| $C_3H_7$- | -CO-$C_7H_{15}$ | K 116 | A 119 I |
| $C_4H_9$- | -CO-$C_6H_{13}$ | K 114 | A 123 I |
| $C_5H_{11}$- | -CO-$C_5H_{11}$ | K 107 | E 83 A 127 I |
| $C_6H_{13}$- | -CO-$C_4H_9$ | K 92 | E 92 A 126 I |
| $C_7H_{15}$- | -CO-$C_3H_7$ | K 75 | E 73 A 107 I |
| $C_8H_{17}$- | -CO-$C_2H_5$ | K 80 | E 55 A 117 I |
| $C_9H_{19}$- | -CO-$C_2H_5$ | K 75 | A 120 I |
| $C_9H_{19}$- | -CO-$C_3H_7$ | K 74 | E 64 A 104 I |
| $C_9H_{19}$- | -CO-$C_4H_9$ | K 71 | A 118 I |
| $C_9H_{19}$- | -CO-$C_5H_{11}$ | K 98 | A 118 I |
| $C_6H_{13}$-O- | -O-$C_6H_{13}$ | K 114 | S 125 I |
| $C_7H_{15}$-O- | -O-$C_7H_{15}$ | K 99 | S 101 S 123 I |
| $C_8H_{17}$-O- | -O-$C_8H_{17}$ | K 90 | S 93 S 122 I |
| $C_9H_{19}$-O- | -O-$C_9H_{19}$ | K 93 | S 119 I |
| $C_{10}H_{21}$-O- | -O-$C_{10}H_{21}$ | K 94 | S 117 I |
| $C_{11}H_{23}$-O- | -O-$C_{11}H_{23}$ | K 98 | S 113 I |
| $C_{12}H_{25}$-O- | -O-$C_{12}H_{25}$ | K 99 | S 109 I |
| $C_4H_9$-CO- | -CO-$C_4H_9$ | K 130 | E 108 A 157 I |
| $C_5H_{11}$-CO- | -CO-$C_5H_{11}$ | K 149 | A 164 I |
| $C_6H_{13}$-CO- | -CO-$C_6H_{13}$ | K 146.5 | A 166 I |
| $C_7H_{15}$-CO- | -CO-$C_7H_{15}$ | K 140 | A 167 I |
| $C_5H_{11}$-COO- | -OOC-$C_5H_{11}$ | K 109 | A 117 B |
| $C_6H_{13}$-COO- | -OOC-$C_6H_{13}$ | K 72 | X 105 A 119 B |
| $C_7H_{15}$-COO- | -OOC-$C_7H_{15}$ | K 57 | X 83 X 93 A 123 B |
| $C_9H_{19}$-COO- | -OOC-$C_9H_{19}$ | K 88 | A 126 B |

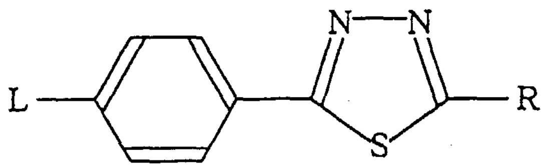

| L | R | | Cr | LC |
|---|---|---|---|---|
| $C_5H_{11}$-O- | -$C_7H_{15}$ | | K 78 | A 73 I |
| $C_6H_{13}$-O- | -$C_6H_{13}$ | | K 79 | A 74 I |
| $C_6H_{13}$-O- | -$C_7H_{15}$ | | K 83 | A 82 I |
| $C_7H_{15}$-O- | -$C_5H_{11}$ | | K 72 | C 74 A 79 I |
| $C_7H_{15}$-O- | -$C_6H_{13}$ | | K 74 | C 81 I |
| $C_7H_{15}$-O- | -$C_7H_{15}$ | | K 79 | C 89 I |
| $C_7H_{15}$-O- | -$C_8H_{17}$ | | K 70 | C 85 I |
| $C_7H_{15}$-O- | -$C_9H_{19}$ | | K 77 | C 89 I |
| $C_7H_{15}$-O- | -$C_{10}H_{21}$ | | K 75 | C 88 I |
| $C_8H_{17}$-O- | -$C_5H_{11}$ | | K 73 | C 69 A 81 I |
| $C_8H_{17}$-O- | -$C_6H_{13}$ | | K 73 | C 80 A 83 I |
| $C_8H_{17}$-O- | -$C_7H_{15}$ | | K 80 | C 87 I |
| $C_8H_{17}$-O- | -$C_8H_{17}$ | | K 80 | C 90 I |
| $C_8H_{17}$-O- | -$C_9H_{19}$ | | K 77 | C 90 I |
| $C_8H_{17}$-O- | -$C_{10}H_{21}$ | | K 78 | G 70 C 90 I |
| $C_9H_{19}$-O- | -$C_5H_{11}$ | | K 69 | G 53 C 66 A 82 I |
| $C_9H_{19}$-O- | -$C_6H_{13}$ | | K 62 | G 61 C 81 A 83 I |
| $C_9H_{19}$-O- | -$C_7H_{15}$ | | K 72 | C 87 I |
| $C_9H_{19}$-O- | -$C_9H_{19}$ | | K 76 | C 90 I |
| $C_{10}H_{21}$-O- | -$C_5H_{11}$ | | K 73 | F 55 C 57 A 84 I |
| $C_{10}H_{21}$-O- | -$C_6H_{13}$ | | K 50.6 | S 65.4 C 81.1 A 85.4 I |
| $C_{10}H_{21}$-O- | -$C_7H_{15}$ | | K 70 | C 89 I |
| $C_{10}H_{21}$-O- | -$C_9H_{19}$ | | K 79 | C 92 I |
| $C_4H_9$-$CMe_2$-$C_4H_8$-O- | -$C_7H_{15}$ | | K 49 | C 33 I |
| $C_4H_9$-$CMe_2$-$C_6H_{12}$-O- | -$C_7H_{15}$ | | K 54 | C 55 I |
| $C_7H_{15}$-COO- | -$C_7H_{15}$ | | K 79 | B 66 A 73 I |
| $C_8H_{17}$-COO- | -$C_9H_{19}$ | | K 85 | C 84.5 I |
| $C_{11}H_{23}$-COO- | -$C_{11}H_{23}$ | | K 88 | B 85 I |
| $C_8H_{17}$-O- | -CHMe-$C_2H_5$ | 1 | K 52 | A 19 I |
| $C_7H_{15}$- | -$C_4H_8$-CHMe-$C_2H_5$ | S | K 42.6 | C* 27.5 A 34 I |

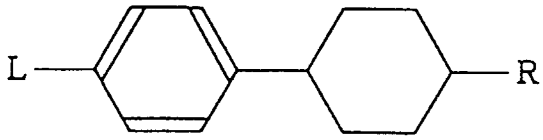

| L | R | | Cr | LC |
|---|---|---|---|---|
| $C_6H_{13}$-O- | -CH=CH-$CH_2$-O-$CH_3$ | | K 16 | B 30 N 38 I |
| $C_7H_{15}$-O- | -CH=CH-$CH_2$-O-$CH_3$ | | K 14 | B 38 I |
| $CH_3$-CO- | -$C_3H_7$ | | K 45 | S 54 I |
| $C_4H_9$-CO- | -$C_5H_{11}$ | | K 60.7 | B 52.5 N 58 I |
| $C_4H_9$-CO- | -$C_7H_{15}$ | | K 56.5 | A 50.5 N 64.3 I |
| $C_6H_{13}$-CO- | -$C_7H_{15}$ | | K 70 | B 71.5 I |
| $C_8H_{17}$-CO- | -$C_7H_{15}$ | | K 70.2 | E 43 B 80.1 I |
| $C_3H_7$-$CF_2$-CO- | -$C_5H_{11}$ | | K 20 | B 33 N 53.9 I |
| $CH_3$-NH-CH%CH-CO- | -$C_6H_{13}$ | | K 107.8 | A 144.3 N 153 I |
| $C_2H_5$-NH-CH%CH-CO- | -$C_6H_{13}$ | | K 68.4 | A 76.8 N 120 I |
| $C_6H_{13}$-NH-CH%CH-CO- | -$C_6H_{13}$ | | K 61 | C 35 N 104.2 I |
| $C_7H_{15}$-NH-CH%CH-CO- | -$C_6H_{13}$ | | K 55.2 | H 40 C 68.9 N 107.8 I |
| $C_8H_{17}$-NH-CH%CH-CO- | -$C_6H_{13}$ | | K 50.8 | H 57.8 C 80.3 N 104 I |
| $C_9H_{19}$-NH-CH%CH-CO- | -$C_6H_{13}$ | | K 54 | H 74.6 C 94.1 N 107.3 I |
| $C_{10}H_{21}$-NH-CH%CH-CO- | -$C_6H_{13}$ | | K 61.3 | H 83.3 C 100.1 N 105.2 I |
| $C_{11}H_{23}$-NH-CH%CH-CO- | -$C_6H_{13}$ | | K 66.7 | H 94.3 C 106.6 N 109.3 I |
| $C_{12}H_{25}$-NH-CH%CH-CO- | -$C_6H_{13}$ | | K 64.1 | H 97.8 C 109 N 109.4 I |
| $C_{13}H_{27}$-NH-CH%CH-CO- | -$C_6H_{13}$ | | K 65 | H 103.2 C 111.4 I |
| $C_{14}H_{29}$-NH-CH%CH-CO- | -$C_6H_{13}$ | | K 55 | H 102.1 C 109.8 I |
| $C_{15}H_{31}$-NH-CH%CH-CO- | -$C_6H_{13}$ | | K 54.2 | H 106.1 C 110.6 I |
| $C_{18}H_{37}$-NH-CH%CH-CO- | -$C_6H_{13}$ | | K 54.1 | H 107.4 I |
| $C_4H_9$-OOC- | -$C_5H_{11}$ | | K 11 | A -4 N -3.2 I |
| $C_3H_7$-COO- | -$C_3H_7$ | | K 11 | B 26.1 N 30.3 I |
| $C_4H_9$-COO- | -$C_3H_7$ | | K 32.3 | B 42.7 I |
| $C_5H_{11}$-COO- | -$C_7H_{15}$ | | K 34.2 | B 64.5 I |
| $C_8H_{17}$-O- | -OOC-$CH_2$-CHMe-$C_3H_6$-CHMe-$CH_3$ | S | K 53 | B 39 I |
| $C_{10}H_{21}$-O- | -OOC-CHF-$C_4H_9$ | S | K 42.5 | B 41 I |
| $C_5H_{11}$-COO- | -OOC-CHF-$C_4H_9$ | R | K 42 | B 59 I |
| $C_6H_{13}$-COO- | -OOC-CHF-$C_4H_9$ | R | K 52 | B 59 I |
| $C_7H_{15}$-COO- | -OOC-CHF-$C_4H_9$ | R | K 42 | B 64 I |

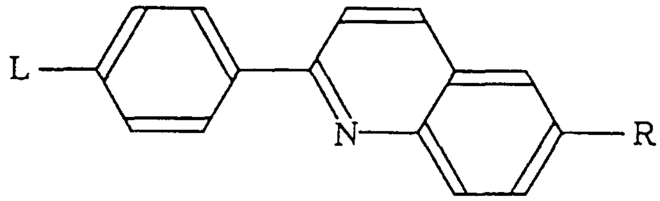

| L | R | Cr | LC |
|---|---|---|---|
| $C_2H_5$-O- | -CN | K 150 | S 144 N 189 I |
| $C_8H_{17}$- | -$C_6H_{13}$ | K 68 | C 106 N 116 I |
| $C_5H_{11}$- | -O-$C_4H_9$ | K 77 | S 76 N 118 I |
| $C_5H_{11}$-O- | -$C_5H_{11}$ | K 73 | C 77 N 118 I |
| $C_5H_{11}$-O- | -$C_6H_{13}$ | K 73 | C 88 N 114 I |
| $C_5H_{11}$-O- | -$C_7H_{15}$ | K 71 | C 96 A 98 N 118 I |
| $C_5H_{11}$-O- | -$C_8H_{17}$ | K 73 | C 92 A 105 N 112 I |
| $C_6H_{13}$-O- | -$C_5H_{11}$ | K 68 | C 93 N 125 I |
| $C_6H_{13}$-O- | -$C_6H_{13}$ | K 66 | C 98 N 117 I |
| $C_6H_{13}$-O- | -$C_7H_{15}$ | K 65 | C 104 A 106 N 121 I |
| $C_6H_{13}$-O- | -$C_8H_{17}$ | K 69 | C 104 A 113 N 117 I |
| $C_7H_{15}$-O- | -$C_5H_{11}$ | K 73 | C 98 N 121 I |
| $C_7H_{15}$-O- | -$C_6H_{13}$ | K 70 | C 105 N 116 I |
| $C_7H_{15}$-O- | -$C_7H_{15}$ | K 70 | C 109 A 113 N 120 I |
| $C_7H_{15}$-O- | -$C_8H_{17}$ | K 71 | C 109 A 115 N 116 I |
| $C_8H_{17}$-O- | -$C_5H_{11}$ | K 72 | C 104 N 120 I |
| $C_8H_{17}$-O- | -$C_6H_{13}$ | K 68 | C 106 N 116 I |
| $C_8H_{17}$-O- | -$C_7H_{15}$ | K 70 | C 109 A 117 N 120 I |
| $C_8H_{17}$-O- | -$C_8H_{17}$ | K 69 | C 113 A 118 I |
| $C_9H_{19}$-O- | -$C_5H_{11}$ | K 76 | C 107 A 109 N 118 I |
| $C_9H_{19}$-O- | -$C_6H_{13}$ | K 76 | C 111 A 113 N 116 I |
| $C_9H_{19}$-O- | -$C_7H_{15}$ | K 76 | C 113 A 119 I |
| $C_9H_{19}$-O- | -$C_8H_{17}$ | K 75 | C 114 A 117 I |
| $C_{10}H_{21}$-O- | -$C_5H_{11}$ | K 77 | C 107 A 113 N 118 I |
| $C_{10}H_{21}$-O- | -$C_6H_{13}$ | K 75 | C 110 A 114 N 116 I |
| $C_{10}H_{21}$-O- | -$C_7H_{15}$ | K 74 | C 114 A 119 I |
| $C_{10}H_{21}$-O- | -$C_8H_{17}$ | K 68 | C 114 A 116 I |
| $C_{11}H_{23}$-O- | -$C_5H_{11}$ | K 83 | C 105 A 114 N 116 I |
| $C_{11}H_{23}$-O- | -$C_6H_{13}$ | K 82 | C 110 A 115 I |
| $C_{11}H_{23}$-O- | -$C_7H_{15}$ | K 81 | C 113 A 118 I |

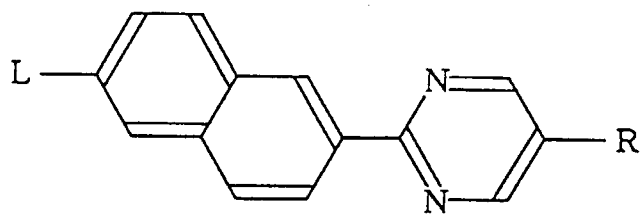

| L | R | | Cr | LC |
|---|---|---|---|---|
| $C_7H_{15}$- | -CN | | K 125.6 | S 154.1 N 163.7 I |
| $C_8H_{17}$-O- | -O-$C_8H_{17}$ | | K 93 | C 105 A 111 N 129 I |
| $C_8H_{17}$-O- | -O-$CH_2$-CH/O\CH(t)-$C_4H_9$ | S | K 85 | C* 128.4 A 130.5 N* 141 I |

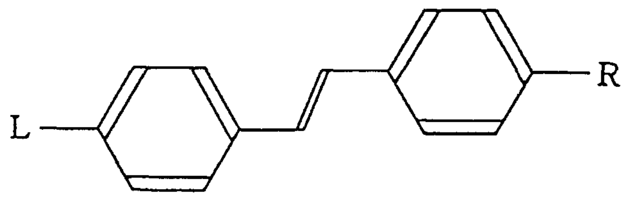

| L | R | | Cr | LC |
|---|---|---|---|---|
| NC- | $-O-C_5H_{10}-SiMeCl_2$ | | K 119.4 | S 191.4 I |
| $C_{10}H_{21}-O-$ | -H | | K 106.8 | B 94 I |
| $C_7H_{15}-$ | -CN | | K 61.5 | S 73.5 N 98 I |
| $C_8H_{17}-$ | -CN | | K 52 | S 57.5 A 80 N 89 B |
| $C_9H_{19}-$ | -CN | | K 56.2 | A 94.4 N 96.7 I |
| $C_{10}H_{21}-$ | -CN | | K 47.2 | A 95.1 I |
| $C_{11}H_{23}-$ | -CN | | K 85.5 | A 100.2 I |
| $C_7H_{15}-O-$ | -CN | | K 80 | A 80.5 N 126 B |
| $C_8H_{17}-O-$ | -CN | | K 103 | A 110 N 128 B |
| $C_{10}H_{21}-O-$ | -CN | | K 87 | A 129 B |
| $C_{17}H_{36}-CONH-$ | -CN | | K 144 | S 159 I |
| $C_2H_5-CHMe-C_4H_8-$ | -CN | 1 | K 59.4 | S 67.2 I |
| $C_2H_5-CHMe-C_5H_{10}-$ | -CN | 1 | K 44.7 | S 68.3 I |
| $C_7H_{15}-O-$ | $-NO_2$ | | K 77.5 | A 94 N 106.5 B |
| $C_8H_{17}-O-$ | $-NO_2$ | | K 111 | A 111 N 114 I |
| $C_{10}H_{21}-O-$ | $-NO_2$ | | K 97 | A 116 I |
| $C_{12}H_{25}-O-$ | $-NO_2$ | | K 85 | A 115 I |
| $C_{12}H_{25}-NH-$ | $-NO_2$ | | K 109 | E 141 I |
| $C_{18}H_{37}-NH-$ | $-NO_2$ | | K 112.1 | E 132 I |
| $C_{17}H_{35}-CONH-$ | $-NO_2$ | | K 139 | A 160 B |
| $C_8H_{17}-$ | $-C_8H_{17}$ | | K 46 | H 106 G 108 I |
| $C_9H_{19}-$ | $-C_9H_{19}$ | | K 41 | H 93 G 109 I |
| $C_{10}H_{21}-$ | $-C_{10}H_{21}$ | | K 64 | H 92 G 106 I |
| $C_{11}H_{23}-$ | $-C_{11}H_{23}$ | | K 61 | S 70 H 85 G 106 I |
| $C_{12}H_{25}-$ | $-C_{12}H_{25}$ | | K 75 | S 77 H 81 G 103 I |
| $C_5H_{11}-$ | $-O-CH_3$ | | K 118 | B 109.8 N 124.7 I |
| $C_5H_{11}-$ | $-O-C_8H_{17}$ | | K 121.3 | S 121.1 S 125.5 S 131 I |
| $CH_3-O-$ | $-O-C_9H_{19}$ | | K 149 | S 142.5 N 142.6 I |
| $CH_3-O-$ | $-O-C_{12}H_{25}$ | | K 142 | S 136 I |
| $CH_3-O-$ | $-O-C_{14}H_{29}$ | | K 139 | S 132 I |

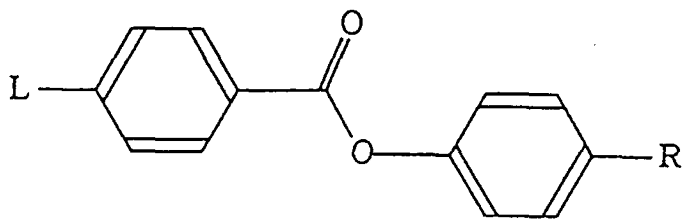

| L | R | Cr | LC |
|---|---|---|---|
| $C_9H_{19}$- | $-O-C_7H_{15}$ | K 46 | C 41 N 61 I |
| $C_9H_{19}$- | $-O-C_8H_{17}$ | K 53 | C 48 N 64 I |
| $C_9H_{19}$- | $-O-C_9H_{19}$ | K 54 | C 52 N 63 I |
| $C_9H_{19}$- | $-O-C_{10}H_{21}$ | K 58.7 | C 57.9 N 65.8 I |
| $C_9H_{19}$- | $-O-C_{12}H_{25}$ | K 62.1 | B 47.5 C 63.1 A 63.8 N 66.5 I |
| $C_9H_{19}$- | $-O-C_{14}H_{29}$ | K 63.7 | B 55.7 C 65.4 A 66.8 I |
| $C_9H_{19}$- | $-O-C_{16}H_{33}$ | K 69.4 | B 61.3 C 66.4 A 67.6 I |
| $C_{10}H_{21}$- | $-O-C_5H_{11}$ | K 52.5 | A 42.4 N 52.5 I |
| $C_{10}H_{21}$- | $-O-C_6H_{13}$ | K 44.1 | B 33.6 A 47.7 N 59 I |
| $C_{10}H_{21}$- | $-O-C_7H_{15}$ | K 52.8 | B 38.2 C 40.6 A 51.7 N 58.7 I |
| $C_{10}H_{21}$- | $-O-C_8H_{17}$ | K 55.2 | B 40.5 C 52.4 A 55.9 N 62.5 I |
| $C_{10}H_{21}$- | $-O-C_{10}H_{21}$ | K 61.4 | B 45.9 C 60.5 A 62.1 N 64.5 I |
| $C_{10}H_{21}$- | $-O-C_{12}H_{25}$ | K 64.5 | B 51 C 64.1 A 65.7 I |
| $C_{10}H_{21}$- | $-O-C_{14}H_{29}$ | K 65.2 | B 58.1 C 66.7 I |
| $C_{10}H_{21}$- | $-O-C_{16}H_{33}$ | K 67.2 | B 64.2 C 69.6 I |
| $C_{12}H_{25}$- | $-O-C_{16}H_{33}$ | K 73.7 | B 68.9 C 71 I |
| $C_6H_{13}$- | $-CO-C_4H_9$ | K 80 | A 76 I |
| $C_6H_{13}$- | $-CO-C_5H_{11}$ | K 91.6 | A 80.4 I |
| $C_6H_{13}$- | $-CO-C_7H_{15}$ | K 91.4 | A 85.8 I |
| $C_9H_{19}$- | $-CO-C_5H_{11}$ | K 86.7 | A 88.5 I |
| $C_{10}H_{21}$- | $-CO-C_4H_9$ | K 81.4 | A 87.3 I |
| $C_{10}H_{21}$- | $-CO-C_5H_{11}$ | K 87.8 | A 93.3 I |
| $C_{10}H_{21}$- | $-CO-C_7H_{15}$ | K 97.1 | A 93 I |
| $C_4H_9$- | $-CO-CH_2-OOC-C_3H_7$ | K 80.2 | S 90.4 N 95.6 I |
| $C_{10}H_{21}$- | $-OOC-C_7H_{15}$ | K 69 | C 61.7 N 70.4 I |
| $C_6H_{13}$-O- | $-C_6H_{13}$ | K 43.7 | A 36.7 N 59.6 I |
| $C_6H_{13}$-O- | $-C_8H_{17}$ | K 43.6 | A 42.1 N 61.6 I |
| $C_6H_{13}$-O- | $-C_9H_{19}$ | K 38.3 | C 26.1 A 40 N 65.2 I |
| $C_6H_{13}$-O- | $-C_{10}H_{21}$ | K 51 | A 49 N 62 I |
| $C_6H_{13}$-O- | $-C_{12}H_{25}$ | K 61.2 | A 51.4 N 62.2 I |

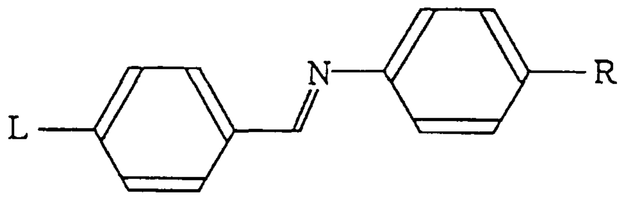

| L | R | Cr | LC |
|---|---|---|---|
| $C_4H_9$-O- | $-CH_3$ | K 65 | G 45 N 72 I |
| $C_4H_9$-O- | $-C_2H_5$ | K 40.5 | G 51 N 65.5 I |
| $C_4H_9$-O- | $-C_4H_9$ | K 8 | G 41 B 45 A 45.5 N 75 I |
| $C_4H_9$-O- | $-C_5H_{11}$ | K 28 | S 30 S 41.5 A 44.4 N 84.6 I |
| $C_4H_9$-O- | $-C_6H_{13}$ | K 26 | B 47.3 A 54.7 N 76.9 I |
| $C_4H_9$-O- | $-C_7H_{15}$ | K 20 | S 29 B 48.8 A 56.6 N 83.3 I |
| $C_4H_9$-O- | $-C_8H_{17}$ | K 33 | B 49.5 A 64.5 N 79 I |
| $C_4H_9$-O- | $-C_9H_{19}$ | K ? | B 48 A 64.7 N 80.2 I |
| $C_4H_9$-O- | $-C_{10}H_{21}$ | K 44.3 | B 46.8 A 64.7 N 76.7 I |
| $C_4H_9$-O- | $-C_{12}H_{25}$ | K 37.5 | G 45.6 B 52.5 A 69.4 N 76.7 I |
| $C_5H_{11}$-O- | $-CH_3$ | K 55 | G 44 N 70.5 I |
| $C_5H_{11}$-O- | $-C_2H_5$ | K 49.2 | G 54.2 N 59 I |
| $C_5H_{11}$-O- | $-C_3H_7$ | K 24 | A 58 N 77.7 B |
| $C_5H_{11}$-O- | $-C_4H_9$ | K 20 | G 51.9 A 52.4 N 69.2 I |
| $C_5H_{11}$-O- | $-C_5H_{11}$ | K 28 | G 46.1 B 48 C 52 A 53 N 77.5 I |
| $C_5H_{11}$-O- | $-C_6H_{13}$ | K 34.5 | G 41 F 44.3 B 51.6 C 53 A 61.1 N 72.9 I |
| $C_5H_{11}$-O- | $-C_7H_{15}$ | K 29.5 | G 33.9 B 51 C 53.1 A 62.8 N 78 I |
| $C_5H_{11}$-O- | $-C_8H_{17}$ | K 43.2 | G 26.2 B 53.7 A 67.8 N 75.1 I |
| $C_5H_{11}$-O- | $-C_9H_{19}$ | K ? | B 52.9 A 68.7 N 76.7 I |
| $C_5H_{11}$-O- | $-C_{10}H_{21}$ | K 41 | B 54 A 67 N 78.2 I |
| $C_5H_{11}$-O- | $-C_{11}H_{23}$ | K ? | B 53 A 70.4 N 75.1 I |
| $C_5H_{11}$-O- | $-C_{12}H_{25}$ | K 37 | B 53.3 A 71 N 73.9 I |
| $C_5H_{11}$-O- | $-C_{13}H_{27}$ | K ? | B 52.9 A 70.2 N 73.2 I |
| $C_5H_{11}$-O- | $-C_{14}H_{29}$ | K ? | B 52.7 A 69.5 N 71.2 I |
| $C_6H_{13}$-O- | $-CH_3$ | K 58 | G 44 B 53 N 76 I |
| $C_6H_{13}$-O- | $-C_2H_5$ | K 47 | G 58 N 70 I |
| $C_6H_{13}$-O- | $-C_3H_7$ | K 29 | G 65.7 A 68 N 85.6 I |
| $C_6H_{13}$-O- | $-C_4H_9$ | K 33.5 | G 58.5 B 59.8 A 70.1 N 77.8 I |
| $C_6H_{13}$-O- | $-C_5H_{11}$ | K 41.9 | G 45.6 B 62 A 75.1 N 85 I |
| $C_6H_{13}$-O- | $-C_6H_{13}$ | K 15 | G 35 B 63 A 77 N 82 I |

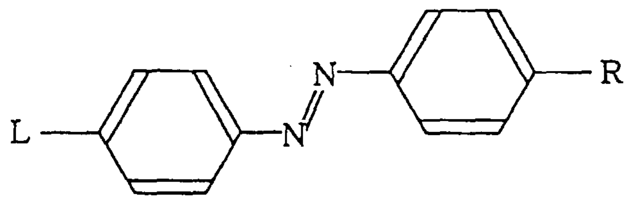

| L | R | Cr | LC |
|---|---|---|---|
| $C_8H_{17}$- | -$C_8H_{17}$ | K 47.9 | A 36.4 N 41.8 I |
| $C_9H_{19}$- | -$C_9H_{19}$ | K 37 | B 40.5 A 53.2 I |
| $C_{10}H_{21}$- | -$C_{10}H_{21}$ | K 42.3 | B 44.6 A 53.7 I |
| $CH_3$- | -O-$C_5H_{11}$ | K 61 | S 48 N 63 I |
| $C_4H_9$- | -O-$C_7H_{15}$ | K 53.7 | C 40.3 N 70.2 I |
| $C_4H_9$- | -O-$C_8H_{17}$ | K 55.2 | B 35 C 54.2 A 57.6 N 75.2 I |
| $C_4H_9$- | -O-$C_9H_{19}$ | K 62.1 | C 58.9 A 63.8 N 73.2 I |
| $C_4H_9$- | -O-$C_{10}H_{21}$ | K 54.4 | B 50.3 C 61.5 A 69.4 N 76.8 I |
| $C_4H_9$- | -O-$C_{12}H_{25}$ | K 62 | I 60 C 64 A 76 N 76.2 I |
| $C_4H_9$- | -O-$C_{14}H_{29}$ | K 64 | S 66 C 69 A 77 I |
| $C_4H_9$- | -O-$C_{18}H_{37}$ | K 72.5 | S 72 A 77 I |
| $C_8H_{17}$- | -O-$C_7H_{15}$ | K 53.2 | C 56.6 A 60.2 N 77.5 I |
| $C_9H_{19}$- | -O-$C_8H_{17}$ | K 49.2 | I 44.8 C 66 A 77.8 N 84.7 I |
| $C_9H_{19}$- | -O-$C_9H_{19}$ | K 51 | I 51.5 C 72.5 A 80.5 N 84.7 I |
| $C_9H_{19}$- | -O-$C_{10}H_{21}$ | K 42.5 | I 62.3 C 77.2 A 87.3 I |
| $C_9H_{19}$- | -O-$C_{12}H_{25}$ | K 41.5 | G 52 I 72.2 C 83 A 88.3 I |
| $C_9H_{19}$- | -O-$C_{14}H_{29}$ | K 51 | G 68 I 81.1 C 88.2 I |
| $C_9H_{19}$- | -O-$C_{16}H_{33}$ | K 57.5 | G 77.7 I 86.2 C 88.6 I |
| $C_9H_{19}$- | -O-$C_{18}H_{37}$ | K 63 | G 81.8 I 89 I |
| $CH_3$-OOC-CH=CH- | -CH=CH-COO-$CH_3$ | K 237 | S 246 S 249 I |
| $CH_3$-OOC-CH=CH- | -CH=CH-COO-$C_2H_5$ | K 237 | S 246 S 249 I |
| $C_2H_5$-OOC-CH=CH- | -CH=CH-COO-$C_2H_5$ | K 156 | A 240 I |
| $C_3H_7$-OOC-CH=CH- | -CH=CH-COO-$C_3H_7$ | K 120 | S 209 I |
| $CH_3$-O- | -CH=CH-COO-$C_2H_5$ | K 117.7 | A 124.2 N 142.8 I |
| $C_2H_5$-O- | -CH=CH-COO-$C_2H_5$ | K 110 | S 137 S 147 N 160 I |
| $C_5H_{11}$-O- | -CH=CH-COO-$C_5H_{11}$ | K 87 | E 91 A 133 I |
| $C_5H_{11}$-O- | -CH=CH-COO-$C_{10}H_{21}$ | K 50.5 | E 64 A 119 I |
| $C_{10}H_{21}$-O- | -CH=CH-COO-$C_5H_{11}$ | K 54 | B 94.5 C 95 A 127.5 I |
| $C_{10}H_{21}$-O- | -CH=CH-COO-$C_{10}H_{21}$ | K 59 | E 60 B 72 C 95 A 116.5 I |
| $CH_3$-COO- | -CH=CH-COO-$C_2H_5$ | K 138.3 | A 153.2 N 162.2 I |

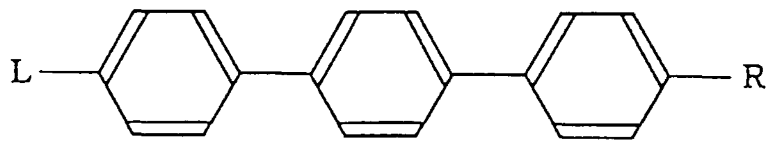

| L | R | | Cr | LC |
|---|---|---|---|---|
| $C_7H_{15}$-O-CHMe-$CH_2$-OOC- | -COO-$CH_2$-CHMe-O-$C_7H_{15}$ | 3 | K 57.8 | A 80.1 I |
| $C_8H_{17}$-O-CHMe-$CH_2$-OOC- | -COO-$CH_2$-CHMe-O-$C_8H_{17}$ | 3 | K 63 | A 84.1 I |
| $CH_3$-COO- | -OOC-$CH_3$ | | K 229 | S 282,5 X 284.5 I |
| $CH_3$-OCOO- | -OCOO-$CH_3$ | | K 229 | S 257 N 277 I |
| $C_2H_5$-OCOO- | -OCOO-$C_2H_5$ | | K 213 | S 225.5 X 242.5 I |
| $C_5H_{11}$- | -CHCN-OOC-CHMe-$C_2H_5$ | 5 | K 124 | A <7 I |
| $C_{10}H_{21}$- | -O-CHMe-$C_5H_{11}$ | R | K 76.5 | S 101.5 S 118 C* 122.5 A 126 I |
| $C_8H_{17}$- | -COO-CHMe-$C_6H_{13}$ | 1 | K 116.5 | A 123.4 I |
| $C_8H_{17}$- | -COO-$CH_2$-CHMe-$C_2H_5$ | 1 | K 104.7 | S 125.1 G* 128.9 B 147.6 A 173.5 I |
| $C_8H_{17}$- | -COO-$CH_2$-CHCl-$CH_2$-CHMe-$CH_3$ | 1 | K 114.2 | G* 106 I* 114.2 A 153.5 I |
| $C_8H_{17}$- | -COO-$CH_2$-CHCN-$CH_2$-CHMe-$CH_3$ | 1 | K 81.8 | B 83.8 A 96.7 I |
| $C_5H_{11}$- | -O-$C_3H_6$-CHMe-$C_2H_5$ | S | K ? | B 198 A 215.5 I |
| $C_{10}H_{21}$- | -O-$C_3H_6$-CHMe-$C_2H_5$ | S | K 85 | S 181.5 C* 188.5 A 191 I |
| $C_8H_{17}$- | -COO-$CH_2$-CHCl-$CH_3$ | 1 | K 54.9 | S 111.7 G* 148.5 C* 149.1 A 195.4 I |
| $C_8H_{17}$- | -COO-$CH_2$-CHCl-$C_4H_9$ | 1 | K 123.6 | G* 130.6 C* 139.7 A 169.5 I |
| $C_8H_{17}$- | -COO-$CH_2$-CHCN-$CH_3$ | 1 | K 138 | C* 151.4 A 168.5 I |
| $C_8H_{17}$- | -COO-$CH_2$-CHCN-$C_2H_5$ | 1 | K 77.8 | G* 99.7 I* 118.6 A 139.6 I |
| $C_8H_{17}$- | -COO-$CH_2$-CHCN-$C_3H_7$ | 1 | K 97 | B 92.8 A 112.7 I |
| $C_8H_{17}$- | -COO-$CH_2$-CHCN-$C_4H_9$ | 1 | K 78.8 | B 86.7 A 101.2 I |
| $C_5H_{11}$- | -O-$CF_3$ | | K 211 | B 221 A 239 I |
| $C_5H_{11}$- | -O-$CF_2$-H | | K 223 | A 241 I |
| $C_3H_7$-O-$CH_2$- | -O-$CH_2$-CH/O\CH(f)-$C_3H_7$ | S | K 210 | E 227.8 A 257.3 I |
| $C_6H_{13}$-CHMe-OOC- | -COO-$CH_2$-CHCl-CHMe-$C_2H_5$ | * | K 55.2 | C* 57.9 A 79.1 I |
| $C_6H_{13}$-CHMe-OOC- | -COO-$CH_2$-CHCl-$CH_2$-CHMe-$CH_3$ | 3 | K 58.9 | C* 54.8 A 61.9 I |
| $C_6H_{13}$-CHMe-OOC- | -COO-$CH_2$-CHCl-$CH_3$ | 3 | K 79.8 | C* 90.4 A 120.2 I |
| $C_6H_{13}$-CHMe-OOC- | -COO-$CH_2$-CHCl-$C_3H_7$ | 3 | K 84.9 | C* 78.3 A 84.3 I |
| $C_6H_{13}$-CHMe-OOC- | -COO-$CH_2$-CHCl-$C_4H_9$ | 3 | K 91.8 | A 83.8 I |
| $C_2H_5$-CHMe-$CH_2$-OOC- | -COO-$CH_2$-CHMe-$C_2H_5$ | 3 | K 132 | A 143 N* 145 I |
| $CH_3$-CHCl-$CH_2$-OOC- | -COO-$CH_2$-CHCl-$CH_3$ | 3 | K 123 | A 135 N* 138 I |
| $C_2H_5$-CHCl-$CH_2$-OOC- | -COO-$CH_2$-CHCl-$C_2H_5$ | 3 | K 137.3 | A 138.3 N* 151.5 BP 152.2 I |

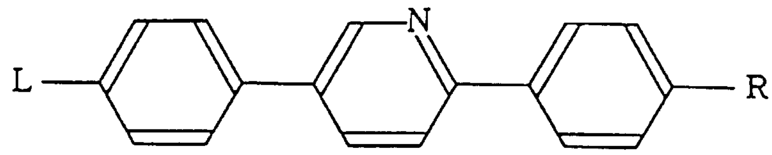

| L | R | | Cr | LC |
|---|---|---|---|---|
| $C_4H_9$-COO-CHMe-$CH_2$-O- | -$C_9H_{19}$ | S | K 82.9 | S 101.2 C* 121.7 I |
| $C_3H_7$-COO-$CH_2$-CHMe-$CH_2$-O- | -$C_6H_{13}$ | R | K ? | S 89 S 114 S 132 C* 145 A 145.5 I |
| $C_3H_7$-O-CHMe-COO-CHMe-$CH_2$-O- | -$C_5H_{11}$ | S | K 76.2 | C* 101 A 113.3 N* 114.9 I |
| $C_3H_7$-O-CHMe-COO-CHMe-$CH_2$-O- | -$C_6H_{13}$ | S | K 75.1 | C* 100.7 A 105.6 N* 109.2 I |
| $C_3H_7$-O-CHMe-COO-CHMe-$CH_2$-O- | -$C_7H_{15}$ | S | K 73.5 | C* 104.2 N* 111.2 I |
| $C_3H_7$-O-CHMe-COO-CHMe-$CH_2$-O- | -$C_9H_{19}$ | S | K 70.1 | C* 102.7 A 107.9 N* 109.5 I |
| $C_4H_9$-O-CHMe-COO-CHMe-$CH_2$-O- | -$C_5H_{11}$ | S | K 78 | C* 93.4 A 111.1 I |
| $C_4H_9$-O-CHMe-COO-CHMe-$CH_2$-O- | -$C_6H_{13}$ | S | K 67.6 | C* 94 A 106.1 I |
| $C_4H_9$-O-CHMe-COO-CHMe-$CH_2$-O- | -$C_7H_{15}$ | S | K 63.5 | C* 97.8 A 106.8 I |
| $C_4H_9$-O-CHMe-COO-CHMe-$CH_2$-O- | -$C_9H_{19}$ | S | K 68.9 | C* 107 I |
| $C_2H_5$-O-$CH_2$-COO-$CH_2$-CHMe-$CH_2$-O- | -$C_6H_{13}$ | R | K 63 | S 77.6 S 122.3 C* 132.3 A 136.8 I |
| $C_3H_7$-O-CHMe-COO-$CH_2$-CHMe-$CH_2$-O- | -$C_6H_{13}$ | R | K ? | S 62 S 99 C* 116 A 117.4 I |
| $C_3H_7$-O-CHMe-COO- | -$C_6H_{13}$ | R | K 110 | S 116 S 132 C* 161.4 I |
| $C_5H_{11}$- | -O-CHMe-$C_6H_{13}$ | 1 | K 78 | A 139 I |
| $C_5H_{11}$- | -O-CHMe-$C_{10}H_{21}$ | -1 | K 70 | A 127 I |
| $C_5H_{11}$-O- | -O-CHMe-$C_6H_{13}$ | 1 | K 104 | S 117 B 132 C* 142 A 165 I |
| $C_4H_9$- | -O-$CH_2$-CHMe-$C_2H_5$ | R | K ? | H 118.5 G* 139.2 F* 144.4 B 156.7 C* 165.8 A 191.4 I |
| $C_7H_{15}$-O- | -O-$CH_2$-CHMe-$C_2H_5$ | 1 | K 114 | E 127 F* 168 C* 213 A 215 I |
| $C_8H_{17}$-O- | -O-$CH_2$-CHMe-$C_2H_5$ | 1 | K 110 | E 122 F* 164 C* 212 A 214 I |
| $C_9H_{19}$-O- | -O-$CH_2$-CHMe-$C_2H_5$ | 1 | K 97 | E 117 F* 160 C* 207 A 208 I |
| $C_{10}H_{21}$-O- | -O-$CH_2$-CHMe-$C_2H_5$ | 1 | K 85 | E 108 F* 146 C* 205 A 206 I |
| $C_8H_{17}$- | -O-$C_4H_8$-CHMe-$C_3H_7$ | 2 | K 67 | S 109 S 180 C 194 A 215 I |
| $C_4H_9$- | -OOC-$C_4H_8$-CHMe-$C_2H_5$ | R | K ? | G* 111.3 F* 152.4 B 182.8 A 207 I |
| $C_4H_9$- | -O-$C_5H_{10}$-CHMe-$C_2H_5$ | R | K 61 | S 98.8 S 102.5 S 170 C* 182.3 A 196.3 I |
| $C_8H_{17}$- | -O-$CH_2$-CHF-$C_6H_{13}$ | R | K 75.4 | S 106 B 153.7 C* 158.5 A 183.3 I |
| $C_6H_{13}$-CHMe-O- | -$C_5H_{11}$ | 1 | K 58 | C* 115 A 116 N* 117 I |
| $C_2H_5$-CHMe-COO-CHMe-$CH_2$-O- | -$C_6H_{13}$ | 3 | K 107 | C* 112 I |
| $C_2H_5$-CHMe-COO-CHMe-$CH_2$-O- | -$C_7H_{15}$ | S | K 101 | C* 113.1 I |
| $C_2H_5$-CHMe-COO-CHMe-$CH_2$-O- | -$C_9H_{19}$ | 3 | K 92.3 | C* 106.6 N* 110.8 I |
| $C_6H_{13}$-CHMe-OOC- | -$C_6H_{13}$ | R | K 57.4 | S 80 S 90.3 C* 94 A 118.5 I |

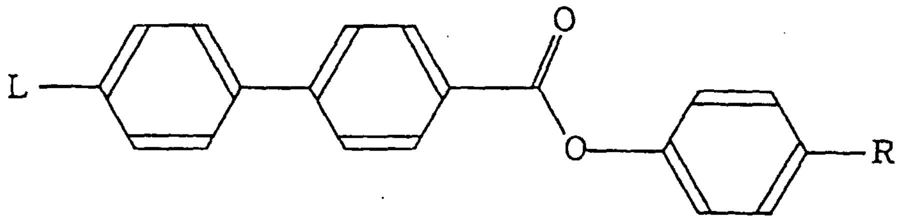

| L | R | | Cr | LC |
|---|---|---|---|---|
| $C_3H_7$- | -COO-$CH_2$-CHMe-$C_2H_5$ | 1 | K 127 | A 158 $N^*$ 166 I |
| $C_5H_{11}$- | -COO-$CH_2$-CHMe-$C_2H_5$ | 1 | K 89 | A 161.8 $N^*$ 162.3 I |
| $C_6H_{13}$- | -COO-$CH_2$-CHMe-$C_2H_5$ | 1 | K 68 | $C^*$ 86 A 157 I |
| $C_7H_{15}$- | -COO-$CH_2$-CHMe-$C_2H_5$ | 1 | K 62 | $C^*$ 90 A 158 I |
| $C_8H_{17}$- | -COO-$CH_2$-CHMe-$C_2H_5$ | 1 | K 67 | $C^*$ 101 A 153 I |
| $C_9H_{19}$- | -COO-$CH_2$-CHMe-$C_2H_5$ | 1 | K 53 | $C^*$ 100 A 151 I |
| $C_{10}H_{21}$- | -COO-$CH_2$-CHMe-$C_2H_5$ | 1 | K 57 | $C^*$ 102 A 148 I |
| $C_{12}H_{25}$- | -COO-$CH_2$-CHMe-$C_2H_5$ | 1 | K 42 | $C^*$ 81 A 175 U |
| $C_5H_{11}$- | -COO-$CH_2$-CHMe-$C_2H_5$ | 2 | K 106.5 | A 163 I |
| $C_8H_{17}$- | -COO-$CH_2$-CHMe-$C_2H_5$ | 2 | K 68.9 | I 51.4 C 103.6 A 154.5 I |
| $C_8H_{17}$- | -COO-$CH_2$-CHMe-$C_3H_7$ | 2 | K 57.2 | I 36.4 C 93.7 A 150.4 I |
| $C_8H_{17}$- | -COO-$CH_2$-CHMe-$C_4H_9$ | 2 | K 54.5 | I 35.7 C 91.7 A 145 I |
| $C_7H_{15}$- | -OCOO-$CH_2$-CHMe-$C_2H_5$ | S | K 88.8 | B 105 A 160.7 $N^*$ 163.8 I |
| $C_8H_{17}$- | -OCOO-$CH_2$-CHMe-$C_2H_5$ | S | K 78.3 | A 150.2 $N^*$ 165.2 I |
| $C_4H_9$-O- | -$CH_2$-CHMe-$C_2H_5$ | S | K 107 | E 102 A 174 $N^*$ 193 I |
| $C_5H_{11}$-O- | -$CH_2$-CHMe-$C_2H_5$ | S | K 91 | E 70 B 96 A 172 $N^*$ 186 I |
| $C_6H_{13}$-O- | -$CH_2$-CHMe-$C_2H_5$ | S | K 88.5 | $J^*$ 84 $C^*$ 103.5 A 172 $N^*$ 182 I |
| $C_7H_{15}$-O- | -$CH_2$-CHMe-$C_2H_5$ | S | K 86.5 | K 66 $J^*$ 70 $I^*$ 79 $C^*$ 126 A 170 $N^*$ 177 I |
| $C_8H_{17}$-O- | -$CH_2$-CHMe-$C_2H_5$ | S | K 77 | K 61 $J^*$ 72 $I^*$ 80 $C^*$ 132 A 171 $N^*$ 174 I |
| $C_9H_{19}$-O- | -$CH_2$-CHMe-$C_2H_5$ | S | K 82 | K 61 $J^*$ 70 $I^*$ 79 $C^*$ 133 A 169 $N^*$ 171 I |
| $C_{10}H_{21}$-O- | -$CH_2$-CHMe-$C_2H_5$ | S | K 38 | K 60 $J^*$ 70 $I^*$ 79 $C^*$ 133 A 167 I |
| $C_{12}H_{25}$-O- | -$CH_2$-CHMe-$C_2H_5$ | S | K 74 | $J^*$ 68 $I^*$ 79 $C^*$ 131 A 162 I |
| $C_{14}H_{29}$-O- | -$CH_2$-CHMe-$C_2H_5$ | S | K 73 | $J^*$ 67 $I^*$ 79 $C^*$ 124 A 157 I |
| $C_{16}H_{33}$-O- | -$CH_2$-CHMe-$C_2H_5$ | S | K 68 | $J^*$ 65 $I^*$ 79 $C^*$ 120 A 154 I |
| $C_{18}H_{37}$-O- | -$CH_2$-CHMe-$C_2H_5$ | S | K 71 | $J^*$ 64.5 $I^*$ 79 $C^*$ 118 A 150 I |
| $C_4H_9$-O- | -$CH_2$-CHMe-$C_2H_5$ | 2 | K 107 | E 103 A 174 N 192 I |
| $C_5H_{11}$-O- | -$CH_2$-CHMe-$C_2H_5$ | 2 | K 90 | E 72 B 98 A 172 N 186 I |
| $C_6H_{13}$-O- | -$CH_2$-CHMe-$C_2H_5$ | 2 | K 88 | G 84 C 103 A 172 N 182 I |
| $C_7H_{15}$-O- | -$CH_2$-CHMe-$C_2H_5$ | 2 | K 86 | H 68 G 70 F 79 C 126 A 170 N 177 I |
| $C_8H_{17}$-O- | -$CH_2$-CHMe-$C_2H_5$ | 2 | K 74 | K 61 J 72 I 79 C 132 A 171 N 174 I |

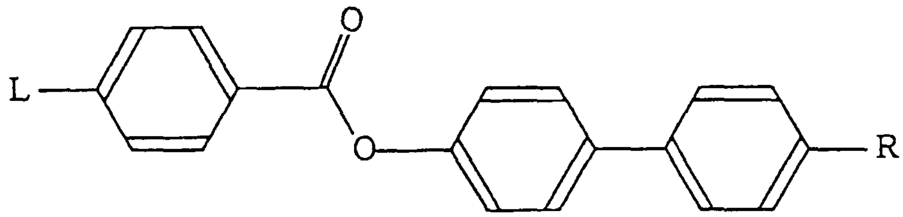

| L | R | | Cr | LC |
|---|---|---|---|---|
| $C_2H_5$-CHMe-$CH_2$- | -O-$C_7H_{15}$ | S | K 65 | J* 85 I* 91 C* 110 N* 154 I |
| $C_2H_5$-CHMe-$CH_2$- | -O-$C_8H_{17}$ | S | K 60 | J* 90 I* 92 C* 114 N* 163 I |
| $C_2H_5$-CHMe-$CH_2$- | -O-$C_9H_{19}$ | S | K 89 | J* 88 I* 90 C* 116 N* 152 I |
| $C_2H_5$-CHMe-$CH_2$- | -O-$C_{10}H_{21}$ | S | K 65 | J* 78 I* 87 C* 117 N* 148 I |
| $C_2H_5$-CHMe-$CH_2$- | -O-$C_{12}H_{25}$ | S | K 60 | J* 70 I* 87 C* 116 N* 136 I |
| $C_2H_5$-CHMe-$CH_2$- | -O-$C_{14}H_{29}$ | 1 | K 80.8 | C* 93.1 A 130.8 U |
| $C_2H_5$-CHMe-$CH_2$- | -O-$C_{10}H_{21}$ | 2 | K 55 | J 78.8 I 90 C 117.3 N 151.8 I |
| $C_2H_5$-CHMe-$CH_2$-O-$C_2H_4$- | -O-$C_{10}H_{21}$ | S | K 79.5 | S 75 C* 115.5 I |
| $C_2H_5$-CHMe-$CH_2$-O-CHMe- | -O-$C_{10}H_{21}$ | 3 | K 89 | C* 95 I |
| $C_2H_5$-CHMe-$CH_2$-NMe-$CH_2$- | -O-$C_8H_{17}$ | S | K 68 | S 103 C* 114 N* 128 I |
| $C_2H_5$-CHMe-$CH_2$-NMe-$CH_2$- | -O-$C_{12}H_{25}$ | S | K <25 | S 93 C* 111 N* 115 I |
| $C_2H_5$-CHMe-$CH_2$-NMe-$CH_2$- | -O-$C_{14}H_{29}$ | S | K 45 | S 83 C* 105 N* 109 I |
| $C_2H_5$-CHMe-$CH_2$-NMe-$CH_2$- | -O-$C_{16}H_{33}$ | S | K 65 | S 82 C* 104 N* 107 I |
| $C_2H_5$-CHMe-$CH_2$-NMe-$CH_2$- | -O-$C_{18}H_{37}$ | S | K 72 | S 75 C* 104 N* 107 I |
| $C_2H_5$-CHMe-$CH_2$-O- | -O-$C_8H_{17}$ | S | K 136.5 | C* 128.8 N* 174 I |
| $C_6H_{13}$-CHMe-$CH_2$-O- | -O-$C_8H_{17}$ | 1 | K 108.2 | C* 125.3 N* 141.3 I |
| $C_2H_5$-CHMe-$CH_2$-OOC- | -O-$C_6H_{13}$ | 1 | K 94 | E 121.3 B 125.6 A 165.9 N* 177.5 I |
| $C_2H_5$-CHMe-$CH_2$-OOC- | -O-$C_8H_{17}$ | 1 | K 85.3 | E 102 B 119 C* 125.9 A 162.9 N* 170.4 I |
| $C_2H_5$-CHMe-$CH_2$-OOC- | -O-$C_{10}H_{21}$ | 1 | K 86.5 | B 97.9 C* 143.5 A 158.8 N* 162.7 I |
| $C_2H_5$-CHMe-$CH_2$-COO- | -O-$C_8H_{17}$ | S | K 110 | C* 148.3 N* 189.9 I |
| $C_2H_5$-CHMe-$CH_2$-O-CHMe-COO- | -O-$C_7H_{15}$ | 3 | K 120 | C* 130 N* 134 I |
| $C_2H_5$-CHMe-$CH_2$-O-CHMe-COO- | -O-$C_8H_{17}$ | 3 | K 115 | C* 135 N* 139 I |
| $C_2H_5$-CHMe-$CH_2$-O-CHMe-COO- | -O-$C_9H_{19}$ | 3 | K 104 | C* 131 N* 133 I |
| $C_2H_5$-CHMe-$CH_2$-O-CHMe-COO- | -O-$C_{10}H_{21}$ | 3 | K 103 | C* 134 I |
| $C_2H_5$-CHMe-$CH_2$-O-CHMe-COO- | -O-$C_{12}H_{25}$ | 3 | K 106 | C* 129 I |
| $C_2H_5$-CHMe-$CH_2$-OCOO- | -O-$C_6H_{13}$ | S | K 99.7 | C* 125.1 N* 185 I |
| $C_2H_5$-CHMe-$CH_2$-OCOO- | -O-$C_8H_{17}$ | S | K 104 | C* 135.9 N* 173.8 I |
| $C_2H_5$-CHMe-$CH_2$-OCOO- | -O-$C_9H_{19}$ | S | K 102.8 | C* 139.8 N* 170.4 I |
| $C_2H_5$-CHMe-$CH_2$-OCOO- | -O-$C_{10}H_{21}$ | S | K 105.6 | C* 142.9 N* 165.8 I |
| $C_2H_5$-CHMe-$CH_2$- | -O-$C_2H_4$-O-$C_4H_9$ | S | K 7 | S 64 C* 76 A 92 N* 126 I |

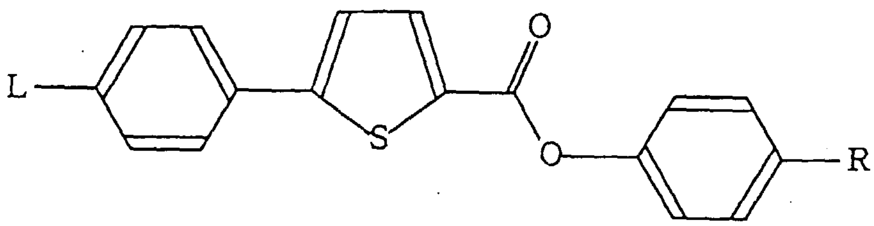

| L | R | | Cr | LC |
|---|---|---|---|---|
| $C_5H_{11}$- | -O-$C_8H_{17}$ | | K 86.3 | C 88.3 N 132.4 I |
| $C_6H_{13}$- | -O-$C_8H_{17}$ | | K 87 | C 102.2 N 126.8 I |
| $C_7H_{15}$- | -O-$C_8H_{17}$ | | K 87.3 | I 76.4 C 112.6 A 123 N 130.9 I |
| $C_8H_{17}$- | -O-$C_8H_{17}$ | | K 87.6 | I 83.4 C 120 A 125 N 128.2 I |
| $C_9H_{19}$- | -O-$C_8H_{17}$ | | K 84.6 | B 92.3 C 124.7 A 129 N 129.5 I |
| $C_{10}H_{21}$- | -O-$C_8H_{17}$ | | K 87.8 | G 94.3 C 127.2 A 128.3 I |
| $C_{10}H_{21}$-O- | -COO-CHMe-$C_6H_{13}$ | 1 | K ? | CA ? C~g ? C* ? I |
| $C_{12}H_{25}$-O- | -COO-CHMe-$C_6H_{13}$ | 1 | K ? | CA ? C~g ? C* ? I |

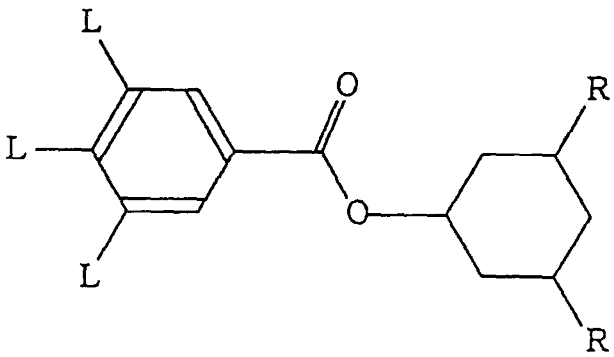

| L | R | | Cr | LC |
|---|---|---|---|---|
| $C_{10}H_{21}$-O- | -OOC-$C_{10}H_{21}$ | | K 40.7 | P -32 I |

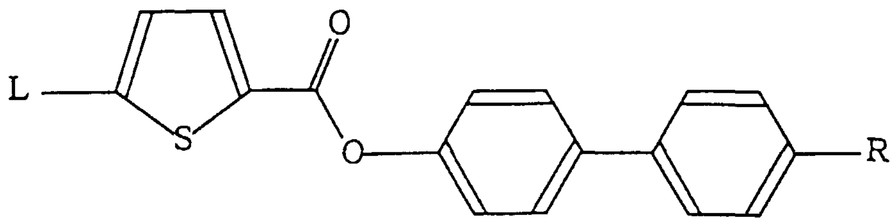

| L | R | Cr | LC |
|---|---|---|---|
| $C_6H_{13}$- | -Br | K 104.5 | S 141.5 N 146.5 I |
| $C_{10}H_{21}$- | -Br | K 95 | S 143 I |
| $C_{12}H_{25}$- | -Br | K 100.5 | S 144.6 I |
| $C_3H_7$- | -CN | K 133.1 | A 107.3 N 209.1 I |
| $C_{12}H_{25}$- | -CN | K 98.5 | S 165 I |
| $C_6H_{13}$- | $-COO-C_3H_6-SiMe_2C_4H_9$ | K 45 | S -17 C 41 A 70 I |
| H- | $-O-C_8H_{17}$ | K 118.7 | F 93 N 116.5 I |
| H- | $-O-C_9H_{19}$ | K 113 | F 94.6 N 114.5 I |
| H- | $-O-C_{10}H_{21}$ | K 110.8 | F 96.5 N 116 I |
| H- | $-O-C_{12}H_{25}$ | K 114.6 | B 99.6 C 99.7 N 115.2 I |
| $C_2H_5$- | $-C_9H_{19}$ | K 89.7 | G 95 N 114.6 I |
| $C_2H_5$- | $-C_{10}H_{21}$ | K 72 | G 66.4 N 109.7 I |
| $C_3H_7$- | $-C_8H_{17}$ | K 88.9 | G 73.6 N 110.8 I |
| $C_3H_7$- | $-C_9H_{19}$ | K 88.2 | G 76.7 N 113.3 I |
| $C_3H_7$- | $-C_{10}H_{21}$ | K 83 | G 74.1 N 110.8 I |
| $C_4H_9$- | $-C_8H_{17}$ | K 90 | G 79 N 104.3 I |
| $C_4H_9$- | $-C_9H_{19}$ | K 71.1 | G 81.6 N 106.6 I |
| $C_4H_9$- | $-C_{10}H_{21}$ | K 70 | K 79.5 J 80.5 F 81.5 I 82.7 N 103.7 I |
| $C_5H_{11}$- | $-C_8H_{17}$ | K 82.4 | G 82.3 N 108.5 I |
| $C_5H_{11}$- | $-C_9H_{19}$ | K 80 | G 85.8 N 110.2 I |
| $C_5H_{11}$- | $-C_{10}H_{21}$ | K 73.2 | K 78.9 J 82.5 F 84.3 I 86.3 C 87.7 N 106.7 I |
| $C_6H_{13}$- | $-C_8H_{17}$ | K 78 | K 80.7 J 82.2 I 85 C 86.7 N 104.5 I |
| $C_6H_{13}$- | $-C_9H_{19}$ | K 74.5 | K 82.6 J 85.4 F 87 I 88.3 C 91.4 N 107.2 I |
| $C_6H_{13}$- | $-C_{10}H_{21}$ | K 67.4 | K 79.2 J 80.9 F 85 I 88 C 92.8 N 103.8 I |
| $C_7H_{15}$- | $-C_8H_{17}$ | K 88 | K 68 J 78 I 81.6 C 91.6 N 107.4 I |
| $C_7H_{15}$- | $-C_9H_{19}$ | K 86.3 | K 79 J 82.2 F 84.8 I 86.4 C 98 N 110.2 I |
| $C_7H_{15}$- | $-C_{10}H_{21}$ | K 76.8 | K 76.6 J 78.1 F 83.4 I 86.5 C 96.6 N 106.7 I |
| $C_8H_{17}$- | $-C_8H_{17}$ | K 87.3 | J 71.1 I 80 C 96.3 N 106.7 I |
| $C_8H_{17}$- | $-C_9H_{19}$ | K 88.8 | J 76.4 F 82.6 I 84.9 C 100.6 N 108.1 I |
| $C_8H_{17}$- | $-C_{10}H_{21}$ | K 75.8 | K 66.1 J 74 F 83.9 I 86.7 C 103 N 107 I |

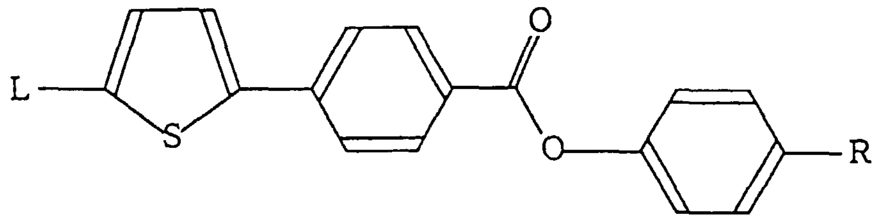

| L | R | Cr | LC |
|---|---|---|---|
| $C_8H_{17}$- | $-C_7H_{15}$ | K 60 | E 54.6 B 81.8 A 128.2 N 128.8 I |
| $C_8H_{17}$- | $-C_8H_{17}$ | K 70 | E 47.7 B 82.2 A 126.6 I |
| $C_4H_9$- | $-O-C_8H_{17}$ | K 84.4 | C 73.9 N 149.5 I |
| $C_4H_9$- | $-O-C_9H_{19}$ | K 92 | C 78.6 N 141.7 I |
| $C_4H_9$- | $-O-C_{10}H_{21}$ | K 88.8 | C 82.8 N 143.8 I |
| $C_8H_{17}$- | $-O-C_5H_{11}$ | K 88.9 | E 84.3 B 99.7 A 137.6 N 147.3 I |
| $C_8H_{17}$- | $-O-C_6H_{13}$ | K 86.1 | E 75.9 B 99.7 C 120.7 A 138.6 N 148.9 I |
| $C_8H_{17}$- | $-O-C_7H_{15}$ | K 91.7 | E 73.3 B 97.8 C 125.8 A 138.8 N 146.2 I |
| $C_8H_{17}$- | $-O-C_8H_{17}$ | K 87 | E 70.1 B 95.2 C 130.5 A 139.5 N 146.4 I |
| $C_8H_{17}$- | $-O-C_9H_{19}$ | K 95.6 | E 68.9 B 95.5 C 130 A 139.5 N 143.2 I |
| $C_8H_{17}$- | $-O-C_{10}H_{21}$ | K 92.3 | E 68.2 B 93.5 C 131 A 138.9 N 142.6 I |
| $C_{10}H_{21}$- | $-O-C_5H_{11}$ | K 90.1 | H 81.5 B 102.8 C 119.6 A 141.1 N 143.2 I |
| $C_{10}H_{21}$- | $-O-C_6H_{13}$ | K 89.5 | H 70 B 99.4 C 131.5 A 142.7 N 145.3 I |
| $C_{10}H_{21}$- | $-O-C_7H_{15}$ | K 94.2 | H 65.5 B 100.5 C 135.7 A 141.7 N 143.1 I |
| $C_{10}H_{21}$- | $-O-C_8H_{17}$ | K 93 | H 62.2 B 99.5 C 138 A 142 N 142.9 I |
| $C_{10}H_{21}$- | $-O-C_9H_{19}$ | K 97 | H 60.5 B 99.9 C 137.8 A 141.1 I |
| $C_{10}H_{21}$- | $-O-C_{10}H_{21}$ | K 96.5 | B 99.5 C 138.3 A 140.7 I |
| $C_{12}H_{25}$- | $-O-C_5H_{11}$ | K 95.8 | H 83.2 G 93.4 B 103.8 C 123.9 A 140.4 I |
| $C_{12}H_{25}$- | $-O-C_6H_{13}$ | K 95.8 | H 86.5 B 103.1 C 134 A 142.1 I |
| $C_{12}H_{25}$- | $-O-C_7H_{15}$ | K 97.4 | H 82 B 102.5 C 137.1 A 140.4 I |
| $C_{12}H_{25}$- | $-O-C_8H_{17}$ | K 97.4 | H 69 B 101.3 C 139.6 A 140.9 I |
| $C_{12}H_{25}$- | $-O-C_9H_{19}$ | K 99.8 | H 63.7 B 102.2 C 139.6 I |
| $C_{12}H_{25}$- | $-O-C_{10}H_{21}$ | K 97.9 | B 102.2 C 139.3 I |

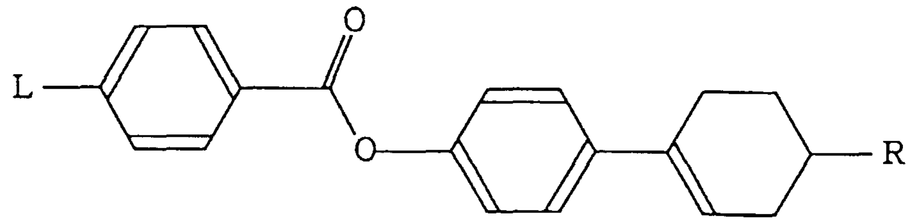

| L | R | | Cr | LC |
|---|---|---|---|---|
| $Me_3Si-O-Me_2Si-C_4H_8-$ | $-C_3H_7$ | 2 | K 65 | G 88 C 93 I |
| $Me_3Si-CH_2-SiMe_2-C_4H_8-$ | $-C_3H_7$ | 2 | K 45 | C 86 I |
| $Me_3Si-C_2H_4-SiMe_2-C_4H_8-$ | $-C_3H_7$ | 2 | K 73 | E 77 C 84 I |
| $Me_3Si-(CH_2-SiMe_2)_2-C_4H_8-$ | $-C_3H_7$ | 2 | K ? | G 43 C 71 I |
| $(Me_3Si-CH_2)_2-SiMe-C_2H_4-SiMe_2-C_4H_8-$ | $-C_3H_7$ | 2 | K ? | G 45 C 55 I |
| $Me_3Si-C_2H_4-SiMe_2-O-SiMe_2-C_4H_8-$ | $-C_3H_7$ | 2 | K 28 | C 72 I |

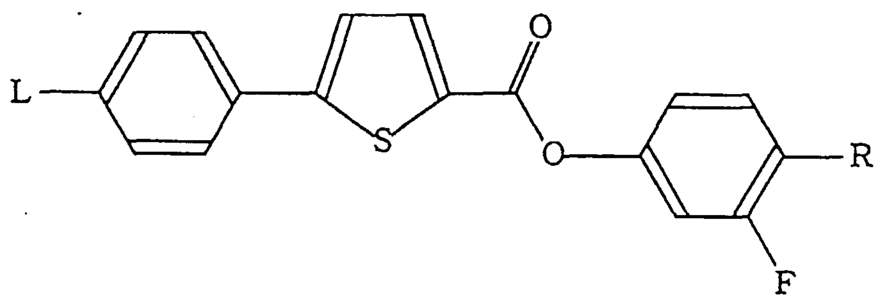

| L | R | | Cr | LC |
|---|---|---|---|---|
| $C_7H_{15}-$ | $-O-C_6H_{13}$ | | K 74 | C 77.9 A 123.3 I |
| $C_7H_{15}-$ | $-O-C_8H_{17}$ | | K 78.8 | C 77.9 A 122 I |
| $C_8H_{17}-$ | $-O-C_6H_{13}$ | | K 70 | C 99 A 122.3 I |
| $C_8H_{17}-$ | $-O-C_8H_{17}$ | | K 77.3 | C 100.2 A 120.3 I |
| $C_9H_{19}-$ | $-O-C_6H_{13}$ | | K 86.5 | C 103.5 A 123.8 I |
| $C_9H_{19}-$ | $-O-C_8H_{17}$ | | K 72.9 | C 107.4 A 121.7 I |

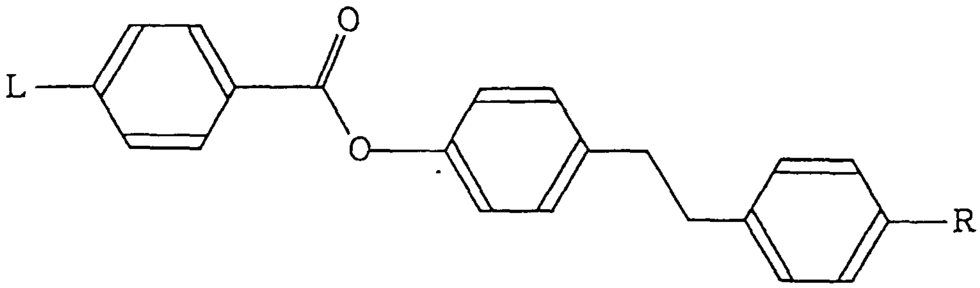

| L | R | | Cr | LC |
|---|---|---|---|---|
| $C_9H_{19}$-O- | -$C_5H_{11}$ | | K 74 | S 48 S 70.5 F 74 C 102 N 124.5 I |
| $C_{10}H_{21}$-O- | -$C_5H_{11}$ | | K 75 | S 56.5 B 83.5 C 111 N 125 I |
| $C_{11}H_{23}$-O- | -$C_5H_{11}$ | | K 74 | S 65 B 94 C 118 A 120 N 123 I |
| $C_{12}H_{25}$-O- | -$C_5H_{11}$ | | K 78 | B 90 C 115 N 124 I |
| $C_7H_{15}$- | -CO-$CH_3$ | | K 125 | S 132 N 140.5 I |
| $C_4H_9$-O- | -CO-$CH_3$ | | K 134 | S 144 N 176 I |
| $C_6H_{13}$-O- | -CO-$CH_3$ | | K 149.5 | C 154.5 N 169 I |
| $C_5H_{11}$-COO- | -CO-$CH_3$ | | K 143 | S 150 N 179 I |
| $C_4H_9$- | -COO-$C_2H_5$ | | K 118 | B 119.5 N 125 I |
| $C_4H_9$-O- | -COO-$C_2H_5$ | | K 121 | A 129 N 156.5 I |
| $C_6H_{13}$-CHMe-OOC- | -O-$C_6H_{13}$ | R | K 51 | S 82 I |
| $C_6H_{13}$-CHMe-OOC- | -O-$C_7H_{15}$ | R | K 62 | S 81 I |
| $C_6H_{13}$-CHMe-OOC- | -O-$C_8H_{17}$ | R | K 73 | S 83 I |
| $C_6H_{13}$-CHMe-OOC- | -O-$C_9H_{19}$ | R | K 70 | S 77 I |
| $C_6H_{13}$-CHMe-OOC- | -O-$C_{10}H_{21}$ | R | K 72 | S 76 A 81 I |
| $C_6H_{13}$-CHMe-OOC- | -O-$C_{11}H_{23}$ | R | K 55 | S 70 $C^*$ 74 A 79 I |
| $C_6H_{13}$-CHMe-OOC- | -O-$C_{12}H_{25}$ | R | K 54 | S 69 $C^*$ 75 A 79 I |
| $CH_3$-CHMe-CHCl-COO- | -O-$C_6H_{13}$ | 1 | K 59 | S 84 B 96 $C^*$ 106 $N^*$ 125 I |
| $CH_3$-CHMe-CHCl-COO- | -O-$C_7H_{15}$ | 1 | K 69 | S 96 $C^*$ 110 A 111 $N^*$ 122 I |
| $CH_3$-CHMe-CHCl-COO- | -O-$C_8H_{17}$ | 1 | K 81 | S 98 $C^*$ 112 A 115 $N^*$ 121.7 I |
| $CH_3$-CHMe-CHCl-COO- | -O-$C_9H_{19}$ | 1 | K 49 | $I^*$ 96.5 $C^*$ 114 A 117 $N^*$ 120 I |
| $CH_3$-CHMe-CHCl-COO- | -O-$C_{10}H_{21}$ | 1 | K 48 | $I^*$ 96 $C^*$ 114 A 118 $N^*$ 119.5 I |
| $CH_3$-CHMe-CHCl-COO- | -O-$C_{11}H_{23}$ | 1 | K 57 | $I^*$ 95.5 $C^*$ 114 A 119 I |
| $CH_3$-CHMe-CHCl-COO- | -O-$C_{12}H_{25}$ | 1 | K 60 | $I^*$ 95.2 $C^*$ 114 A 118 I |
| $C_2H_5$-CHMe-$C_3H_6$-O- | -O-$C_9H_{19}$ | 1 | K 65 | $J^*$ 82 $I^*$ 95 $C^*$ 111 $N^*$ 123 I |
| $C_2H_5$-CHMe-$C_4H_8$-O- | -O-$C_9H_{19}$ | 1 | K 60 | $J^*$ 79 $I^*$ 93 $C^*$ 111 A 118 I |
| $C_2H_5$-CHMe-$C_5H_{10}$-O- | -O-$C_9H_{19}$ | 1 | K 72 | $J^*$ 82 $I^*$ 99 $C^*$ 121 $N^*$ 123 I |
| $C_6H_{13}$-O- | -COO-CHMe-$C_6H_{13}$ | R | K 50 | $C^*$ 65 A 100 I |
| $C_7H_{15}$-O- | -COO-CHMe-$C_6H_{13}$ | R | K 62 | $C^*$ 78 A 97 I |
| $C_8H_{17}$-O- | -COO-CHMe-$C_6H_{13}$ | R | K 68 | $C^*$ 83 A 99 I |

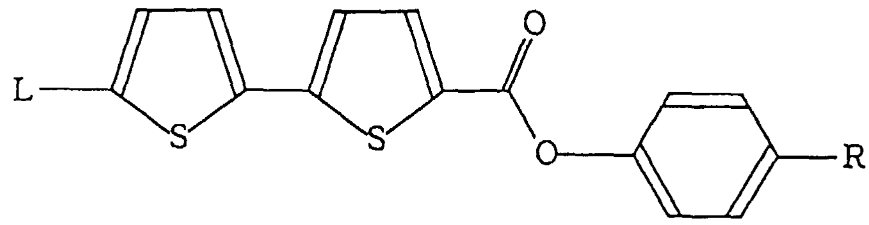

| L | R | Cr | LC |
|---|---|---|---|
| $C_7H_{15}$- | -O-$C_8H_{17}$ | K 84.4 | C 79.3 N 104.6 I |
| $C_8H_{17}$- | -O-$C_8H_{17}$ | K 87.1 | B 58 C 91.7 N 104.5 I |
| $C_9H_{19}$- | -O-$C_8H_{17}$ | K 78.8 | B 65.8 C 97.2 N 105 I |
| $C_{10}H_{21}$- | -O-$C_8H_{17}$ | K 81 | B 72.2 C 102.7 N 104.7 I |

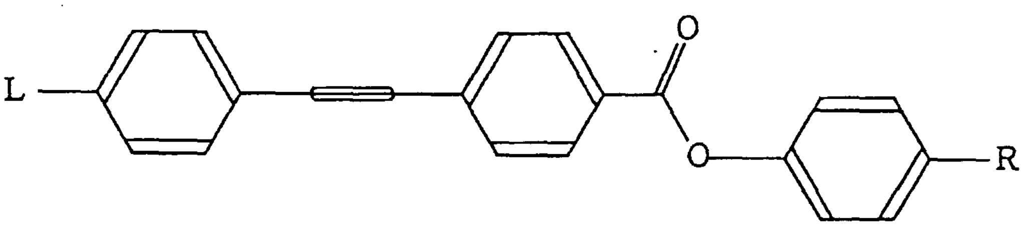

| L | R | | Cr | LC |
|---|---|---|---|---|
| $C_7H_{15}$-O- | -COO-CHMe-$C_6H_{13}$ | 1 | K 92.3 | * 73.7 CA 87.5 C–g 90 $C^*$ 96.1 C–a 98.4 A 136 I |
| $C_8H_{17}$-O- | -COO-CHMe-$C_6H_{13}$ | 1 | K 67.6 | * 71.6 CA 96.1 C–g 97 $C^*$ 104 C–a 105.5 A 135.3 I |
| $C_9H_{19}$-O- | -COO-CHMe-$C_6H_{13}$ | 1 | K 62.2 | * 84 CA 92.5 C–g 95 $C^*$ 107.6 C–a 108.5 A 129.6 I |
| $C_{10}H_{21}$-O- | -COO-CHMe-$C_6H_{13}$ | R | K 58.2 | CA 94.6 C–g 96.1 $C^*$ 111.2 A 128.6 I |
| $C_{11}H_{23}$-O- | -COO-CHMe-$C_6H_{13}$ | 1 | K 66 | CA 89 C–g 92.3 $C^*$ 112.4 A 123 I |
| $C_{12}H_{25}$-O- | -COO-CHMe-$C_6H_{13}$ | 1 | K 73.4 | CA 92 C–g 94.3 $C^*$ 113.2 A 121.3 I |
| $C_{10}H_{21}$-O- | -COO-$CH_2$-CHMe-$C_2H_5$ | S | K 53 | S 54 $C^*$ 131 A 169 $N^*$ 172 I |
| $C_6H_{13}$-CHMe-OOC- | -O-$C_6H_{13}$ | R | K 92 | $C^*$ 62 A 122 I |
| $C_6H_{13}$-CHMe-OOC- | -O-$C_7H_{15}$ | R | K 83 | $C^*$ 85 A 117 I |
| $C_6H_{13}$-CHMe-OOC- | -O-$C_8H_{17}$ | R | K 84 | $C^*$ 90 A 117 I |
| $C_6H_{13}$-CHMe-OOC- | -O-$C_9H_{19}$ | R | K 87 | $C^*$ 99 A 112 I |
| $C_6H_{13}$-CHMe-OOC- | -O-$C_{10}H_{21}$ | R | K 87 | $C^*$ 102 A 112 I |
| $C_6H_{13}$-CHMe-OOC- | -O-$C_{11}H_{23}$ | R | K 91 | $C^*$ 107 A 109 I |
| $C_6H_{13}$-CHMe-OOC- | -O-$C_{12}H_{25}$ | R | K 91 | $C^*$ 106 A 109 I |
| $C_2H_5$-CHMe-$CH_2$-OOC- | -O-$C_8H_{17}$ | S | K 84 | $C^*$ 120 A 159 $N^*$ 176 I |
| $C_2H_5$-CHMe-$CH_2$-OOC- | -O-$C_{10}H_{21}$ | S | K 91 | $C^*$ 122 A 158 $N^*$ 168 I |

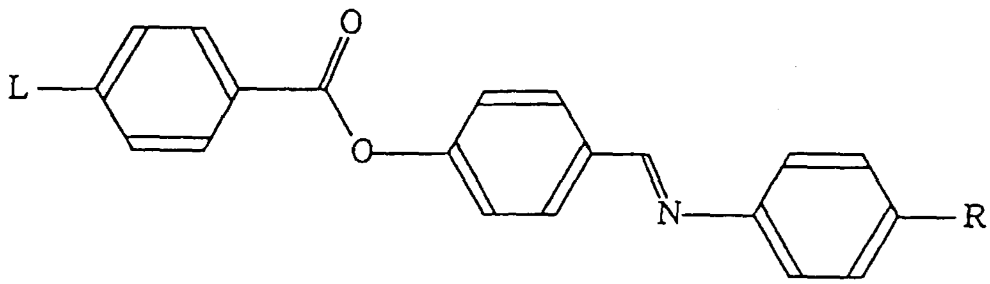

| L | R | Cr | LC |
|---|---|---|---|
| $C_{10}H_{21}$-O- | $-CH_3$ | K 106.5 | S 121.5 N 202.5 I |
| $C_{10}H_{21}$-O- | $-C_2H_5$ | K 84 | S 136.5 N 197 I |
| $C_{10}H_{21}$-O- | $-C_4H_9$ | K 68 | B 88 C 151 N 192 I |
| $C_{12}H_{25}$-O- | $-CH_3$ | K 99.5 | S 142.5 N 193.5 I |
| $C_{12}H_{25}$-O- | $-C_2H_5$ | K 90 | S 150 N 186.5 I |
| $C_{12}H_{25}$-O- | $-C_4H_9$ | K 66 | B 91 C 159 N 185 I |
| $C_{14}H_{29}$-O- | $-CH_3$ | K 95 | S 155 N 184 I |
| $C_{14}H_{29}$-O- | $-C_2H_5$ | K 94 | S 155 N 180 I |
| $C_{14}H_{29}$-O- | $-C_4H_9$ | K 64 | B 95 C 162 N 178 I |
| $C_{16}H_{33}$-O- | $-CH_3$ | K 91 | S 160.5 N 178 I |
| $C_{16}H_{33}$-O- | $-C_2H_5$ | K 94 | S 157 N 172 I |
| $C_{16}H_{33}$-O- | $-C_4H_9$ | K 63 | B 96 C 163 N 172 I |
| $C_{18}H_{37}$-O- | $-CH_3$ | K 88 | S 159 N 171.5 I |
| $C_{18}H_{37}$-O- | $-C_2H_5$ | K 95 | S 157.5 N 166.5 I |
| $C_5H_{11}$-O- | $-O-C_8H_{17}$ | K 95 | S 136 N 226 I |
| $C_6H_{13}$-O- | $-O-C_8H_{17}$ | K 90 | S 151 N 221 I |
| $C_7H_{15}$-O- | $-O-C_2H_5$ | K 101.5 | C 73.8 N 250 I |
| $C_7H_{15}$-O- | $-O-C_3H_7$ | K 114.3 | S 84.5 C 108 N 235 I |
| $C_7H_{15}$-O- | $-O-C_4H_9$ | K 90.4 | S 88.4 C 128.4 N 234.6 I |
| $C_7H_{15}$-O- | $-O-C_5H_{11}$ | K 89.4 | S 85.5 C 141.5 N 221.5 I |
| $C_7H_{15}$-O- | $-O-C_6H_{13}$ | K 92 | S 83 S 84 C 150 N 221.7 I |
| $C_7H_{15}$-O- | $-O-C_7H_{15}$ | K 101.4 | S 85 C 157 N 215.5 I |
| $C_7H_{15}$-O- | $-O-C_8H_{17}$ | K 89.7 | S 84 S 86 C 162.6 N 213.4 I |
| $C_7H_{15}$-O- | $-O-C_9H_{19}$ | K 92.9 | S 81.2 S 85.8 C 168.8 N 208.7 I |
| $C_7H_{15}$-O- | $-O-C_{10}H_{21}$ | K 90.4 | S 80 S 85.5 C 167.4 N 205.3 I |
| $C_8H_{17}$-O- | $-O-C_8H_{17}$ | K 94 | S 169 N 215.5 I |
| $C_9H_{19}$-O- | $-O-C_2H_5$ | K 104.2 | C 99 N 236 I |
| $C_9H_{19}$-O- | $-O-C_3H_7$ | K 105.4 | S 79 C 134.8 N 224 I |
| $C_9H_{19}$-O- | $-O-C_4H_9$ | K 94.6 | S 80 C 148.8 N 221.8 I |
| $C_9H_{19}$-O- | $-O-C_5H_{11}$ | K 91.2 | S 79 S 80.5 C 158.8 N 215.3 I |

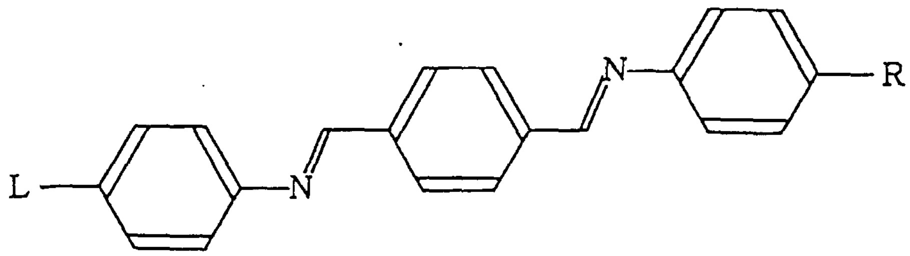

| L | R | Cr | LC |
|---|---|---|---|
| $C_2H_5$- | -$C_2H_5$ | K 127 | S 136 S 149 N 251 I |
| $C_3H_7$- | -$C_3H_7$ | K 109.2 | H 114.5 G 143 C 150.7 A 180.6 N 255 I |
| $C_4H_9$- | -$C_4H_9$ | K 113 | S 74 H 89.2 G 144.5 C 172 A 199 N 235 I |
| $C_5H_{11}$- | -$C_5H_{11}$ | K 72.8 | H 62.8 G 139 F 148.8 C 178.3 A 212 N 233.3 I |
| $C_6H_{13}$- | -$C_6H_{13}$ | K 71.3 | H 64.5 G 141.6 F 152.4 C 186.2 A 207.5 N 215.5 I |
| $C_7H_{15}$- | -$C_7H_{15}$ | K 61.8 | H 48 G 143 F 156.9 C 191.4 A 210 N 211.5 I |
| $C_8H_{17}$- | -$C_8H_{17}$ | K 83.5 | H 46 G 138.5 F 156.8 C 192.5 A 202.5 I |
| $C_9H_{19}$- | -$C_9H_{19}$ | K 57.3 | G 132.5 F 155.5 I 157.5 C 192.7 A 199 I |
| $C_{10}H_{21}$- | -$C_{10}H_{21}$ | K 73 | G 115 F 149 I 156 C 196 A 198 I |
| $C_{12}H_{25}$- | -$C_{12}H_{25}$ | K 80.7 | G 112.9 F 136.9 I 151 C 180.3 I |
| $C_{13}H_{27}$- | -$C_{13}H_{27}$ | K 95 | G 115 F 130 I 153 C 178 I |
| $C_{14}H_{29}$- | -$C_{14}H_{29}$ | K 90 | F 120.1 I 144 C 170 I |
| $C_{15}H_{31}$- | -$C_{15}H_{31}$ | K 91 | G 117 I 147 C 170 I |
| $C_{16}H_{33}$- | -$C_{16}H_{33}$ | K 89 | F 133.6 I 138.8 C 160 I |
| $C_2H_5$-OOC-CH=CH- | -CH=CH-COO-$C_2H_5$ | K 180.6 | B 189.7 C 232 A 305 N ? Z |
| $C_5H_{11}$-OOC-CH=CH- | -CH=CH-COO-$C_5H_{11}$ | K 124.7 | B 133 C 247 A 307 N 314 Z |
| $C_2H_5$-OOC-CMe=CH- | -CH=CMe-COO-$C_2H_5$ | K 169 | S 241 S 249 N 306 Z |
| $C_4H_9$-O- | -O-$C_4H_9$ | K 191 | C 221 N 295 I |
| $C_6H_{13}$-O- | -O-$C_6H_{13}$ | K 159 | S 176 S 232 S 239 N 262 I |
| $C_8H_{17}$-O- | -O-$C_8H_{17}$ | K 144 | S 172 S 234 S 241 N 246 I |
| $C_{12}H_{25}$-O- | -O-$C_{12}H_{25}$ | K 130 | S 162 S 215.1 I |
| $C_2H_5$-S- | -S-$C_2H_5$ | K 175.8 | A 204.5 N 236.2 I |
| $CH_3$-O-$CH_2$-O- | -O-$CH_2$-O-$CH_3$ | K 136.2 | B 140.9 A 147.1 N 222 I |
| $C_4H_9$-O-$CH_2$-O- | -O-$CH_2$-O-$C_4H_9$ | K 106.2 | A 118.7 I |
| $C_3H_7$-OOC- | -COO-$C_3H_7$ | K 153 | A 199 N 258 I |
| $C_4H_9$-OOC- | -COO-$C_4H_9$ | K 92 | C 137 A 190 N 209 I |
| $C_5H_{11}$-OOC- | -COO-$C_5H_{11}$ | K 100 | A 206 N 216 I |
| $C_6H_{13}$-OOC- | -COO-$C_6H_{13}$ | K 113 | C 148 A 189 I |
| $C_7H_{15}$-OOC- | -COO-$C_7H_{15}$ | K 92 | C 140 A 196 I |
| $C_4D_9$- | -$C_4D_9$ | K 112 | S 146 C 174 A 201 N 238 I |

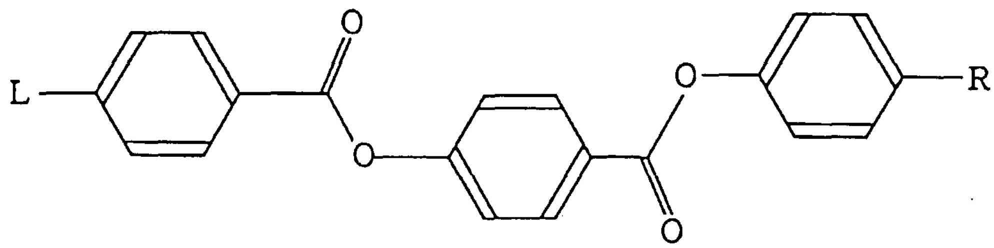

| L | R | | Cr | LC |
|---|---|---|---|---|
| $C_8H_{17}$-O- | -CH=C(COO-$C_6H_{13}$)$_2$ | | K 52 | C 51 A 85 N 101 I |
| $C_8H_{17}$-O- | -CH=C(COO-$C_7H_{15}$)$_2$ | | K 58 | C 51.5 A 83 N 97 I |
| $C_8H_{17}$-O- | -CH=C(COO-$C_8H_{17}$)$_2$ | | K 59 | C 53 A 84 N 94 I |
| $C_8H_{17}$-O- | -CH=C(COO-$C_9H_{19}$)$_2$ | | K 58 | C 53 A 86 N 94 I |
| $C_8H_{17}$-O- | -CH=C(COO-$C_{10}H_{21}$)$_2$ | | K 63 | C 55 A 84 N 91 I |
| $C_8H_{17}$-O- | -CH=C(COO-$C_{11}H_{23}$)$_2$ | | K 61 | C 56 A 84 N 90 I |
| $C_8H_{17}$-O- | -CH=C(COO-$C_{12}H_{25}$)$_2$ | | K 67 | C 57 A 85 N 89 I |
| $C_8H_{17}$-O- | -CH=C(COO-$C_{16}H_{33}$)$_2$ | | K 83 | C 65 A 85 N 86 I |
| $C_8H_{17}$-O- | -CH=C(COO-$C_{18}H_{37}$)$_2$ | | K 86 | C 69 A 83 I |
| $C_9H_{19}$-O- | -CH=C(COO-$C_5H_{11}$)$_2$ | | K 70 | C 56 A 88 N 107 I |
| $C_8H_{17}$-O- | -CHCN-CH(COO-$C_3H_7$)$_2$ | 2 | K 60 | A 100 N 131 I |
| $C_4H_9$-O- | -O-$C_8H_{17}$ | | K ? | C 65 N 207 I |
| $C_5H_{11}$-O- | -O-$C_8H_{17}$ | | K 97 | C 101 N 201 I |
| $C_6H_{13}$-O- | -O-$C_8H_{17}$ | | K 96 | C 132 A 144 N 198 I |
| $C_7H_{15}$-O- | -O-$C_7H_{15}$ | | K 87 | C 143 A 162 N 193 I |
| $C_7H_{15}$-O- | -O-$C_8H_{17}$ | | K ? | C 142 A 155 N 193 I |
| $C_8H_{17}$-O- | -O-$CH_3$ | | K 107 | A 122 N 226 I |
| $C_8H_{17}$-O- | -O-$C_2H_5$ | | K 110 | A 130 N 213 I |
| $C_8H_{17}$-O- | -O-$C_8H_{17}$ | | K 87 | C 145 A 163 N 189.5 I |
| $C_8H_{17}$-O- | -O-CHMe-COO-$C_2H_5$ | S | K 86 | A 117 N* 122 I |
| $C_8H_{17}$-O- | -O-CHMe-COO-$C_8H_{17}$ | S | K 71 | A 94 N* 113 I |
| $C_8H_{17}$-O- | -CO-$CH_3$ | | K 131 | A 210 N 227 I |
| $C_6H_{13}$-O- | -COO-$C_3H_7$ | | K 101.5 | C 188.5 N 193 I |
| $C_8H_{17}$-O- | -CO-N(-$CH_3$)$_2$ | | K 127 | A 144 N 204 I |
| $C_8H_{17}$-O- | -COO-N=C(-$CH_3$)$_2$ | | K 116 | A 180 N 230 Z |
| $C_8H_{17}$-O- | -COO-N=C(-$C_2H_5$)$_2$ | | K 77.5 | A 155.5 N 192 Z |
| $C_8H_{17}$-O- | -COO-N=C(-$C_3H_7$)$_2$ | | K 91 | A 128 N 165 I |
| $C_8H_{17}$-O- | -COO-N=C(-$C_7H_{15}$)$_2$ | | K 76 | A 83 N 116.5 I |
| $C_8H_{17}$-O- | -COO-N=C(-$C_{11}H_{23}$)$_2$ | | K 73 | A 78 N 99 I |
| $C_8H_{17}$-O- | -COO-N=C(-$C_{13}H_{27}$)$_2$ | | K 59 | A 78 N 93 I |

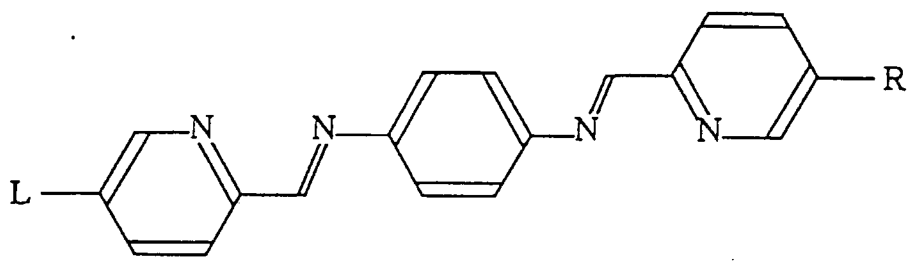

| L | R | Cr | LC |
|---|---|---|---|
| $C_6H_{13}$-O- | -O-$C_6H_{13}$ | K 122.4 | B 132.6 N 243 I |
| $C_8H_{17}$-O- | -O-$C_8H_{17}$ | K 61.2 | H 100.2 G 121.2 C 158.4 N 223.1 I |
| $C_{10}H_{21}$-O- | -O-$C_{10}H_{21}$ | K 89.9 | H 87.2 G 95.5 C 173.4 N 202.1 I |

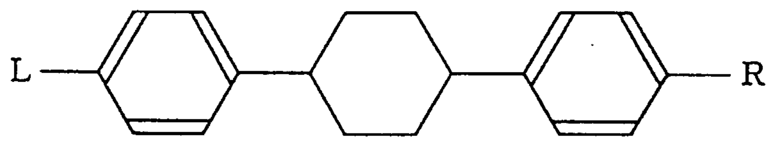

| L | R | Cr | LC |
|---|---|---|---|
| $C_4H_9$- | -$C_4H_9$ | K 89 | P 107 I |
| $C_6H_{13}$- | -$C_6H_{13}$ | K 70 | P 112 I |
| $C_7H_{15}$- | -$C_7H_{15}$ | K 60 | P 114 I |
| $C_{12}H_{25}$- | -$C_{12}H_{25}$ | K 53 | P 108.8 I |
| $C_{16}H_{33}$- | -$C_{16}H_{33}$ | K 69 | P 102.5 I |

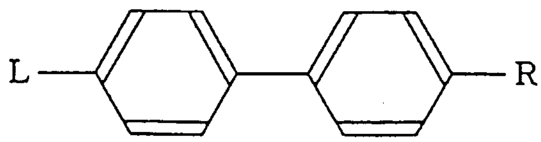

| L | R | Cr | LC |
|---|---|---|---|
| $C_8H_{17}$- | -$C_8H_{17}$ | K 57 | P 61 I |
| $C_9H_{19}$- | -$C_9H_{19}$ | K 57 | P 68 I |

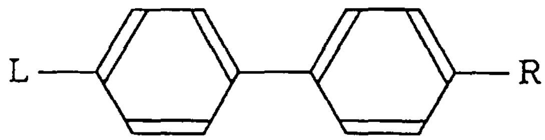

| L | R | Cr | LC | Ref |
|---|---|---|---|---|
| $H-O-C_6H_{12}-O-$ | $-O-C_6H_{12}-O-H$ | K 97.9 | S 178.8 I | 5165 |
| H-CONH- | -NHOC-H | K 274 | S 286 I | 4109 |
| $Br-C_3H_6-COO-$ | $-OOC-C_3H_6-Br$ | K 114 | S 142 I | 7455 |
| $Br-C_4H_8-COO-$ | $-OOC-C_4H_8-Br$ | K 96 | S 116 I | 7455 |
| $Br-C_5H_{10}-COO-$ | $-OOC-C_5H_{10}-Br$ | K 57 | S 103 I | 7455 |
| $Br-C_7H_{14}-COO-$ | $-OOC-C_7H_{14}-Br$ | K 71 | S 99 I | 7455 |

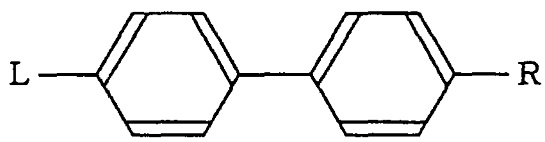

| L | R | Cr | LC |
|---|---|---|---|
| $Br-C_{10}H_{20}-COO-$ | $-OOC-C_{10}H_{20}-Br$ | K 83 | S 100 I |
| $C_5H_{11}-$ | -H | K 11.5 | N -34 E |
| $C_5H_{11}-$ | $-C_2H_4-O-H$ | K 72 | S 112.5 I |
| $C_2H_5-O-$ | -O-H | K 169 | X 176 I |
| $C_8H_{17}-O-$ | $-O-CH_2-CHtBu-O-H$ | S K 95 | S 58 S 103 S 113.1 S 113.6 S 115.6 A 119.5 I |
| $CH_3-O-$ | $-O-C_6H_{12}-OOC-CMe=CH-H$ | K 66 | S 73 I |
| $C_2H_5-O-$ | $-O-C_6H_{12}-OOC-CMe=CH-H$ | K 63.1 | N 87.6 I |
| $C_5H_{11}-O-$ | $-O-C_6H_{12}-OOC-CMe=CH-H$ | K 53 | S 57 I |
| $C_6H_{13}-O-$ | $-O-C_6H_{12}-OOC-CMe=CH-H$ | K 79 | S 84 I |
| $C_4H_9-$ | -CO-H | K 4.5 | N 2 I |
| $C_5H_{11}-$ | -CO-H | K 21.5 | N 23.5 I |
| $C_6H_{13}-$ | -CO-H | K -5.5 | N 17.5 I |
| $C_7H_{15}-$ | -CO-H | K 4.5 | N 33 I |
| $C_8H_{17}-$ | -CO-H | K 20.5 | S 30 N 36 I |
| $C_9H_{19}-$ | -CO-H | K 31 | S 42 N 45 I |

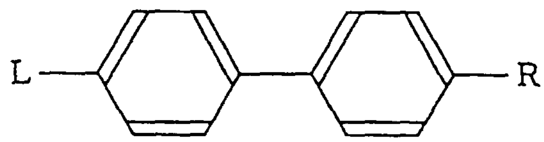

| L | R | | Cr | LC |
|---|---|---|---|---|
| $C_{10}H_{21}$- | -CO-H | | K 42 | S 44 I |
| $C_8H_{17}$-O- | -COO-$CH_2$-CHMe-O-H | S | K 119 | A 118 I |
| $C_2H_5$-O- | -OOC-CMe=CH-H | | K 95 | X 105 I |
| $C_8H_{17}$-O- | -OOC-$C_4H_8$-OOC-CMe=CH-H | | K 80.6 | S 86.2 I |
| $C_8H_{17}$-O- | -OOC-$C_2H_4$-CHMe-$CH_2$-OOC-CMe=CH-H | 1 | K 46 | S 64.1 I |
| $C_6H_{13}$-O- | -OOC-$C_{11}H_{22}$-NHOC-CMe=CH-H | | K 111 | S 132 X ? I |
| $C_2H_5$-CHMe-CHF-$CH_2$-OOC- | -O-H | 3 | K 127.5 | I |
| $CH_3$-CHMe-$CH_2$-CHCl-$CH_2$-OOC- | -O-H | S | K 48.3 | I |
| $C_2H_5$-CHMe-$CH_2$-O- | -O-$C_6H_{12}$-OOC-CMe=CH-H | S | K 42.5 | S 49 I |
| $C_8F_{17}$-$C_{11}H_{22}$-O- | -CONH-H | | K 224 | I |
| $H_2C$=CH-$C_4H_8$-O- | -O-H | | K 136 | I |
| $H_2C$=CH-$C_9H_{18}$-O- | -O-H | | K 134 | S 139 I |
| $C_5H_{11}$- | -CH=CH-F | | K ? | S 123 I |
| $C_3H_7$- | -$SO_2$-F | | K 94 | N -100 E |
| $C_4H_9$-C:::C- | -F | | K ? | S 73.7 I |
| $C_5H_{11}$- | -$C_2H_4$-Cl | | K 49 | N 14 E |
| $C_4H_9$-O- | -CO-$CH_2$-Cl | | K 115 | E 110 I |
| $C_5H_{11}$-O- | -CO-$CH_2$-Cl | | K 98 | E 72 A 103 I |
| $C_6H_{13}$-O- | -CO-$CH_2$-Cl | | K 87 | E 107 A 116 I |
| $C_7H_{15}$-O- | -CO-$CH_2$-Cl | | K 93 | E 106 A 122 I |
| $C_8H_{17}$-O- | -CO-$CH_2$-Cl | | K 88 | E 105 A 126 I |

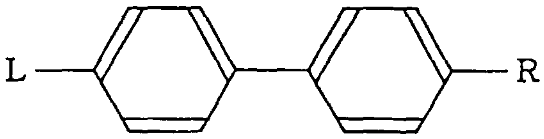

| L | R | | Cr | LC |
|---|---|---|---|---|
| $C_9H_{19}$-O- | -CO-$CH_2$-Cl | | K 95 | E 102 A 126 I |
| $C_{10}H_{21}$-O- | -CO-$CH_2$-Cl | | K 89 | E 101 A 128 I |
| $C_5H_{11}$-CO-$C_2H_4$-CO- | -Br | | K 119 | A 123.8 I |
| $C_6H_{13}$-CO-$C_2H_4$-CO- | -Br | | K 120.3 | A 127.5 I |
| $C_3H_7$-COO-$CH_2$-CO- | -Br | | K 94.4 | S 112 I |
| $C_5H_{11}$-COO- | -Br | | K 70 | E 83 B 103 I |
| $C_6H_{13}$-COO- | -Br | | K 68.5 | E 74 B 104 I |
| $C_7H_{15}$-COO- | -Br | | K 76 | S 59.7 B 104.5 I |
| $C_8H_{17}$-COO- | -Br | | K 69 | E 46 B 103 I |
| $C_9H_{19}$-COO- | -Br | | K 73.5 | B 102.5 I |
| $C_5H_{11}$- | -$CH_2$-Br | | K 78 | N 1.5 E |
| $C_5H_{11}$- | -C:::C-Br | | K 88 | X 108 I |
| $CH_3$-O- | -O-$C_9H_{18}$-Br | | K 88.4 | I |
| $C_6H_{13}$- | -CO-$CH_2$-Br | | K 64 | A 52 I |
| $C_7H_{15}$- | -CO-$CH_2$-Br | | K 60.5 | A 59.5 I |
| $C_8H_{17}$- | -CO-$CH_2$-Br | | K 65.5 | A 64 I |
| $C_9H_{19}$- | -CO-$CH_2$-Br | | K 64 | A 67 I |
| $C_{10}H_{21}$- | -CO-$CH_2$-Br | | K 72.5 | A 70 I |
| $C_2H_5$-O- | -CO-$CH_2$-Br | | K 137 | S 112.5 I |
| $C_3H_7$-O- | -CO-$CH_2$-Br | | K 124 | S 118.5 I |
| $C_4H_9$-O- | -CO-$CH_2$-Br | | K 107 | E 106 I |
| $C_5H_{11}$-O- | -CO-$CH_2$-Br | | K 93 | E 101 I |
| $C_6H_{13}$-O- | -CO-$CH_2$-Br | | K 79 | E 98 A 104 I |
| $C_7H_{15}$-O- | -CO-$CH_2$-Br | | K 96 | E 92 A 104 I |
| $C_8H_{17}$-O- | -CO-$CH_2$-Br | | K 80 | E 95 A 107 I |
| $C_9H_{19}$-O- | -CO-$CH_2$-Br | | K 95 | E 100 A 116 I |
| $C_{10}H_{21}$-O- | -CO-$CH_2$-Br | | K 91 | E 98 A 116 I |
| $C_7H_{15}$-O- | -CO-CHCl-Br | 2 | K 95 | A 56 I |
| $C_8H_{17}$-O- | -CO-CHCl-Br | 2 | K 68 | A 71 I |
| $C_9H_{19}$-O- | -CO-CHCl-Br | 2 | K 68 | A 78 I |
| $C_{10}H_{21}$-O- | -CO-CHCl-Br | 2 | K 65 | A 66 I |
| $C_2H_5$-CHMe-$C_2H_4$-COO- | -Br | 1 | K 56 | S 28 I |
| $C_5H_{11}$-O- | -$NO_2$ | | K 54.5 | N <42 I |
| $C_6H_{13}$-O- | -$NO_2$ | | K 67 | N 32.5 I |
| $C_7H_{15}$-O- | -$NO_2$ | | K 36.5 | A 30.5 N 38.5 B |
| $C_8H_{17}$-O- | -$NO_2$ | | K 51.5 | A 49.5 N 51.5 B |
| $H_2C$=CH-O-$C_{11}H_{22}$-O- | -$NO_2$ | | K 97 | I |
| $C_6H_{13}$- | -CH=$CF_2$ | | K 59 | S 95.8 I |
| $C_5H_{11}$- | -$CH_2$-CH=$CF_2$ | | K 36.9 | S 53.1 I |
| $C_5H_{11}$- | -$C_2H_4$-CH=$CF_2$ | | K -25.4 | S 30.8 S 50.6 I |
| $C_9H_{19}$-O- | -COO-Isopinocampheyl | R | K 67.5 | A 48.7 N* 55.7 I |
| $CH_3$- | -$C_5H_{11}$ | | K 48 | N -1 I |

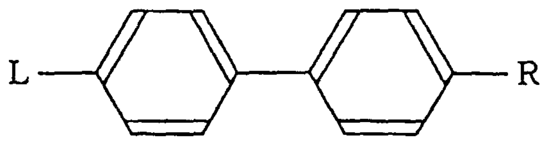

| L | R | Cr | LC |
|---|---|---|---|
| $C_2H_5$- | $-C_5H_{11}$ | K <20 | S 33.9 I |
| $C_3H_7$- | $-C_5H_{11}$ | K -18 | S 47.8 I |
| $C_3H_7$- | $-C_6H_{13}$ | K -10.5 | E 48 I |
| $C_3H_7$- | $-C_7H_{15}$ | K -14 | E 29 B 50.5 I |
| $C_4H_9$- | $-C_6H_{13}$ | K -2 | E 40.5 B 48.5 I |
| $C_4H_9$- | $-C_7H_{15}$ | K -15 | E 16.5 B 38.5 I |
| $C_5H_{11}$- | $-C_5H_{11}$ | K 25.1 | E 46.1 E 47.1 L 52.3 I |
| $C_5H_{11}$- | $-C_6H_{13}$ | K ? | E 11.7 E 41.7 E 42.6 L 53.7 I |
| $C_5H_{11}$- | $-C_7H_{15}$ | K ? | E 36 B 63 I |
| $C_6H_{13}$- | $-C_6H_{13}$ | K 25.1 | E 46.1 E 47.1 L 52.3 I |
| $C_6H_{13}$- | $-C_7H_{15}$ | K ? | E 29.7 E 30.2 L 58.1 I |
| $C_7H_{15}$- | $-C_7H_{15}$ | K ? | E 19.5 E 35.1 L 61 I |
| $C_8H_{17}$- | $-C_8H_{17}$ | K 57 | P 81 I |
| $C_9H_{19}$- | $-C_9H_{19}$ | K 57 | P 68 I |
| $C_5H_{11}$- | $-CH_2-O-CH_3$ | K 48 | S 47 I |
| $C_5H_{11}$- | $-CH_2-O-C_3H_7$ | K 27 | S 21 I |
| $C_5H_{11}$- | $-CH_2-O-C_5H_{11}$ | K 16 | S 10 I |
| $C_5H_{11}$- | $-O-C_2H_5$ | K 72 | S 81 I |
| $C_5H_{11}$- | $-O-C_4H_9$ | K 37 | S 80.1 S 88.1 I |
| $C_5H_{11}$- | $-O-C_6H_{13}$ | K 82 | S 84 I |
| $C_6H_{13}$- | $-O-C_6H_{13}$ | K 9 | E 68 B 83.9 I |
| $C_7H_{15}$- | $-O-C_6H_{13}$ | K 58 | B 86.5 I |
| $C_8H_{17}$- | $-O-C_6H_{13}$ | K 46 | B 84 I |
| $C_8H_{17}$- | $-O-C_8H_{17}$ | K 57 | E 86 I |
| $C_9H_{19}$- | $-O-C_6H_{13}$ | K 34 | B 82 I |
| $C_3H_7$- | $-NH-C_4H_9$ | K 75 | S 74.1 I |
| $C_5H_{11}$- | $-NH-C_4H_9$ | K 45 | A 78 I |
| $C_3H_7$- | $-CO-C_2H_5$ | K 42 | S 130 I |
| $C_5H_{11}$- | $-CO-CH_3$ | K 77 | B 84 I |
| $C_5H_{11}$- | $-CO-C_4H_9$ | K 90 | S 106.2 S 110.5 I |

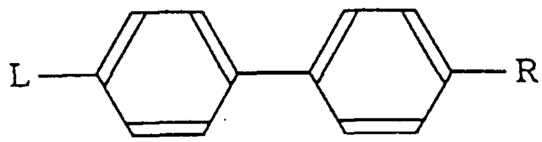

| L | R | Cr | LC |
|---|---|---|---|
| $C_5H_{11}$- | $-CO-C_5H_{11}$ | K 106 | B 104 A 109.5 I |
| $C_5H_{11}$- | $-CO-C_6H_{13}$ | K 96 | A 111 I |
| $C_6H_{13}$- | $-CO-CH_3$ | K 79 | B 85.5 I |
| $C_6H_{13}$- | $-CO-C_5H_{11}$ | K 106 | A 105.9 I |
| $C_7H_{15}$- | $-CO-CH_3$ | K 76.5 | B 84.5 I |
| $C_7H_{15}$- | $-CO-C_5H_{11}$ | K 94.3 | B 95.6 A 103.8 I |
| $C_8H_{17}$- | $-CO-CH_3$ | K 86.5 | B 84 I |
| $C_8H_{17}$- | $-CO-C_5H_{11}$ | K 87.5 | B 92.2 A 101.3 I |
| $C_9H_{19}$- | $-CO-CH_3$ | K 85 | B 82.5 I |
| $C_9H_{19}$- | $-CO-C_5H_{11}$ | K 80.2 | B 88.1 A 99.7 I |
| $C_{10}H_{21}$- | $-CO-C_5H_{11}$ | K 77.5 | B 88.8 A 98.7 I |
| $C_{10}H_{21}$- | $-CO-C_9H_{19}$ | K 57.8 | E 110 I |
| $C_5H_{11}$- | $-CO-CH_2-CO-CH_3$ | K 110 | X 135 I |
| $C_{10}H_{21}$- | $-CO-CH_2-CO-CH_3$ | K 86 | E 97 B 107 A 135 I |
| $C_5H_{11}$- | $-CO-CH_2-OOC-C_3H_7$ | K 85 | S 147 I |
| $C_8H_{17}$- | $-CO-CH_2-OOC-C_3H_7$ | K 70 | S 144 I |
| $C_6H_{13}$- | $-CO-CH=CH-COO-C_2H_5$ | K 40 | S 59 I |
| $C_6H_{13}$- | $-CO-CH=CH-COO-C_3H_7$ | K 40 | S 66 I |
| $C_6H_{13}$- | $-CO-CH=CH-COO-C_4H_9$ | K 34 | S 68 I |
| $C_6H_{13}$- | $-CO-CH=CH-COO-C_5H_{11}$ | K 25 | S 57 I |
| $C_8H_{17}$- | $-CO-CH=CH-COO-C_3H_7$ | K 62 | S 72 I |
| $C_8H_{17}$- | $-CO-CH=CH-COO-C_4H_9$ | K 56 | S 69 I |
| $C_8H_{17}$- | $-CO-CH=CH-COO-C_5H_{11}$ | K 54 | S 70 I |
| $C_8H_{17}$- | $-CO-CH=CH-COO-C_6H_{13}$ | K 36 | S 71 I |
| $C_8H_{17}$- | $-CO-CH=CH-COO-C_7H_{15}$ | K 40 | S 72 I |
| $C_8H_{17}$- | $-CO-CH=CH-COO-C_8H_{17}$ | K 35 | S 71 I |
| $C_3H_7$- | $-COO-C_3H_7$ | K 63 | X 61 I |
| $C_5H_{11}$- | $-COO-C_3H_7$ | K 55 | X 58 I |
| $C_5H_{11}$- | $-COO-C_8H_{17}$ | K 29 | B 25 I |
| $C_8H_{17}$- | $-COO-C_2H_5$ | K 64 | B 61.4 A 61.4 I |

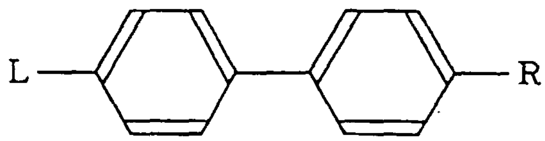

| L | R | | Cr | LC |
|---|---|---|---|---|
| $C_8H_{17}$- | -COO-$C_3H_7$ | | K 60 | A 57 I |
| $C_5H_{11}$- | -COS-$C_2H_5$ | | K ? | E 103.5 L 113 A 121.4 U |
| $C_5H_{11}$- | -COS-$C_3H_7$ | | K ? | E 90 L 110.3 A 118.5 I |
| $C_5H_{11}$- | -COS-$C_4H_9$ | | K ? | E 75 L 109 A 120.5 I |
| $C_5H_{11}$- | -COS-$C_5H_{11}$ | | K ? | E 59.8 L 104.5 A 120 I |
| $C_5H_{11}$- | -COS-$C_6H_{13}$ | | K ? | E 50 L 102 A 118 I |
| $C_5H_{11}$- | -COS-$C_7H_{15}$ | | K ? | E 40.1 L 100.2 A 116.7 I |
| $C_5H_{11}$- | -COS-$C_8H_{17}$ | | K ? | E 33 L 99.8 A 116.3 I |
| $C_5H_{11}$- | -COS-$C_9H_{19}$ | | K ? | E 25 L 95.4 A 113.8 I |
| $C_5H_{11}$- | -COS-$C_{10}H_{21}$ | | K ? | E 15 L 94 A 113.2 I |
| $C_5H_{11}$- | -OOC-$C_5H_{11}$ | | K 45.7 | S 87.4 I |
| $C_8H_{17}$- | -OOC-$C_7H_{15}$ | | K 65 | E 83 B 91 I |
| $C_7H_{15}$- | -OOC-CHMe-CHMe-O-$CH_3$ | 1 | K -18 | $C^*$ 9 A 13 I |
| $C_8H_{17}$- | -OOC-CHMe-CHMe-O-$CH_3$ | 1 | K 32 | $C^*$ 10 A 15 I |
| $C_5H_{11}$- | -CMe=N-O-$C_2H_5$ | | K 73 | A 91 I |
| $C_6H_{13}$- | -CMe=N-OOC-$C_4H_9$ | | K 89 | A 88 I |
| $C_6H_{13}$- | -CMe=N-OOC-$C_8H_{17}$ | | K 70 | A 86 I |
| $C_8H_{17}$-O- | -$C_5H_{10}$-CHMe-O-$C_3H_7$ | 1 | K 14 | S 18 S 37 $C^*$ 41 I |
| $C_{10}H_{21}$-O- | -$C_5H_{10}$-CHMe-O-$CH_3$ | 1 | K 41 | S 49 $C^*$ 53 I |
| $C_{10}H_{21}$-O- | -$C_5H_{10}$-CHMe-O-$C_2H_5$ | 1 | K 31 | S 32 S 38 $C^*$ 48 I |
| $C_{10}H_{21}$-O- | -$C_5H_{10}$-CHMe-O-$C_3H_7$ | 1 | K 28 | S 23 S 35 $C^*$ 44 I |
| $C_{10}H_{21}$-O- | -$C_5H_{10}$-CHMe-O-$C_4H_9$ | 1 | K 33 | S 25 $C^*$ 35 A 39 I |
| $C_{10}H_{21}$-O- | -$C_6H_{10}$-CHMe-O-$C_5H_{11}$ | 1 | K 32 | S 27 $C^*$ 30 A 36 I |
| $C_{12}H_{25}$-O- | -$C_6H_{10}$-CHMe-O-$C_3H_7$ | 1 | K 40 | $C^*$ 44 U |
| $C_{10}H_{21}$-O- | -$C_6H_{12}$-CHMe-O-$C_3H_7$ | 1 | K 43 | S 46 S 56 I |
| $C_2H_5$-O- | -O-$C_2H_5$ | | K 178 | X 185 I |
| $C_6H_{13}$-O- | -O-$C_6H_{13}$ | | K 124 | N 130 U |
| $C_8H_{17}$-O- | -O-CHMe-COO-$CH_3$ | S | K 57 | A 49.2 I |
| $C_8H_{17}$-O- | -O-CHMe-COO-$C_2H_5$ | S | K 39 | A 42 I |
| $CH_3$-O- | -CO-$C_2H_5$ | | K 145.7 | E 146.4 I |

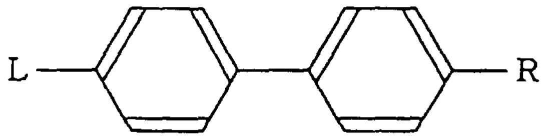

| L | R | Cr | LC |
|---|---|---|---|
| $CH_3$-O- | -CO-$C_3H_7$ | K 126.2 | E 122.2 A 125.9 I |
| $CH_3$-O- | -CO-$C_4H_9$ | K 120.5 | A 117.7 I |
| $CH_3$-O- | -CO-$C_5H_{11}$ | K 123 | A 119 I |
| $CH_3$-O- | -CO-$C_6H_{13}$ | K 118 | A 117 I |
| $CH_3$-O- | -CO-$C_7H_{15}$ | K 120 | A 117.7 I |
| $CH_3$-O- | -CO-$C_8H_{17}$ | K 116 | A 118.2 I |
| $CH_3$-O- | -CO-$C_9H_{19}$ | K 118 | A 116.7 I |
| $C_2H_5$-O- | -CO-$CH_3$ | K 96 | E 156.2 I |
| $C_2H_5$-O- | -CO-$C_2H_5$ | K 124 | E 172.4 I |
| $C_2H_5$-O- | -CO-$C_3H_7$ | K 123 | E 156.2 I |
| $C_2H_5$-O- | -CO-$C_4H_9$ | K 106 | E 136 A 153 I |
| $C_2H_5$-O- | -CO-$C_5H_{11}$ | K 110 | E 129.9 A 150.6 I |
| $C_2H_5$-O- | -CO-$C_6H_{13}$ | K 107 | E 124 A 148 I |
| $C_2H_5$-O- | -CO-$C_7H_{15}$ | K 111.5 | E 121 A 146.4 I |
| $C_2H_5$-O- | -CO-$C_8H_{17}$ | K 108 | E 120.2 A 144.8 I |
| $C_2H_5$-O- | -CO-$C_9H_{19}$ | K 116 | E 121.7 A 143.1 I |
| $C_3H_7$-O- | -CO-$CH_3$ | K 107 | E 155.6 I |
| $C_3H_7$-O- | -CO-$C_2H_5$ | K 119 | E 177.3 I |
| $C_3H_7$-O- | -CO-$C_3H_7$ | K 136.5 | E 153.9 A 158.2 I |
| $C_3H_7$-O- | -CO-$C_4H_9$ | K 126 | E 135.7 A 154.6 I |
| $C_3H_7$-O- | -CO-$C_5H_{11}$ | K 116 | E 125.9 A 150.3 I |
| $C_3H_7$-O- | -CO-$C_6H_{13}$ | K 113 | E 120.1 A 147.3 I |
| $C_3H_7$-O- | -CO-$C_7H_{15}$ | K 118 | E 121 A 145.2 I |
| $C_3H_7$-O- | -CO-$C_8H_{17}$ | K 115 | E 120.3 A 143 I |
| $C_3H_7$-O- | -CO-$C_9H_{19}$ | K 106 | E 119.5 A 141 I |
| $C_4H_9$-O- | -CO-$CH_3$ | K 97 | E 144 I |
| $C_4H_9$-O- | -CO-$C_2H_5$ | K 114 | E 167.3 A 171.4 I |
| $C_4H_9$-O- | -CO-$C_3H_7$ | K 101.5 | E 145.7 A 155.9 I |
| $C_4H_9$-O- | -CO-$C_4H_9$ | K 124 | E 136.2 A 156.8 I |
| $C_4H_9$-O- | -CO-$C_5H_{11}$ | K 115 | E 120 A 150.8 I |

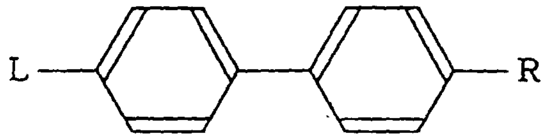

| L | R | Cr | LC |
|---|---|---|---|
| $C_4H_9$-O- | -CO-$C_6H_{13}$ | K 109 | E 115 A 151.5 I |
| $C_4H_9$-O- | -CO-$C_7H_{15}$ | K 99 | E 113.7 A 148.3 I |
| $C_4H_9$-O- | -CO-$C_8H_{17}$ | K 102.5 | E 111.8 A 146.8 I |
| $C_4H_9$-O- | -CO-$C_9H_{19}$ | K 107 | E 111.6 A 144.7 I |
| $C_5H_{11}$-O- | -CO-$CH_3$ | K 90 | E 139.5 I |
| $C_5H_{11}$-O- | -CO-$C_2H_5$ | K 91 | E 155.6 A 169 I |
| $C_5H_{11}$-O- | -CO-$C_3H_7$ | K 93 | E 129.5 A 150.8 I |
| $C_5H_{11}$-O- | -CO-$C_4H_9$ | K 124 | E 121 A 152.1 I |
| $C_5H_{11}$-O- | -CO-$C_5H_{11}$ | K 128.8 | E 127 A 147.8 I |
| $C_5H_{11}$-O- | -CO-$C_6H_{13}$ | K 117 | E 113 A 146.3 I |
| $C_5H_{11}$-O- | -CO-$C_7H_{15}$ | K 111 | E 108 A 143.8 I |
| $C_5H_{11}$-O- | -CO-$C_8H_{17}$ | K 104 | E 101 A 144 I |
| $C_5H_{11}$-O- | -CO-$C_9H_{19}$ | K 102.7 | E 101.5 A 141.8 I |
| $C_6H_{13}$-O- | -CO-$CH_3$ | K 91 | E 137 I |
| $C_6H_{13}$-O- | -CO-$C_2H_5$ | K 78 | E 149 A 165.5 I |
| $C_6H_{13}$-O- | -CO-$C_3H_7$ | K 82 | E 121.8 A 147 I |
| $C_6H_{13}$-O- | -CO-$C_4H_9$ | K 109 | E 116 A 149.6 I |
| $C_6H_{13}$-O- | -CO-$C_5H_{11}$ | K 120.5 | A 145.3 I |
| $C_6H_{13}$-O- | -CO-$C_6H_{13}$ | K 124.5 | A 145.2 I |
| $C_6H_{13}$-O- | -CO-$C_7H_{15}$ | K 123 | A 142.5 I |
| $C_6H_{13}$-O- | -CO-$C_8H_{17}$ | K 113.5 | A 141.2 I |
| $C_6H_{13}$-O- | -CO-$C_9H_{19}$ | K 110.2 | A 139.5 I |
| $C_7H_{15}$-O- | -CO-$CH_3$ | K 99 | E 136 I |
| $C_7H_{15}$-O- | -CO-$C_2H_5$ | K 98 | E 146.8 A 163.7 I |
| $C_7H_{15}$-O- | -CO-$C_3H_7$ | K 87 | E 120.2 A 145.2 I |
| $C_7H_{15}$-O- | -CO-$C_4H_9$ | K 106 | E 110 A 147 I |
| $C_7H_{15}$-O- | -CO-$C_5H_{11}$ | K 112.5 | A 142.3 I |
| $C_7H_{15}$-O- | -CO-$C_6H_{13}$ | K 123 | A 138 I |
| $C_7H_{15}$-O- | -CO-$C_7H_{15}$ | K 126.5 | A 139.7 I |
| $C_7H_{15}$-O- | -CO-$C_8H_{17}$ | K 119 | A 138.7 I |

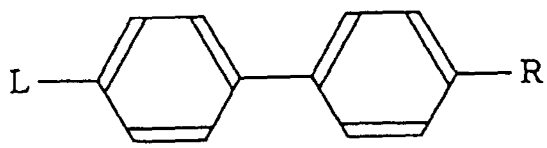

| L | R | Cr | LC |
|---|---|---|---|
| $C_7H_{15}$-O- | -CO-$C_9H_{19}$ | K 114 | A 134.7 I |
| $C_8H_{17}$-O- | -CO-$CH_3$ | K 96 | E 136.5 I |
| $C_8H_{17}$-O- | -CO-$C_2H_5$ | K 104 | E 144.8 A 161.8 I |
| $C_8H_{17}$-O- | -CO-$C_3H_7$ | K 96 | E 118.9 A 142.9 I |
| $C_8H_{17}$-O- | -CO-$C_4H_9$ | K 106.5 | E 107 A 145.7 I |
| $C_8H_{17}$-O- | -CO-$C_5H_{11}$ | K 104 | A 140 I |
| $C_8H_{17}$-O- | -CO-$C_6H_{13}$ | K 116 | A 140.3 I |
| $C_8H_{17}$-O- | -CO-$C_7H_{15}$ | K 125 | A 138.5 I |
| $C_8H_{17}$-O- | -CO-$C_8H_{17}$ | K 124.5 | A 137.4 I |
| $C_8H_{17}$-O- | -CO-$C_9H_{19}$ | K 124.5 | A 134.9 I |
| $C_9H_{19}$-O- | -CO-$CH_3$ | K 104.2 | E 135 I |
| $C_9H_{19}$-O- | -CO-$C_2H_5$ | K 112 | E 144.3 A 160 I |
| $C_9H_{19}$-O- | -CO-$C_3H_7$ | K 103.5 | E 118.2 A 141 I |
| $C_9H_{19}$-O- | -CO-$C_4H_9$ | K 101 | E 106.4 A 143.9 I |
| $C_9H_{19}$-O- | -CO-$C_5H_{11}$ | K 106 | A 138.5 I |
| $C_9H_{19}$-O- | -CO-$C_6H_{13}$ | K 112.8 | A 139 I |
| $C_9H_{19}$-O- | -CO-$C_7H_{15}$ | K 124 | A 136 I |
| $C_9H_{19}$-O- | -CO-$C_8H_{17}$ | K 124.5 | A 135.4 I |
| $C_9H_{19}$-O- | -CO-$C_9H_{19}$ | K 128.5 | A 132.8 I |
| $C_{10}H_{21}$-O- | -CO-$CH_3$ | K 103 | E 132 I |
| $C_{10}H_{21}$-O- | -CO-$C_2H_5$ | K 92 | E 143.4 A 157.5 I |
| $C_{10}H_{21}$-O- | -CO-$C_3H_7$ | K 90 | E 117.5 A 138.8 I |
| $C_{10}H_{21}$-O- | -CO-$C_4H_9$ | K 97 | E 106 A 141.2 I |
| $C_{10}H_{21}$-O- | -CO-$C_5H_{11}$ | K 101.9 | A 136.8 I |
| $C_{10}H_{21}$-O- | -CO-$C_6H_{13}$ | K 108.7 | A 137 I |
| $C_{10}H_{21}$-O- | -CO-$C_7H_{15}$ | K 110.5 | A 134 I |
| $C_{10}H_{21}$-O- | -CO-$C_8H_{17}$ | K 118 | A 133.3 I |
| $C_{10}H_{21}$-O- | -CO-$C_9H_{19}$ | K 123.5 | A 130.9 I |
| $C_{11}H_{23}$-O- | -CO-$CH_3$ | K 110.5 | E 130.6 I |
| $C_{12}H_{25}$-O- | -CO-$CH_3$ | K 109.8 | E 129.9 I |

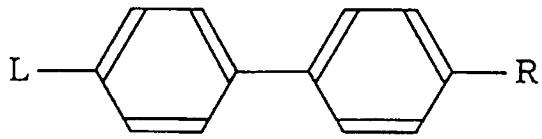

| L | R | Cr | LC |
|---|---|---|---|
| $C_{12}H_{25}$-O- | -CO-$C_2H_5$ | K 95.5 | E 139.3 A 151.5 I |
| $C_{12}H_{25}$-O- | -CO-$C_3H_7$ | K 105.5 | E 115.5 A 134.8 I |
| $C_{12}H_{25}$-O- | -CO-$C_4H_9$ | K 102 | E 105 S 115 A 141 I |
| $C_{12}H_{25}$-O- | -CO-$C_5H_{11}$ | K 98 | A 132.5 I |
| $C_{12}H_{25}$-O- | -CO-$C_6H_{13}$ | K 105 | A 131 I |
| $C_{12}H_{25}$-O- | -CO-$C_7H_{15}$ | K 108.5 | A 129.7 I |
| $C_{12}H_{25}$-O- | -CO-$C_8H_{17}$ | K 112.5 | A 129.8 I |
| $C_{12}H_{25}$-O- | -CO-$C_9H_{19}$ | K 115.5 | A 127.4 I |
| $C_{14}H_{29}$-O- | -CO-$CH_3$ | K 112.1 | E 123.2 B |
| $C_{16}H_{33}$-O- | -CO-$CH_3$ | K 116.8 | E 122.5 I |
| $C_4H_9$-O- | -CO-$CH_2$-CO-$C_4H_9$ | K 126.1 | A 155.4 I |
| $C_6H_{13}$-O- | -CO-$CH_2$-CO-$C_2H_5$ | K 108.6 | E 128.1 A 175.2 I |
| $C_8H_{17}$-O- | -CO-$CH_2$-CO-$CH_3$ | K 108.7 | E 140.7 A 176.5 I |
| $C_8H_{17}$-O- | -CO-$CH_2$-CO-$C_2H_5$ | K 101 | E 124.3 A 173.1 I |
| $C_8H_{17}$-O- | -CO-$CH_2$-CO-$C_4H_9$ | K 110.2 | A 152.5 I |
| $C_8H_{17}$-O- | -CO-$CH_2$-CO-$C_8H_{17}$ | K 125.3 | A 137 I |
| $C_9H_{19}$-O- | -CO-$CH_2$-CO-$CH_3$ | K 104.5 | E 141 A 175.5 I |
| $C_{10}H_{21}$-O- | -CO-$CH_2$-CO-$CH_3$ | K 100.5 | E 137.4 A 173.8 I |
| $C_{10}H_{21}$-O- | -CO-$CH_2$-CO-$C_2H_5$ | K 98.5 | E 123.4 A 168.3 I |
| $C_{11}H_{23}$-O- | -CO-$CH_2$-CO-$CH_3$ | K 108.5 | E 135.6 A 172 I |
| $C_{11}H_{23}$-O- | -CO-$CH_2$-CO-$C_2H_5$ | K 105.1 | E 123.7 A 166.8 I |
| $C_{12}H_{25}$-O- | -CO-$CH_2$-CO-$CH_3$ | K 105 | E 135 A 167.5 I |
| $C_{12}H_{25}$-O- | -CO-$CH_2$-CO-$C_2H_5$ | K 95.8 | E 120 A 161.5 I |
| $C_{12}H_{25}$-O- | -CO-$CH_2$-CO-$C_3H_7$ | K 112.5 | E 103.3 A 147 I |
| $C_{12}H_{25}$-O- | -CO-$CH_2$-CO-$C_4H_9$ | K 105.2 | A 133.8 I |
| $C_{12}H_{25}$-O- | -CO-$CH_2$-CO-$C_{12}H_{25}$ | K 124.4 | A 125.8 I |
| $C_{14}H_{29}$-O- | -CO-$CH_2$-CO-$C_2H_5$ | K 106 | E 120.5 A 158.5 I |
| $C_{16}H_{33}$-O- | -CO-$CH_2$-CO-$CH_3$ | K 118.9 | E 139.1 A 162 I |
| $C_{18}H_{37}$-O- | -CO-$CH_2$-CO-$CH_3$ | K 121.7 | E 137 A 157.8 I |
| $C_{18}H_{37}$-O- | -CO-$CH_2$-CO-$C_2H_5$ | K 113 | E 114.5 A 150.7 I |

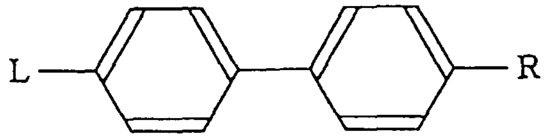

| L | R | Cr | LC |
|---|---|---|---|
| $CH_3$-O- | -COO-$C_6H_{13}$ | K 61.7 | E 45.4 I |
| $C_2H_5$-O- | -COO-$C_3H_7$ | K 102 | S 103 I |
| $C_3H_7$-O- | -COO-$C_3H_7$ | K 105 | S 107 I |
| $C_4H_9$-O- | -COO-$C_3H_7$ | K 97 | A 113.5 I |
| $C_4H_9$-O- | -COO-$C_4H_9$ | K 93 | E 92 A 102 I |
| $C_5H_{11}$-O- | -COO-$C_2H_5$ | K 114.5 | A 123.5 I |
| $C_5H_{11}$-O- | -COO-$C_3H_7$ | K 80 | A 106.5 I |
| $C_5H_{11}$-O- | -COO-$C_6H_{13}$ | K 63.7 | E 63.3 B 68.4 A 85.4 I |
| $C_5H_{11}$-O- | -COO-$C_7H_{15}$ | K ? | E 59 B 65 A 81 I |
| $C_5H_{11}$-O- | -COO-$C_{12}H_{25}$ | K 70.4 | E 54.4 A 70.6 I |
| $C_6H_{13}$-O- | -COO-$CH_3$ | K 124 | E 132 B 139 A 139 I |
| $C_6H_{13}$-O- | -COO-$C_2H_5$ | K 81 | E 92 B 97 A 119 I |
| $C_6H_{13}$-O- | -COO-$C_3H_7$ | K 80 | E 87 B 74 A 107 I |
| $C_6H_{13}$-O- | -COO-$C_4H_9$ | K 58 | B 64 A 92 I |
| $C_6H_{13}$-O- | -COO-$C_5H_{11}$ | K 83 | B 58 A 90 E |
| $C_6H_{13}$-O- | -COO-$C_6H_{13}$ | K 79 | B 57.5 A 86 E |
| $C_6H_{13}$-O- | -COO-$C_7H_{15}$ | K 76 | B 57 A 84 E |
| $C_6H_{13}$-O- | -COO-$C_8H_{17}$ | K 74 | B 56 A 82 I |
| $C_6H_{13}$-O- | -COO-$C_9H_{19}$ | K 71 | B 55 A 80 I |
| $C_6H_{13}$-O- | -COO-$C_{10}H_{21}$ | K 59 | B 54.5 A 78 I |
| $C_7H_{15}$-O- | -COO-$CH_3$ | K 124 | E 127 B 133 A 133 I |
| $C_7H_{15}$-O- | -COO-$C_2H_5$ | K 52 | E 88 B 94 A 111 I |
| $C_7H_{15}$-O- | -COO-$C_3H_7$ | K 78 | E 54 B 84 A 102 I |
| $C_7H_{15}$-O- | -COO-$C_4H_9$ | K 62 | C 59 A 89 I |
| $C_7H_{15}$-O- | -COO-$C_5H_{11}$ | K 79 | C 50 A 87 E |
| $C_7H_{15}$-O- | -COO-$C_6H_{13}$ | K 86 | C 60 A 84 E |
| $C_7H_{15}$-O- | -COO-$C_7H_{15}$ | K 86 | C 55 A 82 E |
| $C_7H_{15}$-O- | -COO-$C_8H_{17}$ | K 76 | A 80 I |
| $C_7H_{15}$-O- | -COO-$C_9H_{19}$ | K 69 | A 78 I |
| $C_7H_{15}$-O- | -COO-$C_{10}H_{21}$ | K 69 | A 76 I |

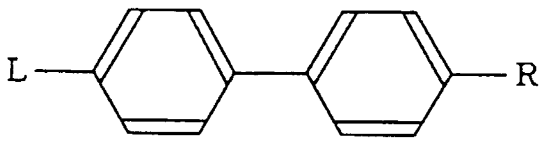

| L | R | Cr | LC |
|---|---|---|---|
| $C_8H_{17}$-O- | -COO-$CH_3$ | K 117 | E 126 B 132 A 132 I |
| $C_8H_{17}$-O- | -COO-$C_2H_5$ | K 75 | E 88 B 96 A 112 I |
| $C_8H_{17}$-O- | -COO-$C_3H_7$ | K 83 | B 64 A 101 I |
| $C_8H_{17}$-O- | -COO-$C_4H_9$ | K 56 | C 56 A 86 I |
| $C_8H_{17}$-O- | -COO-$C_5H_{11}$ | K 66 | C 55 A 88 E |
| $C_8H_{17}$-O- | -COO-$C_6H_{13}$ | K 72 | C 56 A 82 E |
| $C_8H_{17}$-O- | -COO-$C_7H_{15}$ | K 87 | C 46 A 83 E |
| $C_8H_{17}$-O- | -COO-$C_8H_{17}$ | K 80 | A 80 I |
| $C_8H_{17}$-O- | -COO-$C_9H_{19}$ | K 79 | A 80 I |
| $C_8H_{17}$-O- | -COO-$C_{10}H_{21}$ | K 75 | A 79 I |
| $C_8H_{17}$-O- | -COO-$C_{11}H_{23}$ | K 74 | A 79 I |
| $C_8H_{17}$-O- | -COO-$C_{12}H_{25}$ | K 78 | A 76 I |
| $C_8H_{17}$-O- | -COO-$C_{13}H_{27}$ | K 77 | A 76 I |
| $C_8H_{17}$-O- | -COO-$C_{14}H_{29}$ | K 80 | A 74 I |
| $C_8H_{17}$-O- | -COO-$C_{15}H_{31}$ | K 77 | A 74 I |
| $C_8H_{17}$-O- | -COO-$C_{16}H_{33}$ | K 83 | A 72 I |
| $C_8H_{17}$-O- | -COO-$C_{17}H_{35}$ | K 81 | A 72 E |
| $C_8H_{17}$-O- | -COO-$C_{18}H_{37}$ | K 80 | A 70 E |
| $C_8H_{17}$-O- | -COO-$C_{19}H_{39}$ | K 81 | A 69 E |
| $C_9H_{19}$-O- | -COO-$CH_3$ | K 124 | E 123 B 129 A 129 I |
| $C_9H_{19}$-O- | -COO-$C_2H_5$ | K 78 | E 81 B 91 A 106 I |
| $C_9H_{19}$-O- | -COO-$C_3H_7$ | K 67 | B 63 A 99 I |
| $C_9H_{19}$-O- | -COO-$C_4H_9$ | K 64 | C 56 A 88 I |
| $C_9H_{19}$-O- | -COO-$C_5H_{11}$ | K 62 | C 55 A 86 E |
| $C_9H_{19}$-O- | -COO-$C_6H_{13}$ | K 71 | C 57 A 83 E |
| $C_9H_{19}$-O- | -COO-$C_7H_{15}$ | K 84 | C 54 A 82 E |
| $C_9H_{19}$-O- | -COO-$C_8H_{17}$ | K 86 | C 36 A <84 E |
| $C_{10}H_{21}$-O- | -COO-$CH_3$ | K 122 | E 117 B 124 A 124 I |
| $C_{10}H_{21}$-O- | -COO-$C_2H_5$ | K 71 | E 80 B 90 A 104 I |
| $C_{10}H_{21}$-O- | -COO-$C_3H_7$ | K ? | B 67.9 A 99 I |

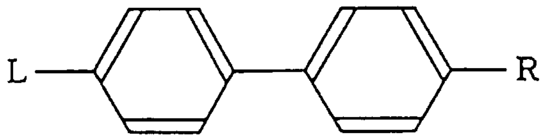

| L | R | Cr | LC |
|---|---|---|---|
| $C_{10}H_{21}$-O- | -COO-$C_4H_9$ | K 54 | C 49 A 82 I |
| $C_{10}H_{21}$-O- | -COO-$C_5H_{11}$ | K 66 | C 53 A 82 I |
| $C_{10}H_{21}$-O- | -COO-$C_6H_{13}$ | K 60 | C 67 A 84 I |
| $C_{10}H_{21}$-O- | -COO-$C_7H_{15}$ | K 74 | C 66 A 80 E |
| $C_{10}H_{21}$-O- | -COO-$C_8H_{17}$ | K 83 | C 67 A 78 E |
| $C_{10}H_{21}$-O- | -COO-$C_9H_{19}$ | K 86 | C 52 A ? E |
| $C_{10}H_{21}$-O- | -COO-$C_{10}H_{21}$ | K 85 | C 54 A ? E |
| $C_{12}H_{25}$-O- | -COO-$CH_3$ | K 122.5 | S 124 I |
| $C_{12}H_{25}$-O- | -COO-$C_2H_5$ | K 80.5 | S 102.5 I |
| $C_{12}H_{25}$-O- | -COO-$C_3H_7$ | K 71 | S 97 I |
| $C_{12}H_{25}$-O- | -COO-$C_6H_{13}$ | K 69 | G 57.8 C 67.5 A 80 I |
| $C_{12}H_{25}$-O- | -COO-$C_7H_{15}$ | K 77 | G 72 C 74 A 81 I |
| $C_{12}H_{25}$-O- | -COO-$C_8H_{17}$ | K 76.3 | C 72.6 A 80 I |
| $C_{14}H_{29}$-O- | -COO-$C_6H_{13}$ | K 68 | G 58.8 C 68.2 A 81 I |
| $C_{14}H_{29}$-O- | -COO-$C_7H_{15}$ | K 71.2 | C 72.5 A 82.5 I |
| $C_{14}H_{29}$-O- | -COO-$C_8H_{17}$ | K 76 | C 74.5 A 80.5 I |
| $C_{16}H_{33}$-O- | -COO-$C_2H_5$ | K 88 | B 82 A 94 I |
| $C_{16}H_{33}$-O- | -COO-$C_3H_7$ | K 80 | B 46 A 89 E |
| $C_{16}H_{33}$-O- | -COO-$C_4H_9$ | K 78 | A 79 I |
| $C_{16}H_{33}$-O- | -COO-$C_5H_{11}$ | K 79 | G 40 A 81 E |
| $C_{16}H_{33}$-O- | -COO-$C_6H_{13}$ | K 75 | G 60 A 78 E |
| $C_{16}H_{33}$-O- | -COO-$C_7H_{15}$ | K 77 | G 72 A 80 I |
| $C_{16}H_{33}$-O- | -COO-$C_8H_{17}$ | K 74 | G 76 A 78 I |
| $C_{16}H_{33}$-O- | -COO-$C_9H_{19}$ | K 83 | G 78 A 80 I |
| $C_{16}H_{33}$-O- | -COO-$C_{10}H_{21}$ | K 83 | G 77 A 78 E |
| $C_{16}H_{33}$-O- | -COO-$C_{11}H_{23}$ | K 88 | G 72 A 79 E |
| $C_{16}H_{33}$-O- | -COO-$C_{12}H_{25}$ | K 89 | G 64 A 77 E |
| $C_{16}H_{33}$-O- | -COO-$C_{13}H_{27}$ | K 91 | G 40 A 78 E |
| $C_{18}H_{37}$-O- | -COO-$C_2H_5$ | K 72 | B 55 A 87 E |
| $C_{18}H_{37}$-O- | -COO-$C_3H_7$ | K 83 | A 86 I |

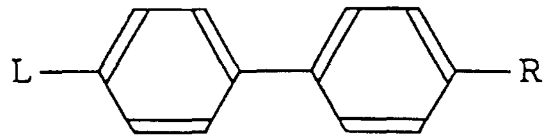

| L | R | | Cr | LC |
|---|---|---|---|---|
| $C_9H_{19}$-O- | -OOC-CHCl-CHMe-$CH_3$ | 1 | K 80 | S 62.5 C* 68 A 82.5 I |
| $C_{10}H_{21}$-O- | -OOC-CHCl-CHMe-$CH_3$ | 1 | K 82 | C* 69 A 81 I |
| $C_{11}H_{23}$-O- | -OOC-CHCl-CHMe-$CH_3$ | S | K 86 | A 85 I |
| $C_{12}H_{25}$-O- | -OOC-CHCl-CHMe-$CH_3$ | 1 | K 92 | A 85 I |
| $C_7H_{15}$-O- | -OOC-CHCl-CHMe-$CH_3$ | 2 | K ? | G 70.2 C 72.4 A 82 I |
| $C_5H_{11}$-O- | -OOC-CHCl-CHMe-$C_2H_5$ | 3 | K ? | C* 55 A 64 B |
| $C_6H_{13}$-O- | -OOC-CHCl-CHMe-$C_2H_5$ | 3 | K 47 | S 48 C* 51.5 A 61 I |
| $C_7H_{15}$-O- | -OOC-CHCl-CHMe-$C_2H_5$ | 3 | K 55 | C* 55 A 62 I |
| $C_8H_{17}$-O- | -OOC-CHCl-CHMe-$C_2H_5$ | 3 | K 48 | S 36 C* 56 A 66 I |
| $C_9H_{19}$-O- | -OOC-CHCl-CHMe-$C_2H_5$ | 3 | K 52 | C* 53.5 A 65 I |
| $C_{10}H_{21}$-O- | -OOC-CHCl-CHMe-$C_2H_5$ | 3 | K 50 | C* 43 A 49 U |
| $C_{12}H_{25}$-O- | -OOC-CHCl-CHMe-$C_2H_5$ | 3 | K 62 | C* 66 A 67 I |
| $C_{14}H_{29}$-O- | -OOC-CHCl-CHMe-$C_2H_5$ | 3 | K 66 | A 68 I |
| $C_8H_{17}$-O- | -OOC-CHCl-CHMe-$C_2H_5$ | 5 | K ? | C* 59 A 60 I |
| $C_6H_{13}$-O- | -OOC-CHBr-CHMe-$CH_3$ | S | K 64 | C* 67 I |
| $C_8H_{17}$-O- | -OOC-CHBr-CHMe-$CH_3$ | S | K 35 | C* 48 A 56 I |
| $C_{10}H_{21}$-O- | -OOC-CHBr-CHMe-$CH_3$ | S | K 55 | C* 57 A 68 I |
| $C_{12}H_{25}$-O- | -OOC-CHBr-CHMe-$CH_3$ | S | K 69 | A 70 I |
| $C_6H_{13}$-O- | -OOC-CHBr-CHMe-$C_2H_5$ | 3 | K ? | C* 55 B |
| $C_8H_{17}$-O- | -OOC-CHBr-CHMe-$C_2H_5$ | 3 | K 20 | C* 42 A 53 I |
| $C_{10}H_{21}$-O- | -OOC-CHBr-CHMe-$C_2H_5$ | 3 | K ? | C* 49 A 58 B |
| $C_{12}H_{25}$-O- | -OOC-CHBr-CHMe-$C_2H_5$ | 3 | K ? | C* 47 A 59 B |
| $C_8H_{17}$-O- | -OOC-CHMe-CHMe-$C_2H_5$ | 3 | K 48 | I* 36 C* 53 A 64 I |
| $C_8H_{17}$-O- | -OCOO-$CH_2$-CHCl-CHMe-$C_2H_5$ | 3 | K 43 | C* 50 I |
| 2($C_2H_5$-OOC)-CH-$C_6H_{12}$-O- | -O-CHMe-$C_6H_{13}$ | S | K -20 | X 19 I |
| $C_5H_{11}$-COO- | -CO-CHMe-$C_2H_5$ | S | K ? | S 15 S 32 A 57 I |
| $C_8H_{17}$-COO- | -CO-CHMe-$C_2H_5$ | S | K 47.8 | A 65.1 I |
| $C_{13}H_{27}$-COO- | -CO-CHMe-$C_2H_5$ | S | K 69.4 | A 66.7 I |
| $C_7H_{15}$-COO- | -COO-CHMe-$C_2H_5$ | R | K 46.7 | C* 22.4 A 44.6 I |
| $C_8H_{17}$-COO- | -COO-CHMe-$C_2H_5$ | R | K 56.2 | C* 26.4 A 45.6 I |

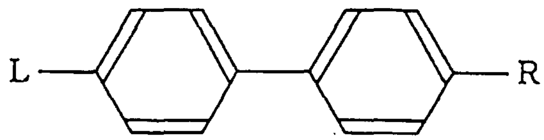

| L | R | Cr | LC |
|---|---|---|---|
| $C_{18}H_{37}$-O- | -COO-$C_4H_9$ | K 83 | A 78 I |
| $C_{18}H_{37}$-O- | -COO-$C_5H_{11}$ | K 83 | A 79 I |
| $C_{18}H_{37}$-O- | -COO-$C_6H_{13}$ | K 84 | G 50 A 76 E |
| $C_{18}H_{37}$-O- | -COO-$C_7H_{15}$ | K 82 | G 67 A 78 E |
| $C_{18}H_{37}$-O- | -COO-$C_8H_{17}$ | K 84 | G 75 A 76 E |
| $C_{18}H_{37}$-O- | -COO-$C_9H_{19}$ | K 80 | G 77 A 78 I |
| $C_{18}H_{37}$-O- | -COO-$C_{10}H_{21}$ | K 84 | G 75 A 78 E |
| $C_{18}H_{37}$-O- | -COO-$C_{11}H_{23}$ | K 81 | G 66 A 78 E |
| $C_{18}H_{37}$-O- | -COO-$C_{12}H_{25}$ | K 88 | A 76 E |
| $C_5H_{11}$-O- | -COS-$C_6H_{13}$ | K 91 | L 121 A 149.5 I |
| $C_5H_{11}$-O- | -OOC-$C_5H_{11}$ | K 7 | E 97.7 B 106 I |
| $C_8H_{17}$-O- | -OOC-$C_9H_{19}$ | K 57 | G 107 F 108.5 I |
| $C_8H_{17}$-O- | -OOC-$C_{11}H_{23}$ | K 78 | G 105 F 108.5 I |
| $C_8H_{17}$-O- | -OOC-$C_{13}H_{27}$ | K 82 | G 104 F 108 I |
| $C_7H_{15}$-NH- | -NH-$C_7H_{15}$ | K 96.8 | C 93 N 103.8 I |
| $C_8H_{17}$-NH- | -NH-$C_8H_{17}$ | K 99 | I 98.1 C 110 N 110.4 I |
| $C_9H_{19}$-NH- | -NH-$C_9H_{19}$ | K 93.8 | I 102 C 112.8 I |
| $C_{10}H_{21}$-NH- | -NH-$C_{10}H_{21}$ | K 97.1 | I 108.8 C 116.8 I |
| $C_{11}H_{23}$-NH- | -NH-$C_{11}H_{23}$ | K 85.4 | F 92.8 I 109.9 C 117 I |
| $C_{12}H_{25}$-NH- | -NH-$C_{12}H_{25}$ | K 98.4 | I 113.5 C 117.8 I |
| $C_{16}H_{33}$-NH- | -NH-$C_{16}H_{33}$ | K 103 | I 115.6 I |
| $C_{18}H_{37}$-NH- | -NH-$C_{18}H_{37}$ | K 105.2 | I 114.6 I |
| $CH_3$-O-$C_2H_4$-O- | -O-$C_2H_4$-O-$CH_3$ | K 127 | K 139 I |
| $C_2H_5$-O-$C_2H_4$-O- | -O-$C_2H_4$-O-$C_2H_5$ | K 75 | K 118 I |
| $C_6H_{13}$-OCOO-$C_2H_4$-O- | -O-$C_2H_4$-OCOO-$C_6H_{13}$ | K 83 | S 109 I |
| $C_7H_{15}$-OCOO-$C_2H_4$-O- | -O-$C_2H_4$-OCOO-$C_7H_{15}$ | K 77 | S 85 I |
| $C_8H_{17}$-OCOO-$C_2H_4$-O- | -O-$C_2H_4$-OCOO-$C_8H_{17}$ | K 83 | S 88 I |
| $CH_3$-OCOO-$C_6H_{12}$-O- | -O-$C_6H_{12}$-OCOO-$CH_3$ | K 107 | S 169 I |
| $C_2H_5$-OCOO-$C_6H_{12}$-O- | -O-$C_6H_{12}$-OCOO-$C_2H_5$ | K 98 | S 166 I |
| $C_3H_7$-OCOO-$C_6H_{12}$-O- | -O-$C_6H_{12}$-OCOO-$C_3H_7$ | K 95 | S 157 I |
| $C_4H_9$-OCOO-$C_6H_{12}$-O- | -O-$C_6H_{12}$-OCOO-$C_4H_9$ | K 90 | S 170 I |
| $C_5H_{11}$-OCOO-$C_6H_{12}$-O- | -O-$C_6H_{12}$-OCOO-$C_5H_{11}$ | K 89 | S 150 I |
| $C_6H_{13}$-OCOO-$C_6H_{12}$-O- | -O-$C_6H_{12}$-OCOO-$C_6H_{13}$ | K 89 | S 168 I |
| $C_7H_{15}$-OCOO-$C_6H_{12}$-O- | -O-$C_6H_{12}$-OCOO-$C_7H_{15}$ | K 85 | S 150 I |
| $C_8H_{17}$-OCOO-$C_6H_{12}$-O- | -O-$C_6H_{12}$-OCOO-$C_8H_{17}$ | K 88 | S 172 I |
| $C_9H_{19}$-CO- | -CO-$C_9H_{19}$ | K 149.3 | C 147.6 I |
| $C_{10}H_{21}$-CO- | -CO-$C_{10}H_{21}$ | K 141 | S 142 I |
| $C_5H_{11}$-CO- | -OOC-$C_5H_{11}$ | K 87.5 | E 91 B 111.5 A 140 I |
| $C_2H_5$-CO- | -NHOC-$C_3H_7$ | K 233 | S 225 I |
| $C_2H_5$-OOC- | -COO-$C_2H_5$ | K 114 | X <? U |

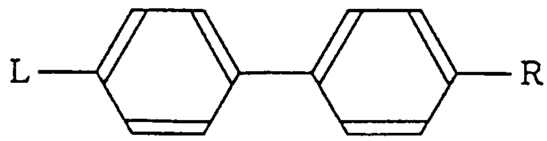

| L | R | | Cr | LC |
|---|---|---|---|---|
| $CH_3$-OOC- | -OOC-$C_4H_9$ | | K 86.5 | S 112 L 118 I |
| $C_2H_5$-OOC- | -OOC-$C_4H_9$ | | K 96 | L 100 I |
| $C_3H_7$-OOC- | -OOC-$C_4H_9$ | | K 59.8 | B 63.3 A 81 I |
| $C_4H_9$-OOC- | -OOC-$C_4H_9$ | | K 80.3 | S 63.4 L 64.9 A 74.4 I |
| $C_5H_{11}$-OOC- | -OOC-$C_4H_9$ | | K 49.7 | S 52.8 L 55.4 A 70.2 I |
| $C_6H_{13}$-OOC- | -OOC-$C_4H_9$ | | K 49.1 | L 56.7 A 68.4 I |
| $C_7H_{15}$-OOC- | -OOC-$C_4H_9$ | | K 47.3 | L 52.8 A 66.8 I |
| $C_7H_{15}$-OOC- | -OOC-$C_5H_{11}$ | | K 50 | B 80.5 A 83 I |
| $C_7H_{15}$-OOC- | -OOC-$C_7H_{15}$ | | K 57 | B 76.5 A 79 I |
| $C_8H_{17}$-OOC- | -OOC-$C_4H_9$ | | K 81.4 | L 52.3 A 56.6 I |
| $C_8H_{17}$-OOC- | -OOC-$C_7H_{15}$ | | K 52 | B 70.5 A 76 I |
| $C_8H_{17}$-OOC- | -OOC-$C_9H_{19}$ | | K 49 | B 82 A 85 I |
| $C_9H_{19}$-OOC- | -OOC-$C_4H_9$ | | K 49.6 | B 48.4 A 61.8 I |
| $C_{10}H_{21}$-OOC- | -OOC-$C_4H_9$ | | K 68.4 | A 60.2 I |
| $C_{10}H_{21}$-OOC- | -OOC-$C_5H_{11}$ | | K 55 | B 65 A 58 I |
| $C_{10}H_{21}$-OOC- | -OOC-$C_9H_{19}$ | | K 82.5 | B 77.5 A 81 I |
| $C_{11}H_{23}$-OOC- | -OOC-$C_4H_9$ | | K 59.5 | A 82.8 I |
| $C_8H_{17}$-COO- | -COO-$CH_2$-CHMe-O-$CH_3$ | 1 | K 49.6 | A 48.3 I |
| $C_8H_{17}$-COO- | -COO-$CH_2$-CHMe-O-$C_3H_7$ | 1 | K 28 | I* 21.1 A 44.2 I |
| $C_8H_{17}$-COO- | -COO-$CH_2$-CHMe-O-$C_6H_{13}$ | 1 | K 7 | A 39.7 I |
| $C_9H_{19}$-COO- | -COO-$CH_2$-CHMe-O-$CH_3$ | 1 | K 35.8 | A 52.8 I |
| $C_9H_{19}$-COO- | -COO-$CH_2$-CHMe-O-$C_3H_7$ | 1 | K 33.1 | I* 28 A 50 I |
| $C_9H_{19}$-COO- | -COO-$CH_2$-CHMe-O-$C_6H_{13}$ | 1 | K 35.7 | A 44.4 I |
| $C_{10}H_{21}$-COO- | -COO-$CH_2$-CHMe-O-$CH_3$ | 1 | K 53 | A 54.4 I |
| $C_{10}H_{21}$-COO- | -COO-$CH_2$-CHMe-O-$C_3H_7$ | 1 | K 39.8 | I* 32.1 A 49.8 I |
| $C_{10}H_{21}$-COO- | -COO-$CH_2$-CHMe-O-$C_6H_{13}$ | 1 | K 38.9 | A 46.3 I |
| $C_{11}H_{23}$-COO- | -COO-$CH_2$-CHMe-O-$CH_3$ | 1 | K 47 | A 58 I |
| $C_{11}H_{23}$-COO- | -COO-$CH_2$-CHMe-O-$C_3H_7$ | 1 | K 47 | A 58 I |
| $C_{11}H_{23}$-COO- | -COO-$CH_2$-CHMe-O-$C_6H_{13}$ | 1 | K 47.1 | A 48.4 I |
| $C_{13}H_{27}$-COO- | -COO-$CH_2$-CHMe-O-$C_3H_7$ | 1 | K 58.2 | A 60.4 I |

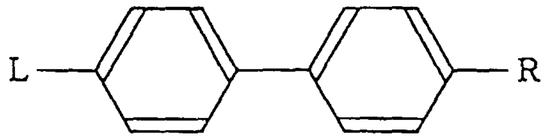

| L | R | | Cr | LC |
|---|---|---|---|---|
| $CH_3$-COO- | -OOC-$CH_3$ | | K 163 | X <? I |
| $C_5H_{11}$-COO- | -OOC-$C_5H_{11}$ | | K 117 | S 118 I |
| $C_6H_{13}$-COO- | -OOC-$C_6H_{13}$ | | K 105 | S 118 I |
| $C_7H_{15}$-COO- | -OOC-$C_7H_{15}$ | | K 95 | S 122 I |
| $C_8H_{17}$-COO- | -OOC-$C_8H_{17}$ | | K 95 | S 121 I |
| $C_9H_{19}$-COO- | -OOC-$C_9H_{19}$ | | K 98 | S 122 I |
| $C_5H_{11}$-COO- | -OOC-CHMe-CHMe-O-$CH_3$ | 1 | K 47 | C* 55 I |
| $C_6H_{13}$-COO- | -OOC-CHMe-CHMe-O-$CH_3$ | 1 | K 23 | S 31 C* 39 I |
| $C_7H_{15}$-COO- | -OOC-CHMe-CHMe-O-$CH_3$ | 1 | K 37 | C* 46 I |
| $C_8H_{17}$-COO- | -OOC-CHMe-CHMe-O-$CH_3$ | 1 | K 38 | C* 47 I |
| $C_8H_{17}$-COO- | -OOC-CHMe-CHMe-O-$C_4H_9$ | 1 | K 47 | S 49 C* 56 I |
| $CH_3$-OCOO- | -OCOO-$CH_3$ | | K 148 | X <? I |
| $C_2H_5$-OCOO- | -OCOO-$C_2H_5$ | | K 96 | X <? I |
| $C_4H_9$-COO-N=CMe- | -CMe=N-OOC-$C_4H_9$ | | K 111 | A 121 I |
| $C_8H_{17}$-COO-N=CMe- | -CMe=N-OOC-$C_8H_{17}$ | | K 104 | A 132 I |
| $C_8H_{17}$- | -O-CHMe-$C_6H_{13}$ | 1 | K ? | I |
| $C_7H_{15}$- | -OOC-CHMe-$C_2H_5$ | 1 | K 28.5 | S 57.3 I |
| $C_9H_{19}$-O- | -$C_2H_4$-COO-CHMe-$C_6H_{13}$ | 1 | K 72.4 | N* 145.9 U |
| $C_{12}H_{25}$-O- | -CO-CHMe-$C_3H_7$ | 2 | K 47 | A 49 I |
| $C_6H_{13}$-O- | -COO-CHMe-$C_2H_5$ | 1 | K 43 | A 38 U |
| $C_8H_{17}$-O- | -COO-CHMe-$C_2H_5$ | S | K 64.5 | C* 30 A 53 I |
| $C_9H_{19}$-O- | -COO-CHMe-$C_6H_{13}$ | 1 | K ? | C* ? N* ? U |
| $C_8H_{17}$-O- | -COO-CHMe-$CH_3$ | | K 75 | C 41 A 69 I |
| $C_8H_{17}$-O- | -COO-CHMe-$C_2H_5$ | 2 | K 67 | C 31 A 50 I |
| $C_8H_{17}$-O- | -COO-CHMe-$C_3H_7$ | 2 | K 43 | C 26 A 36 I |
| $C_8H_{17}$-O- | -COO-CHMe-$C_4H_9$ | 2 | K 49 | A 34 E |
| $C_8H_{17}$-O- | -COO-CHMe-$C_5H_{11}$ | 2 | K 61 | A 30 E |
| $C_8H_{17}$-O- | -COO-CHMe-$C_6H_{13}$ | 2 | K 57 | A 37 E |
| $C_8H_{17}$-O- | -COO-CHMe-$C_7H_{15}$ | 2 | K 61 | A 37 E |
| $C_6H_{13}$-O- | -COO-$CH_2$-CHCl-CHMe-$CH_3$ | 1 | K 46 | C* 15 A 15 U |

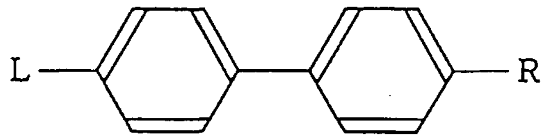

| L | R | | Cr | LC |
|---|---|---|---|---|
| $C_8H_{17}$-O- | -COO-$CH_2$-CHCl-CHMe-$CH_3$ | 1 | K 34 | C* 34 A 54 I |
| $C_9H_{19}$-O- | -COO-$CH_2$-CHCl-CHMe-$CH_3$ | 1 | K 39 | C* 44 A 58 I |
| $C_{10}H_{21}$-O- | -COO-$CH_2$-CHCl-CHMe-$CH_3$ | 1 | K 36 | C* 45 A 58 I |
| $C_{11}H_{23}$-O- | -COO-$CH_2$-CHCl-CHMe-$CH_3$ | 1 | K 55 | C* 49 A 60 I |
| $C_{12}H_{25}$-O- | -COO-$CH_2$-CHCl-CHMe-$CH_3$ | 1 | K 52 | C* 47 A 61 I |
| $C_{13}H_{27}$-O- | -COO-$CH_2$-CHCl-CHMe-$CH_3$ | 1 | K 57 | A 61 I |
| $C_6H_{13}$-O- | -COO-$CH_2$-CHCl-CHMe-$C_2H_5$ | 3 | K 31 | C* 10 A 40 I |
| $C_7H_{15}$-O- | -COO-$CH_2$-CHCl-CHMe-$C_2H_5$ | 3 | K 75 | C* 39 A 56 I |
| $C_8H_{17}$-O- | -COO-$CH_2$-CHCl-CHMe-$C_2H_5$ | 3 | K 15 | S 16 C* 32 A 50 I |
| $C_9H_{19}$-O- | -COO-$CH_2$-CHCl-CHMe-$C_2H_5$ | 3 | K 27 | C* 40 A 53 I |
| $C_{10}H_{21}$-O- | -COO-$CH_2$-CHCl-CHMe-$C_2H_5$ | 3 | K 39 | C* 41 A 54 I |
| $C_{11}H_{23}$-O- | -COO-$CH_2$-CHCl-CHMe-$C_2H_5$ | 3 | K 35 | C* 42 A 55 I |
| $C_{12}H_{25}$-O- | -COO-$CH_2$-CHCl-CHMe-$C_2H_5$ | 3 | K 40 | C* 43 A 57 I |
| $C_{13}H_{27}$-O- | -COO-$CH_2$-CHCl-CHMe-$C_2H_5$ | 3 | K 45 | C* 47 A 60 I |
| $C_8H_{17}$-O- | -COO-CHMe-COO-CHMe-$C_6H_{13}$ | 3 | K 42 | A 21 I |
| $C_8H_{17}$-O- | -OOC-CHMe-$C_2H_5$ | 1 | K 69.4 | C* 84.4 I |
| $C_{10}H_{21}$-O- | -OOC-CHMe-$C_2H_5$ | S | K 74.8 | H 75.8 C* 79.4 A 83.2 I |
| $C_{11}H_{23}$-O- | -OOC-CHMe-$C_2H_5$ | 1 | K 70 | C* 72 I |
| $C_{12}H_{25}$-O- | -OOC-CHMe-$C_2H_5$ | 1 | K 68 | C* 69 I |
| $C_{14}H_{29}$-O- | -OOC-CHMe-$C_2H_5$ | 1 | K 84 | A 81.4 I |
| $C_7H_{15}$-O- | -OOC-CHF-CHMe-$CH_3$ | S | K 89 | S 105 A 107 I |
| $C_8H_{17}$-O- | -OOC-CHF-CHMe-$CH_3$ | S | K 95 | S 103 N* 109 I |
| $C_8H_{17}$-O- | -OOC-CHF-CHMe-$C_2H_5$ | 3 | K ? | C* ? I |
| $C_{10}H_{21}$-O- | -OOC-CHF-CHMe-$C_2H_5$ | 3 | K ? | I |
| $C_{12}H_{25}$-O- | -OOC-CHF-CHMe-$C_2H_5$ | 3 | K 61 | A 72 I |
| $C_8H_{17}$-O- | -OOC-CHF-CHMe-$C_2H_5$ | 5 | K 84 | C* 86 A 94 I |
| $C_{12}H_{25}$-O- | -OOC-CHF-CHMe-$C_2H_5$ | 5 | K 71 | C* 81 A 93 I |
| $C_6H_{13}$-O- | -OOC-CHCl-CHMe-$CH_3$ | 1 | K ? | G* 77.6 A 83.3 I |
| $C_7H_{15}$-O- | -OOC-CHCl-CHMe-$CH_3$ | 1 | K 72 | H 64 G* 71 C* 73 A 81.5 I |
| $C_8H_{17}$-O- | -OOC-CHCl-CHMe-$CH_3$ | 1 | K 76 | S 66 C* 71 A 83 I |

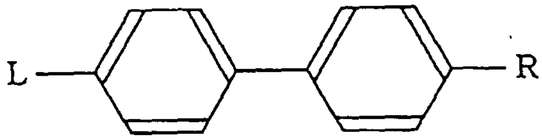

| L | R | | Cr | LC |
|---|---|---|---|---|
| $C_8H_{17}$-COO- | -COO-CHMe-$C_3H_7$ | 1 | K 48.2 | A 38.4 I |
| $C_8H_{17}$-COO- | -COO-CHMe-$C_4H_9$ | 1 | K 29.6 | A 32.6 I |
| $C_8H_{17}$-COO- | -COO-CHMe-$C_5H_{11}$ | 1 | K 37 | A 31.9 I |
| $C_8H_{17}$-COO- | -COO-CHMe-$C_6H_{13}$ | 1 | K 34.3 | A 26.3 I |
| $C_8H_{17}$-COO- | -COO-CHMe-$C_7H_{15}$ | 1 | K 34 | A 26 I |
| $C_9H_{19}$-COO- | -COO-CHMe-$C_2H_5$ | R | K 31.3 | J* 21.1 C* 35.2 A 48.9 I |
| $C_{10}H_{21}$-COO- | -COO-CHMe-$C_2H_5$ | R | K 44.6 | J* 31.1 C* 36.9 A 48.5 I |
| $C_{11}H_{23}$-COO- | -COO-CHMe-$C_2H_5$ | R | K 41.2 | J* 38.6 C* 41.2 A 50.5 I |
| $C_{12}H_{25}$-COO- | -COO-CHMe-$C_2H_5$ | R | K 43.5 | J* 41.3 A 50 I |
| $C_{13}H_{27}$-COO- | -COO-CHMe-$C_2H_5$ | R | K 49.8 | J* 46.7 A 52.7 I |
| $C_6H_{13}$-COO- | -COO-$CH_2$-CHCl-CHMe-$CH_3$ | 1 | K 46 | C* 15 A 45 I |
| $C_8H_{17}$-COO- | -COO-$CH_2$-CHCl-CHMe-$CH_3$ | 1 | K 37 | I* 10 C* 40 A 54 I |
| $C_9H_{19}$-COO- | -COO-$CH_2$-CHCl-CHMe-$CH_3$ | 1 | K ? | C* ? I |
| $C_{10}H_{21}$-COO- | -COO-$CH_2$-CHCl-CHMe-$CH_3$ | 1 | K 36 | C* 45 A 58 I |
| $C_6H_{13}$-COO- | -COO-$CH_2$-CHCl-CHMe-$C_2H_5$ | 3 | K 31 | C* 10 A 40 I |
| $C_8H_{17}$-COO- | -COO-$CH_2$-CHCl-CHMe-$C_2H_5$ | 3 | K 36 | S 13 C* 36 A 49 I |
| $C_{10}H_{21}$-COO- | -COO-$CH_2$-CHCl-CHMe-$C_2H_5$ | 3 | K 36 | C* 41 A 52 I |
| $C_8H_{17}$-COO- | -COO-$CH_2$-CHCl-CHMe-$C_2H_5$ | 5 | K 6 | C* 37 A 47 I |
| $C_8H_{17}$-COO- | -COO-$CH_2$-CH(OMe)-CHMe-$CH_3$ | R | K 25 | S 10 C* 19 A 39 I |
| $C_8H_{17}$-COO- | -COO-$CH_2$-CH(OMe)-CHMe-$C_2H_5$ | 3 | K 38 | C* 18 A 37 I |
| $C_8H_{17}$-COO- | -OOC-CHCl-CHMe-$CH_3$ | 1 | K 66 | S 85 C* 95 I |
| $C_9H_{19}$-COO- | -OOC-CHCl-CHMe-$CH_3$ | 1 | K 68 | S 82 C* 91 A 92 I |
| $C_6H_{13}$-COO- | -OOC-CHCl-CHMe-$C_2H_5$ | 3 | K 36 | S 51 C* 67 I |
| $C_7H_{15}$-COO- | -OOC-CHCl-CHMe-$C_2H_5$ | 3 | K ? | C* ? I |
| $C_8H_{17}$-COO- | -OOC-CHCl-CHMe-$C_2H_5$ | 3 | K 41 | S 49 C* 71 I |
| $C_{10}H_{21}$-COO- | -OOC-CHCl-CHMe-$C_2H_5$ | 3 | K 48 | S 53 C* 80 I |
| $C_6H_{13}$-COO- | -OCOO-$CH_2$-CHCl-CHMe-$C_2H_5$ | 3 | K 53 | S 49 I |
| $C_8H_{17}$-COO- | -OCOO-$CH_2$-CHCl-CHMe-$C_2H_5$ | 3 | K 46 | S 46 C* 53 I |
| $C_9H_{19}$-COO- | -OCOO-$CH_2$-CHCl-CHMe-$C_2H_5$ | 3 | K 54 | S 54 C* 56 I |
| $C_8H_{17}$-OCOO- | -CO-CHMe-$C_2H_5$ | S | K 47.3 | A 41.6 I |

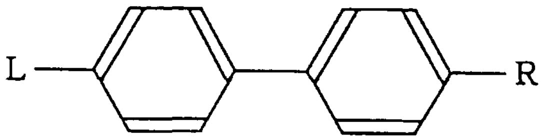

| L | R | | Cr | LC |
|---|---|---|---|---|
| $CH_3$-OCOO- | -COO-CHMe-$C_6H_{13}$ | 1 | K <20 | I |
| $C_9H_{19}$-OCOO- | -COO-$CH_2$-CHCl-CHMe-$CH_3$ | 1 | K 68 | $C^*$ 36 I |
| $C_9H_{19}$-OCOO- | -OOC-CHCl-CHMe-$CH_3$ | 1 | K 50 | $I^*$ 55 $C^*$ 58 I |
| $C_8H_{17}$-OCOO- | -OOC-CHCl-CHMe-$C_2H_5$ | 3 | K 29 | $C^*$ 29 A 41 I |
| $C_9H_{19}$-OCOO- | -OOC-CHCl-CHMe-$C_2H_5$ | 3 | K 25 | $I^*$ 27 $C^*$ 43 I |
| $C_8H_{17}$-OCOO- | -OOC-CHCl-CHMe-$C_2H_5$ | 5 | K 22 | $I^*$ 25 $C^*$ 37 I |
| $C_9H_{19}$-OCOO- | -OOC-CHCl-CHMe-$C_2H_5$ | 5 | K 15 | $I^*$ 25 $C^*$ 39 I |
| $C_8H_{17}$- | -CO-CH=CH-COO-$CH_2$-CHMe-$CH_3$ | | K 68.5 | N 43 I |
| $C_7H_{15}$- | -OOC-$CH_2$-CHMe-$C_2H_5$ | S | K 40.4 | S 68.7 I |
| $C_8H_{17}$-O- | -O-$CH_2$-CHMe-$C_2H_5$ | S | K 70.2 | S 83.7 H 86 I |
| $C_{10}H_{21}$-O- | -O-$CH_2$-CHMe-$C_2H_5$ | S | K 76 | H 78.3 $C^*$ 80.3 I |
| $C_{12}H_{25}$-O- | -O-$CH_2$-CHMe-$C_2H_5$ | S | K 75.3 | S 73.9 H 77.4 $C^*$ 78.9 A 79.8 I |
| $C_8H_{17}$-O- | -CO-$CH_2$-CHMe-$C_2H_5$ | S | K 70.4 | $C^*$ 68.3 A 98.3 I |
| $C_{12}H_{25}$-O- | -CO-$CH_2$-CHMe-$C_2H_5$ | 2 | K 74 | A 86 I |
| $C_4H_9$-O- | -COO-$CH_2$-CHMe-$C_2H_5$ | S | K 55.5 | S 73.8 I |
| $C_5H_{11}$-O- | -COO-$CH_2$-CHMe-$C_2H_5$ | S | K 57.5 | A 65.3 I |
| $C_6H_{13}$-O- | -COO-$CH_2$-CHMe-$C_2H_5$ | S | K 48 | A 66 I |
| $C_7H_{15}$-O- | -COO-$CH_2$-CHMe-$C_2H_5$ | S | K 41.5 | $C^*$ 43 A 64.2 I |
| $C_8H_{17}$-O- | -COO-$CH_2$-CHMe-$C_2H_5$ | S | K 49.2 | $C^*$ 44 A 65.9 I |
| $C_9H_{19}$-O- | -COO-$CH_2$-CHMe-$C_2H_5$ | S | K 60 | $C^*$ 38 A 64.4 I |
| $C_{10}H_{21}$-O- | -COO-$CH_2$-CHMe-$C_2H_5$ | S | K 48.2 | $C^*$ 41.2 A 66.2 I |
| $C_{11}H_{23}$-O- | -COO-$CH_2$-CHMe-$C_2H_5$ | S | K 40 | $C^*$ 50 A 63 U |
| $C_{12}H_{25}$-O- | -COO-$CH_2$-CHMe-$C_2H_5$ | S | K 53.2 | $C^*$ 39 A 63.8 I |
| $C_{13}H_{27}$-O- | -COO-$CH_2$-CHMe-$C_2H_5$ | S | K 50 | $C^*$ 51 A 64 U |
| $C_{14}H_{29}$-O- | -COO-$CH_2$-CHMe-$C_2H_5$ | S | K 61.1 | A 61.7 I |
| $C_6H_{13}$-O- | -COO-$CH_2$-CHCl-$CH_2$-CHMe-$CH_3$ | 1 | K 36 | $C^*$ 4 A 30 I |
| $C_8H_{17}$-O- | -COO-$CH_2$-CHCl-$CH_2$-CHMe-$CH_3$ | 1 | K 35 | S 0 $C^*$ 30 A 40 I |
| $C_9H_{19}$-O- | -COO-$CH_2$-CHCl-$CH_2$-CHMe-$CH_3$ | 1 | K 50 | $C^*$ 36 A 45 I |
| $C_{10}H_{21}$-O- | -COO-$CH_2$-CHCl-$CH_2$-CHMe-$CH_3$ | 1 | K 28 | $C^*$ 40 A 47 I |
| $C_{11}H_{23}$-O- | -COO-$CH_2$-CHCl-$CH_2$-CHMe-$CH_3$ | 1 | K 35 | A 47 I |

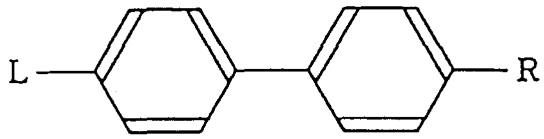

| L | R | | Cr | LC |
|---|---|---|---|---|
| $C_{12}H_{25}$-O- | -COO-$CH_2$-CHCl-$CH_2$-CHMe-$CH_3$ | 1 | K 48 | C* 42 A 48 I |
| $C_8H_{17}$-O- | -OOC-$CH_2$-CHMe-$C_2H_5$ | S | K 56.2 | S 91.8 C* 94.8 I |
| $C_{10}H_{21}$-O- | -OOC-$CH_2$-CHMe-$C_2H_5$ | S | K 65.7 | H 63.4 C* 83.9 A 99.8 I |
| $C_{14}H_{29}$-O- | -OOC-$CH_2$-CHMe-$C_2H_5$ | S | K 77.5 | C* 83.4 A 89.5 I |
| $C_5H_{11}$-O- | -OOC-CHCl-$CH_2$-CHMe-$CH_3$ | 1 | K ? | E 62.9 L 71.3 A 74.5 I |
| $C_6H_{13}$-O- | -OOC-CHCl-$CH_2$-CHMe-$CH_3$ | 1 | K 71 | C* 65 A 74 I |
| $C_7H_{15}$-O- | -OOC-CHCl-$CH_2$-CHMe-$CH_3$ | 1 | K 54 | C* 57 A 67.5 I |
| $C_8H_{17}$-O- | -OOC-CHCl-$CH_2$-CHMe-$CH_3$ | 1 | K 64 | C* 56.5 A 67 I |
| $C_9H_{19}$-O- | -OOC-CHCl-$CH_2$-CHMe-$CH_3$ | 1 | K 67 | C* 54 A 66.5 I |
| $C_2H_5$-OOC- | -OOC-CHMe-O-$CH_2$-CHMe-$C_2H_5$ | 3 | K ? | I |
| $C_7H_{15}$-COO- | -$CH_2$-CHMe-$C_2H_5$ | S | K 30 | B 66 I |
| $C_4H_9$-COO- | -O-$CH_2$-CHMe-$C_2H_5$ | S | K 86 | B 85 I |
| $C_9H_{19}$-COO- | -O-$CH_2$-CHMe-$C_2H_5$ | 1 | K ? | B 117 I |
| $C_6H_{13}$-COO- | -COO-$CH_2$-CHMe-$C_2H_5$ | S | K 22.4 | C* 18.4 A 51.9 I |
| $C_7H_{15}$-COO- | -COO-$CH_2$-CHMe-$C_2H_5$ | S | K 33.7 | C* 33.1 A 57.1 I |
| $C_8H_{17}$-COO- | -COO-$CH_2$-CHMe-$C_2H_5$ | S | K 35.9 | C* 41.8 A 59.7 I |
| $C_9H_{19}$-COO- | -COO-$CH_2$-CHMe-$C_2H_5$ | S | K 34.2 | C* 47.4 A 61.6 I |
| $C_{10}H_{21}$-COO- | -COO-$CH_2$-CHMe-$C_2H_5$ | S | K 43.9 | C* 49.6 A 62.3 I |
| $C_{11}H_{23}$-COO- | -COO-$CH_2$-CHMe-$C_2H_5$ | S | K 45 | C* 50.4 A 63.8 I |
| $C_{12}H_{25}$-COO- | -COO-$CH_2$-CHMe-$C_2H_5$ | S | K 41.2 | C* 50.5 A 63.6 I |
| $C_{13}H_{27}$-COO- | -COO-$CH_2$-CHMe-$C_2H_5$ | S | K 52.9 | C* 51.1 A 64.8 I |
| $C_{15}H_{31}$-COO- | -COO-$CH_2$-CHMe-$C_2H_5$ | S | K 60.9 | A 64.2 I |
| $C_6H_{13}$-COO- | -COO-$CH_2$-CHCl-$CH_2$-CHMe-$CH_3$ | 1 | K 34 | C* 4 A 30 I |
| $C_8H_{17}$-COO- | -COO-$CH_2$-CHCl-$CH_2$-CHMe-$CH_3$ | 1 | K 35 | S 0 C* 30 A 40 I |
| $C_{10}H_{21}$-COO- | -COO-$CH_2$-CHCl-$CH_2$-CHMe-$CH_3$ | 1 | K 28 | C* 40 A 46 I |
| $C_8H_{17}$-COO- | -COO-$CH_2$-CH(OMe)-$CH_2$-CHMe-$CH_3$ | 1 | K 31.7 | A 31.7 I |
| $C_9H_{19}$-COO- | -COO-$CH_2$-CH(OMe)-$CH_2$-CHMe-$CH_3$ | 1 | K 38.2 | A 37.2 I |
| $C_{10}H_{21}$-COO- | -COO-$CH_2$-CH(OMe)-$CH_2$-CHMe-$CH_3$ | 1 | K 41.5 | A 43.4 I |
| $C_{12}H_{25}$-COO- | -COO-$CH_2$-CH(OMe)-$CH_2$-CHMe-$CH_3$ | 1 | K 51.7 | A 39.8 E |
| $C_8H_{17}$-COO- | -OOC-CHCl-$CH_2$-CHMe-$CH_3$ | 1 | K 55 | S 55 C* 68 A 70 I |

L 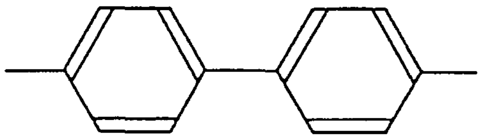 R

| L | R | | Cr | LC |
|---|---|---|---|---|
| $C_9H_{19}$-COO- | -OOC-CHCl-$CH_2$-CHMe-$CH_3$ | 1 | K 54 | S 55 C* 68 A 71 I |
| $C_8H_{17}$-OCOO- | -$CH_2$-CHMe-$C_2H_5$ | S | K 36.8 | C* 24.5 N* 27 I |
| $C_6H_{13}$-OCOO- | -O-$CH_2$-CHMe-$C_2H_5$ | S | K 49 | C* 48 I |
| $C_8H_{17}$-OCOO- | -O-$CH_2$-CHMe-$C_2H_5$ | S | K 55 | C* 47 N* 49.5 I |
| $C_9H_{19}$-OCOO- | -O-$CH_2$-CHMe-$C_2H_5$ | S | K 59 | C* 46 N* 49 I |
| $C_8H_{17}$-OCOO- | -OOC-CHCl-$CH_2$-CHMe-$CH_3$ | 1 | K 20 | I* 22 C* 34 I |
| $C_9H_{19}$-OCOO- | -OOC-CHCl-$CH_2$-CHMe-$CH_3$ | 1 | K 0 | I* 21 C* 35 I |
| $C_7H_{15}$-O- | -$C_2H_4$-CHMe-$C_2H_5$ | S | K 14.1 | S 54 S 64.9 I |
| $C_8H_{17}$-O- | -$C_2H_4$-CHMe-$C_2H_5$ | S | K 43 | S 57.9 H 62.5 C* 65.1 I |
| $C_9H_{19}$-O- | -$C_2H_4$-CHMe-$C_2H_5$ | S | K 58.4 | S 49.9 H 59 C* 62.7 A 63.5 I |
| $C_{10}H_{21}$-O- | -$C_2H_4$-CHMe-$C_2H_5$ | S | K 47.3 | S 51 H 53.6 C* 58.9 A 62.9 I |
| $C_{12}H_{25}$-O- | -CO-$C_2H_4$-CHMe-$CH_3$ | | K 98 | A 113 I |
| $C_8H_{17}$-O- | -COO-$C_2H_4$-CHMe-$C_2H_5$ | S | K 69 | C* 58 A 72 I |
| $C_9H_{19}$-O- | -COO-$C_2H_4$-CHMe-$C_2H_5$ | 1 | K 41 | S 45 C* 63 A 67 U |
| $C_{10}H_{21}$-O- | -COO-$C_2H_4$-CHMe-$C_2H_5$ | 1 | K 45 | S 53 C* 67 A 74 I |
| $C_8H_{17}$-O- | -OOC-$C_2H_4$-CHMe-$C_2H_5$ | 1 | K 7 | G* 92.5 A 93 I |
| $C_8H_{17}$-CO- | -OOC-$C_2H_4$-CHMe-$C_2H_5$ | 1 | K 74.2 | A 112 U |
| $C_9H_{19}$-CO- | -OOC-$C_2H_4$-CHMe-$C_2H_5$ | 1 | K 7 | S 68 C* 99.8 A 114.2 U |
| $C_8H_{17}$-O- | -COO-$C_3H_6$-CHMe-$C_2H_5$ | 1 | K 38 | G* 62.2 A 68 I |
| $C_8H_{17}$-O- | -COO-$C_2H_4$-CHMe-$C_3H_6$-CHMe-$CH_3$ | 1 | K 45 | C* 48 A 58 I |
| $C_9H_{19}$-O- | -COO-$C_2H_4$-CHMe-$C_3H_6$-CHMe-$CH_3$ | 1 | K 53 | A 54 I |
| $C_{12}H_{25}$-O- | -COO-$C_2H_4$-CHMe-$C_3H_6$-CHMe-$CH_3$ | S | K 50 | C* 47 A 53 I |
| $C_7H_{15}$-COO- | -COO-$C_2H_4$-CHMe-$C_3H_6$-CHMe-$CH_3$ | S | K 24.2 | B 41.3 A 65.7 I |
| $C_8H_{17}$-COO- | -COO-$C_2H_4$-CHMe-$C_3H_6$-CHMe-$CH_3$ | S | K 36.6 | J* 38.5 C* 43.9 A 55 I |
| $C_9H_{19}$-COO- | -COO-$C_2H_4$-CHMe-$C_3H_6$-CHMe-$CH_3$ | S | K 40.9 | J* 39.8 C* 51.5 A 56.4 I |
| $C_{10}H_{21}$-COO- | -COO-$C_2H_4$-CHMe-$C_3H_6$-CHMe-$CH_3$ | S | K 45.3 | J* 42.9 C* 53.8 A 56.9 I |
| $C_{11}H_{23}$-COO- | -COO-$C_2H_4$-CHMe-$C_3H_6$-CHMe-$CH_3$ | S | K 51.2 | J* 46.8 C* 55.9 A 56.5 I |
| $C_{12}H_{25}$-COO- | -COO-$C_2H_4$-CHMe-$C_3H_6$-CHMe-$CH_3$ | S | K 57.8 | A 55.5 I |
| $C_{10}H_{21}$- | -O-$C_4H_8$-CHMe-$C_3H_7$ | 2 | K 22 | C 60.5 I |
| $C_{10}H_{21}$- | -O-$C_5H_{10}$-CHMe-$C_2H_5$ | 2 | K 26.5 | C 69.5 I |

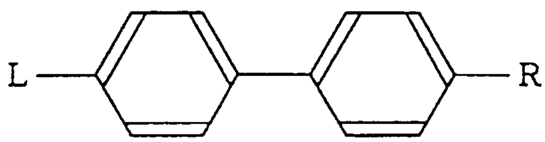

| L | R | | Cr | LC |
|---|---|---|---|---|
| $C_8H_{17}$-O- | -OOC-CHF-$C_6H_{13}$ | 1 | K ? | C* ? I |
| $C_5H_{11}$-O- | -OOC-CHCl-$C_2H_5$ | 1 | K 103.5 | G* 107 I |
| $C_6H_{13}$-O- | -OOC-CHCl-$C_2H_5$ | 1 | K 96 | H 87 G* 103 A 107 I |
| $C_7H_{15}$-O- | -OOC-CHCl-$C_2H_5$ | 1 | K 91.5 | H 80 G* 93 F* 96 A 104 I |
| $C_8H_{17}$-O- | -OOC-CHCl-$C_2H_5$ | 1 | K 98 | H 71 G* 91 F* 95 A 104 I |
| $C_9H_{19}$-O- | -OOC-CHCl-$CH_3$ | S | K ? | G* <? I |
| $C_9H_{19}$-O- | -OOC-CHCl-$C_2H_5$ | 1 | K 100 | G* 85 F* 96 A 102.5 I |
| $C_{10}H_{21}$-O- | -OOC-CHCl-$C_2H_5$ | 1 | K 100 | G* 82 F* 85 A 101 I |
| $C_{12}H_{25}$-O- | -OOC-CHCl-$C_2H_5$ | ·1 | K 96 | G* 74 F* 95 A 100 I |
| $C_9H_{19}$-COO- | -OOC-CHCl-$C_2H_5$ | 1 | K 123 | S 132 I |
| $C_8H_{17}$-OCOO- | -OOC-CHCl-$C_2H_5$ | 1 | K 62 | I* 70 C* 80 I |
| $C_8H_{17}$- | -COO-$CH_2$-CHCl-$CH_3$ | 1 | K 38.5 | A 34 I |
| $C_5H_{11}$-O- | -COO-$CH_2$-CHCl-$CH_3$ | R | K 80 | A 92.5 I |
| $C_6H_{13}$-O- | -COO-$CH_2$-CHCl-$CH_3$ | R | K 73 | A 86.4 I |
| $C_7H_{15}$-O- | -COO-$CH_2$-CHCl-$CH_3$ | R | K 79 | A 86.7 I |
| $C_8H_{17}$-O- | -COO-$CH_2$-CHCl-$CH_3$ | R | K 77.5 | A 86.2 I |
| $C_9H_{19}$-O- | -COO-$CH_2$-CHCl-$CH_3$ | R | K 84 | A 86.7 I |
| $C_{10}H_{21}$-O- | -COO-$CH_2$-CHCl-$CH_3$ | R | K 82.8 | A 87 I |
| $C_{12}H_{25}$-O- | -COO-$CH_2$-CHCl-$CH_3$ | R | K 85.5 | A 86.1 I |
| $C_{10}H_{21}$-O- | -OOC-$CH_2$-CHCl-$CH_3$ | 1 | K 96 | S 95 S 108 I |
| $C_8H_{17}$-COO- | -COO-$CH_2$-CHCl-$CH_3$ | 1 | K 61.3 | E 30.5 B 69.7 A 90.2 I |
| $C_8H_{17}$-COO- | -COO-$CH_2$-CHCl-$C_2H_5$ | S | K 25 | C* 22 A 56 I |
| $C_9H_{19}$-COO- | -COO-$CH_2$-CHCl-$CH_3$ | 1 | K 48.4 | A 80 I |
| $C_8H_{17}$-COO- | -COO-$C_2H_4$-CHCl-$CH_3$ | S | K 50.4 | J* 53.2 I* 53.2 A 65 I |
| $C_9H_{19}$-COO- | -COO-$C_2H_4$-CHCl-$CH_3$ | S | K 53.8 | J* 57.4 A 67.5 I |
| $C_{10}H_{21}$-COO- | -COO-$C_2H_4$-CHCl-$CH_3$ | S | K 58.4 | J* 60.3 A 68.2 I |
| $C_{11}H_{23}$-COO- | -COO-$C_2H_4$-CHCl-$CH_3$ | S | K 66.2 | J* 63.7 A 69.3 I |
| $C_{13}H_{27}$-COO- | -COO-$C_2H_4$-CHCl-$CH_3$ | S | K 70.6 | A 69.6 I |
| $C_4H_9$-O- | -CO-CHBr-$CH_3$ | 2 | K 97 | A 103 I |
| $C_5H_{11}$-O- | -CO-CHBr-$CH_3$ | 2 | K 91 | A 99 I |

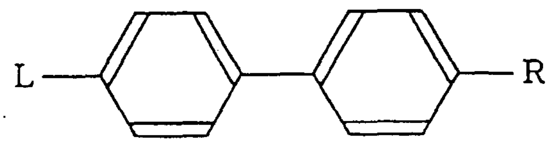

| L | R | | Cr | LC |
|---|---|---|---|---|
| $C_6H_{13}$-O- | -CO-CHBr-$CH_3$ | 2 | K 85 | A 99 I |
| $C_7H_{15}$-O- | -CO-CHBr-$CH_3$ | 2 | K 78 | A 103 I |
| $C_8H_{17}$-O- | -CO-CHBr-$CH_3$ | 2 | K 84 | A 103 I |
| $C_9H_{19}$-O- | -CO-CHBr-$CH_3$ | 2 | K 80 | A 103 I |
| $C_{10}H_{21}$-O- | -CO-CHBr-$CH_3$ | 2 | K 71 | A 103 I |
| $C_{12}H_{25}$-O- | -CO-CHBr-$C_3H_7$ | 2 | K 95 | A 78 I |
| $C_3H_7$- | -$CF_3$ | | K 97 | N -80 E |
| $C_3H_7$- | -O-$CF_3$ | | K 92 | N -60 E |
| $C_5H_{11}$- | -S-$CF_3$ | | K 31 | N -80 E |
| $C_5H_{11}$- | -O-$CH_2$-$CF_3$ | | K 107 | N -30 E |
| $C_5H_{11}$- | -CO-$CF_3$ | | K 13 | N -40 E |
| $C_4H_9$-O- | -$C_6F_{13}$ | | K 86 | S 104 I |
| $C_7H_{15}$-O- | -$CF_3$ | | K 69 | B 114.5 I |
| $C_8H_{17}$-O- | -$CF_3$ | | K 115 | N -20 E |
| $C_4H_9$-O- | -S-$CF_3$ | | K 82 | N -40 E |
| $C_8H_{17}$-O- | -COO-$CH_2$-$C_6F_{13}$ | | K 85 | C 109 A 119 I |
| $C_8H_{17}$-O- | -COO-$C_2H_4$-$C_4F_9$ | | K 108 | C 112 I |
| $C_8H_{17}$-O- | -COO-$C_2H_4$-$C_6F_{13}$ | | K 114 | C 125 A 127 I |
| $C_8H_{17}$-O- | -COO-$C_2H_4$-$C_8F_{17}$ | | K 122 | C 132 A 141 I |
| $C_8H_{17}$-O- | -COO-$C_2H_4$-$C_{10}F_{21}$ | | K 141 | A 152 I |
| $CH_3$-NH- | -$C_6F_{13}$ | | K 142 | S 168 I |
| $C_2H_5$-NH- | -$C_6F_{13}$ | | K 122 | S 174 I |
| $C_3H_7$-NH- | -$C_6F_{13}$ | | K 110 | S 134 I |
| $C_4H_9$-NH- | -$C_3F_7$ | | K 117 | S 123 I |
| $C_4H_9$-NH- | -$C_6F_{13}$ | | K 107 | S 145 I |
| $C_5H_{11}$-NH- | -$C_3F_7$ | | K 108 | S 111 I |
| $C_5H_{11}$-NH- | -$C_6F_{13}$ | | K 108 | S 133 I |
| $C_8H_{17}$-NH- | -$C_6F_{13}$ | | K 115 | S 113 I |
| $C_8H_{17}$-OOC- | -O-$C_2H_4$-$C_6F_{13}$ | | K ? | C ? A ? I |
| $C_9H_{19}$-COO- | -$CF_3$ | | K 63.3 | E 74 B 108.3 I |

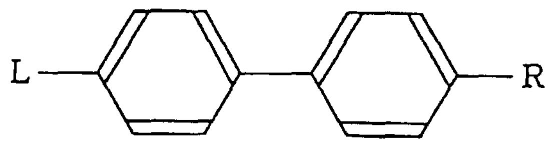

| L | R | | Cr | LC |
|---|---|---|---|---|
| $CH_3$-CHMe-$CH_2$-CHCl-COO- | -O-$CH_2$-$C_7F_{15}$ | 1 | K 88 | A 98 I |
| $C_2H_5$-CHMe-$CH_2$-O- | -O-$C_{11}H_{22}$-OOC-CH=$CH_2$ | S | K 62 | A 69 I |
| $C_2H_5$-CHMe-$CH_2$-OOC- | -O-$C_8H_{16}$-O-CH=$CH_2$ | S | K 37.6 | C* 30.2 A 53.3 I |
| $C_2H_5$-CHMe-$CH_2$-OOC- | -O-$C_2H_4$-OOC-CH=$CH_2$ | S | K 53 | A 49 I |
| $C_2H_5$-CHMe-$CH_2$-OOC- | -O-$C_6H_{12}$-OOC-CH=$CH_2$ | S | K 28 | C* 13 A 36 I |
| $C_2H_5$-CHMe-$CH_2$-OOC- | -O-$C_{10}H_{20}$-OOC-CH=$CH_2$ | S | K 48 | C* 42 A 64 I |
| $C_2H_5$-CHMe-$CH_2$-OOC- | -O-$C_{12}H_{24}$-OOC-CH=$CH_2$ | S | K 54.8 | A 43.7 I |
| $C_2H_5$-CHMe-$CH_2$-OOC- | -O-$C_6H_{12}$-CH=$CH_2$ | S | K 20 | C* 29 A 53 I |
| $C_2H_5$-CHMe-$CH_2$-OOC- | -OOC-$C_8H_{16}$-CH=$CH_2$ | S | K 44.5 | C* 41.7 A ? I |
| $C_2H_5$-CHF-COO- | -OOC-CHF-$C_2H_5$ | 3 | K ? | S 182.1 S 187 I |
| $C_3H_7$-CHF-COO- | -OOC-CHF-$C_3H_7$ | 3 | K 102.4 | S 131.5 I |
| $C_6H_{13}$-CHF-$CH_2$-O- | -O-$C_4H_8$-$C_4F_9$ | 1 | K ? | S 47 S 67 S 91 S 97 C* 112 A 130 I |
| $CH_3$-CHCl-COO- | -OOC-CHCl-$CH_3$ | 3 | K 132.7 | S 182.4 S 183.3 I |
| $C_2H_5$-CHCl-COO- | -OOC-CHCl-$C_2H_5$ | 3 | K 82.8 | S 83 S 102.2 I |
| $CH_3$-CHCl-COO- | -O-$C_4H_8$-CH=$CH_2$ | 1 | K 99 | E 112.5 B 118 I |
| $CH_3$-CHCl-COO- | -O-$C_9H_{18}$-CH=$CH_2$ | 1 | K 112 | A 108 I |
| $C_8F_{17}$-$C_{11}H_{22}$-O- | -COO-$CH_2$-$CF_3$ | | K 95 | S 82 A 113 I |
| $C_8F_{17}$-$C_{11}H_{22}$-O- | -COO-$CH_2$-$C_7F_{15}$ | | K 103 | C 115 I |
| $H_2C$=CH-$CH_2$-OOC-$C_5H_{10}$-O- | -COO-$C_5H_{10}$-O-$CH_2$-CH=$CH_2$ | | K 78 | I |
| $H_2C$=CH-$C_4H_8$-O- | -O-$C_4H_8$-CH=$CH_2$ | | K 51.2 | S 119.5 I |
| $C_5H_{11}$-C≡C- | -C≡C-$C_5H_{11}$ | | K 67.5 | S 88 I |
| $C_7H_{15}$-C≡C- | -C≡C-$C_7H_{15}$ | | K ? | S 73 I |

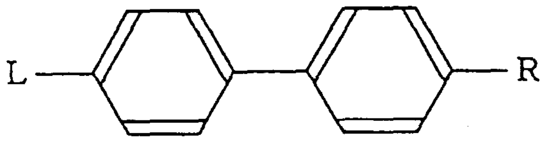

| L | R | | Cr | LC |
|---|---|---|---|---|
| $CH_3$-OOC- | -O-$C_9H_{18}$-CH=$CH_2$ | | K 95 | E 118 I |
| $CH_3$-OOC- | -OOC-$C_9H_{18}$-CH=$CH_2$ | | K 82 | I |
| $C_2H_5$-OOC-CHMe-OOC- | -O-$C_9H_{18}$-CH=$CH_2$ | 1 | K 48 | A 39 U |
| $C_6H_{13}$-O- | -O-$C_9H_{18}$-CH=$CH_2$ | | K 102 | S 102 S 105 I |
| $C_5H_{11}$- | -C:::C-H | | K 56.4 | S 82.7 I |
| $C_5H_{11}$- | -C:::C-$CH_3$ | | K 60.5 | S 83.4 I |
| $CH_3$-O- | -OOC-C:::C-C:::C-$C_{10}H_{21}$ | | K 54 | N 86 I |
| $CH_3$-O- | -O-$C_6H_{12}$-OOC-CH(-$CH_2$-C:::C-H)$_2$ | | K 75 | S 106 I |
| $CH_3$-O- | -OOC-$C_2H_4$-C:::C-H | | K 92 | N 68.1 I |
| $CH_3$-O- | -OOC-$C_9H_{18}$-C:::C-H | | K 78.7 | N 85.6 I |
| $C_2H_5$-CHMe-CHF-$CH_2$-OOC- | -O-$C_{11}H_{22}$-O-CH=$CH_2$ | 3 | K 48.5 | S 32 C* 34.7 A 54.3 I |
| $C_2H_5$-CHMe-CHCl-$CH_2$-OOC- | -O-$C_2H_4$-O-CH=$CH_2$ | 3 | K 56.2 | I |
| $C_2H_5$-CHMe-CHCl-$CH_2$-OOC- | -O-$C_6H_{12}$-O-CH=$CH_2$ | 3 | K 40 | C* 26.5 A 55 I |
| $C_2H_5$-CHMe-CHCl-$CH_2$-OOC- | -O-$C_9H_{18}$-O-CH=$CH_2$ | 3 | K 39 | C* ? A 51.3 I |
| $C_2H_5$-CHMe-CHCl-$CH_2$-OOC- | -O-$C_{11}H_{22}$-O-CH=$CH_2$ | 3 | K 41.9 | C* 21 A 38.3 I |
| $C_6H_{13}$-CHMe-O- | -O-$CH_2$-CH=$CH_2$ | 1 | K 77 | S 66 I |
| $C_2H_5$-CHMe-CHCl-COO- | -O-$CH_2$-CH=$CH_2$ | 3 | K 91 | I |
| $C_2H_5$-CHMe-CHCl-COO- | -O-$C_6H_{12}$-CH=$CH_2$ | 3 | K 41 | C* 35 A 51 I |
| $C_2H_5$-CHMe-CHCl-COO- | -O-$C_9H_{18}$-CH=$CH_2$ | 3 | K 49 | C* 33 A 52 I |
| $C_2H_5$-CHMe-CHCl-COO- | -O-$C_9H_{18}$-CH=$CH_2$ | 3 | K 36 | C* 46 A 59 I |
| $C_2H_5$-CHMe-$CH_2$- | -COO-$CH_2$-CHMe-$C_2H_5$ | 6 | K -4 | N* -70 E |
| $C_2H_5$-CHMe-$CH_2$- | -COO-$CH_2$-$C_7F_{15}$ | 1 | K 72 | A 101 I |
| $C_2H_5$-CHMe-$CH_2$-O- | -COO-$CH_2$-$C_7F_{15}$ | 1 | K ? | H 96 A 115 I |

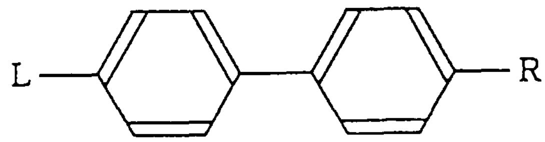

| L | R | | Cr | LC |
|---|---|---|---|---|
| $C_3H_7$- | $-O-CF_2-H$ | | K 84 | N -30 E |
| $C_3H_7$- | $-S-CF_2-H$ | | K 58 | N -70 E |
| $C_7H_{15}$- | $-SO-CF_2-H$ | 2 | K 72 | N -70 E |
| $C_7H_{15}$- | $-SO_2-CF_2-H$ | | K 50 | N -110 E |
| $C_8H_{17}-O-$ | $-O-CF_2-H$ | | K 104 | N 20 E |
| $C_8H_{17}-O-$ | $-COO-CHCF_3-C_6H_{13}$ | 1 | K 45.5 | E 69 A 74 I |
| $C_8H_{17}-OCOO-$ | $-OOC-CH_2-CHCF_3-C_4H_9$ | 1 | K ? | S 5 S 25 I |
| $C_8H_{17}-O-$ | $-COO-C_2H_4-CHCF_3-C_4H_9$ | 1 | K 42 | A 35 I |
| $C_5H_{11}$- | $-CH=CH_2$ | | K 122 | N 51.5 U |
| $C_8H_{17}$- | $-OOC-CH=CH-C_5H_{11}$ | | K 36 | E 59 B 66 N 75 I |
| $CH_3-O-$ | $-O-C_{11}H_{22}-O-CH=CH_2$ | | K 95 | I |
| $C_4H_9-O-$ | $-COO-C_4H_8-OOC-CH=CH_2$ | | K ? | S 55 I |
| $C_8H_{17}-O-$ | $-OOC-C_4H_8-OOC-CH=CH_2$ | | K 84.1 | S 91.7 I |
| $C_8H_{17}-O-$ | $-OOC-C_2H_4-CHMe-CH_2-OOC-CH=CH_2$ | 1 | K 48.7 | S 73.9 I |
| $C_8H_{17}$- | $-O-CH_2-CH=CH-C_5H_{11}$ | | K 75 | E 93 I |
| $CH_3-O-$ | $-O-C_6H_{12}-O-CH_2-CH=CH_2$ | | K 101 | N 98 I |
| $C_6H_{13}-O-$ | $-O-C_6H_{12}-O-CH_2-CH=CH_2$ | | K 100 | S 99 I |
| $CH_3-O-$ | $-O-C_2H_4-O-C_2H_4-O-C_2H_4-O-CH_2-CH=CH_2$ | | K 73 | X 83 I |
| $C_4H_9-OOC-CHMe-OOC-$ | $-O-C_8H_{16}-O-CH_2-CH=CH_2$ | 1 | K 10 | A 20 I |
| $CH_3-O-$ | $-OOC-C_3H_6-CH=CH_2$ | | K 70 | N 76 I |
| $C_2H_5$- | $-C_4H_8-CH=CH_2$ | | K ? | B 26.3 I |
| $C_4H_9$- | $-C_4H_8-CH=CH_2$ | | K 24.4 | B 38.5 I |
| $C_2H_5$- | $-C_6H_{12}-CH=CH_2$ | | K 9.4 | B 28.2 I |
| $C_4H_9$- | $-C_6H_{12}-CH=CH_2$ | | K -24.6 | B 42.4 I |
| $CH_3-O-$ | $-O-C_6H_{12}-CH=CH_2$ | | K 96 | E 108 I |
| $C_6H_{13}-O-$ | $-O-C_6H_{12}-CH=CH_2$ | | K 113 | S 112 I |
| $CH_3-OOC-$ | $-O-C_6H_{12}-CH=CH_2$ | | K 103 | E 123 S 127 I |
| $CH_3-O-$ | $-O-C_8H_{16}-CH=CH_2$ | | K 81 | E 108 I |
| $CH_3-O-$ | $-OOC-C_8H_{16}-CH=CH_2$ | | K 75 | N 79 I |

The liquid crystalline charge transfer materials of the present invention are useful for a variety of applications such as optical sensors, electro-luminescent elements, photoconductors, spacial optical modulators and thin-film transistors.

The liquid crystalline charge transfer materials of the present invention can attain high mobility of electric charges, and prevent the formation of structural traps. Therefore, optical sensors having high-speed responsibility can be mentioned as a primary application of these materials. Secondarily, the materials of the present invention are excellent in charge transferability, and they themselves are fluorescent, so that they can be used for charge transfer layers in electro-luminescent elements which can be produced with the mobility maintaining high. Moreover; the materials of the invention are such that orientation in an electric field and photoconductivity can be switched at the same time. Therefore, they can be used for image-displaying elements.

Figs. 1 to 4 are views for illustrating typical examples of the application of the charge transfer materials of the present invention to electro-luminescent elements. The simplest structure of the elements is shown in Fig. 1, in which a luminescent layer (charge transfer layer) 10, 14 is formed as a single layer; and sandwiched between a cathode

(transparent electrode) 13 provided on a transparent substrate 15' and an anode 13' provided on a substrate 15. Reference numeral 16 indicates a spacer. Only when the charge transfer material has both charge transferability and fluorescence like the liquid crystalline charge transfer materials of the present invention, it is possible to produce an electro-luminescent element having the above structure. In this case, in order to obtain strong luminescence, it is preferable that a material having a low work function be selected as a material for forming the cathode which acts as an electron injector and that a material having a work function which is equal to or greater than the work function of the cathode be selected for forming the anode.

Examples of materials for forming the anode generally include ITO, indium oxide, tin oxide (doped with antimony, arsenic, or fluorine), $Cd_2SnO_4$, zinc oxide, copper iodide, alkaline or alkaline earth metals such as sodium, potassium, magnesium and lithium, sodium-potassium alloys, magnesium-indium alloys, magnesium-silver alloys, aluminum, gold, silver, gallium, indium and copper, and those materials which are used for forming the cathode.

A material for forming the luminescent layer or charge transfer layer is composed of a charge transfer material and a luminescent material. The charge transfer material is preferably an electron-hole transfer material, a mixture of electron-hole transfer materials, or a mixture of an electron transfer material and a hole transfer material. However, in the case where luminescence at the surface of the electrode is utilized, a material which transfers only electrons or holes may also be used. Since the charge transfer materials of the present invention themselves are fluorescent, it is not necessary to use any luminescent material in the present invention; however, such a material may also be used along with the materials of the invention.

Further, in the case of an electro-luminescent element having a structure as shown in Fig. 3 or 4, the thickness of a luminescent layer (luminescent material) 10 is so made that the transfer of electrons or holes will not be impeded. The thickness of the luminescent layer is preferably from 0.2 to 15 μm; and it can be adjusted by scattering spacer particles in the luminescent material, or by a sealer to be provided around the periphery of the cell.

Figs. 5 to 7 are views for illustrating typical examples of the application of the charge transfer materials of the present invention to optical sensors. An optical sensor is composed of electrodes 13, 13', and a liquid crystalline charge transfer material 14 of the present invention. For optical sensors, such a property that the value of electric current changes when light is applied to the charge transfer materials can be utilized.

Fig. 8 is a view for illustrating a typical example of the application of the charge transfer materials of the present invention to image-displaying elements. An image-displaying element is composed of a transparent substrate 15 such as a glass plate, a transparent electrode 13 made from ITO (indium titanium oxide) or the like, a charge-generating layer 14' which generates carriers correspondingly to light applied to this layer, a liquid crystalline charge transfer material 14 of the present invention and a counter electrode (gold electrode) 13', which are successively laminated in the mentioned order. When light is applied image-wise (input image) to the lower part (transparent substrate) of the element, molecules in the liquid crystalline charge transfer material are oriented correspondingly to the light applied, and carriers flow toward the counter electrode (gold electrode) 13'. By optically reading this orientation of molecules in the liquid crystal, the input image can be reproduced. If the above liquid crystal is highly smectic, the orientation of molecules in the liquid crystal is maintained for a long time, and the input information can thus be maintained for a long time.

Fig. 9 is a view for illustrating an example of the application of the liquid crystalline charge transfer materials of the present invention to a charge transfer layer 14 in an image-recording device. While applying voltage to upper and lower electrodes 13 and 13' as shown in Fig. 9, light is applied pattern-wise to the upper part of the device. In a charge-generating layer 14', carriers are generated pattern-wise; and charges transferred by the charge transfer layer 14 are discharged in the space 19, and reach the surface of an information-recording layer 11.

The information-recording layer is a liquid crystal-polymer composite layer consisting of a smectic liquid crystal and a polymer. Molecules in the liquid crystal are oriented pattern-wise by an electric field produced by accumulated charges, and accumulated. Optical reading can thus be conducted.

Fig. 10 also shows an information-recording device. Application of voltage and that of light are conducted in the same manner as in the case of the information-recording device shown in Fig. 9. Charges generated (image) are accumulated on the upper surface of a dielectric layer 20, and optical reading can thus be conducted.

Further; the liquid crystalline charge transfer materials of the present invention can also be used for a spacial optical modulator as schematically shown in Fig. 11. Moreover, they can also be used as an active layer in a thin-film transistor. For example, as shown in Fig. 12, the above-described liquid crystalline material can be used by providing it on a substrate on which a source electrode, a drain electrode and a gate electrode have been arranged.

The present invention will now be explained more specifically by referring to the following Examples. However, the present invention is not limited by these examples.

Example A1

4-Heptyloxybiphenylcarbonic acid (manufactured by Teikoku Chemical Industries Co., Ltd., Japan) and 7-hydroxy-4-methylcumarin (synthesized in accordance with the description in *J. Chem. Soc. Chem. Commun.,* (2) 225-226, 1995) were dissolved in 4-pyridinyl phenol, and dehydration condensation was then carried out at 90°C by using 1,3-dicyclohexylcarbodiimide to synthesize 7-hydroxy-6-(4-heptyloxybiphenylcarboxy)-4-methylcumarin.

Example A2

Two glass substrates, each having thereon an ITO electrode (surface resistance: 100 to 200 Ω/□) formed by means of vacuum deposition were bonded with the ITO electrodes facing each other; a gap being provided between the substrates by using spacer particles, thereby obtaining a cell. Into this cell, the 7-hydroxy-6-(4-heptyloxybiphenylcarboxy)-4-methylcumarin obtained in Example A1 was injected under the condition of 110°C. When a direct current electric field of 250 V was applied to this cell, luminescence originating from the above compound was observed.

Example A3

A glass substrate on which an ITO electrode (surface resistance: 100 to 200 Ω/□) had been provided by means of vacuum deposition, and a glass substrate on which an Ag electrode (specific resistance: 1 Ω/cm or less) film thickness: 3,000 Å) had been provided were bonded with the electrodes facing each other, a gap being provided between the substrates by using spacer particles, thereby obtaining a cell. Into this cell, a liquid crystalline material which was the compound obtained in Example A1 was injected under the condition of 11°C. When a direct current electric field of 250 V was applied to this cell in a dark room, luminescence originating from the above liquid crystalline material was observed.

Example A4

A cell having the structure shown in Fig. 2 was made by using a liquid crystalline material which was the compound obtained in Example A1, where the liquid crystalline material was injected into the cell under the condition of 110°C. When a direct current electric field of 250 V was applied to this cell in a dark room, luminescence originating from the above liquid crystalline material was observed.

Example A5

A cell having the structure shown in Fig. 3 was made by using a liquid crystalline material which was the compound obtained in Example A1, where the liquid crystalline material was injected into the cell under the condition of 110°C. When a direct current electric field of 250 V was applied to this cell in a dark room, luminescence originating from the above liquid crystalline material was observed.

Example A6

A cell having the structure shown in Fig. 4 was made by using a liquid crystalline material which was the compound obtained in Example A1, where the liquid crystalline material was injected into the cell under the condition of 110°C. When a direct current electric field of 250 V was applied to this cell in a dark room, luminescence originating from the above liquid crystalline material was observed.

Example B1

Two glass substrates, each having thereon an ITO electrode (surface resistance: 100 to 200 Ω/□) formed by means of vacuum deposition were bonded with the ITO electrodes facing each other, a gap being provided between the substrates by using spacer particles, thereby obtaining a cell. Into this cell, benzthiazole liquid crystal (2-(4'-heptyloxyphenyl)-6-dodecylbenzothiazole, Crystal-90°C-SmA-100°C-Iso.) was injected under the condition of 110°C. When a direct current electric field of 250 V was applied to this cell, luminescence originating from the above compound was observed.

Example B2

A glass substrate on which an ITO electrode (surface resistance: 100 to 200 Ω/□) had been provided by means of vacuum deposition, and a glass substrate on which an Ag electrode (specific resistance: 1 □/cm or less, film thickness: 3,000 Å) had been provided were bonded with the electrodes facing each other, a gap being provided between the substrates by using spacer particles, thereby obtaining a cell. Into this cell, a liquid crystalline material which was the compound obtained in Example B1 was injected under the condition of 110°C. When a direct current electric field

of 250 V was applied to this cell in a dark room, luminescence originating from the above liquid crystalline material was observed.

Example B3

A cell having the structure shown in Fig. 2 was made by using a liquid crystalline material which was the compound obtained in Example B1, where the liquid crystalline material was injected into the cell under the condition of 110°C. When a direct current electric field of 250 V was applied to this cell in a dark room, luminescence originating from the above liquid crystalline material was observed.

Example B4

A cell having the structure shown in Fig. 3 was made by using a liquid crystalline material which was the compound obtained in Example B1, where the liquid crystalline material was injected into the cell under the condition of 110°C. When a direct current electric field of 250 V was applied to this cell in a dark room, luminescence originating from the above liquid crystalline material was observed.

Example B5

A cell having the structure shown in Fig. 4 was made by using a liquid crystalline material which was the compound obtained in Example B1, where the liquid crystalline material was injected into the cell under the condition of 110°C. When a direct current electric field of 250 V was applied to this cell in a dark room, luminescence originating from the above liquid crystalline material was observed.

## Claims

1. A liquid crystalline charge transfer material having the following structure (A) containing a fluorescent skeletal structure Y, and the core Z of a liquid crystal:

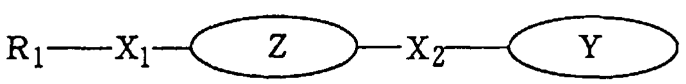

(A)

in which $R_1$, which may directly be combined with Z without interposing $X_1$, represents a saturated or unsaturated, and linear, branched or cyclic hydrocarbon group having 1 to 22 carbon atoms; and $X_1$ and $X_2$ represent oxygen atom, sulfur atom, or -CO-, -OCO-, -COO-, -N=CH-, -CONH-, -NH-, -NHCO- or $-CH_2-$ group.

2. The liquid crystalline charge transfer material according to claim 1, wherein Z has a structure represented by $Z_1$ or $Z_1$-$Z_2$-$Z_3$, in which $Z_1$ and $Z_3$ are $(6\pi$ electron system aromatic ring$)_l$, $(10\pi$ electron system aromatic ring$)_m$ or $(14\pi$ electron system aromatic ring$)_n$ (where l, m and n are an integer of 0 to 4, provided that l + m + n = l to 4 ), and $Z_2$ is -CH=CH-, -C≡C-, -N=N-, -CH=N- or -COO- group, or $Z_1$ and $Z_3$ are directly combined with each other.

3. The liquid crystalline charge transfer material according to claim 1 or 2, wherein Y is selected from radicals of metal chelate compounds, polycyclically condensed or conjugated aromatic hydrocarbons, diphenylethylene derivatives, triphenylamine derivatives, diaminocarbazole derivatives, bisstyryl derivatives, benzothiazole derivatives, benzoxazole derivatives, aromatic diamine derivatives, quinacridone compounds, perylene compounds, oxadiazole derivatives, cumarin compounds and anthracene derivatives.

4. An electro-luminescent element containing in its driving path at least one material set forth in any one of claims 1 to 3.

5. All electro-luminescent element whose charge transfer part and luminescent part are made from at least one material set forth in any one of claims 1 to 3.

6. An electro-luminescent element which contains in its driving path at least one material set forth in any one of claims 1 to 3 and whose charge transfer part and luminescent part are composed of a single layer.

7. All optical sensor containing in its driving path at least one material set forth in any one of claims 1 to 3.

8. A photoconductor containing in its driving path at least one material set forth in any one of claims 1 to 3.

9. An image-displaying element containing in its driving path at least one material set forth in any one of claims 1 to 3.

10. A spacial optical modulator containing in its driving path at least one material set forth in any one of claims 1 to 3.

11. A thin-film transistor containing in its driving path at least one material set forth in any one of claims 1 to 3.

12. A liquid crystalline charge transfer material having the following skeletal structure (B) containing the fluorescent core Y of a liquid crystal:

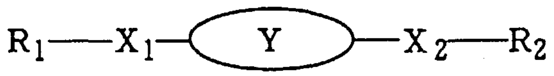

(B)

in which $R_1$ and $R_2$, which may directly be combined with Y without interposing $X_1$ and $X_2$, each represent a saturated or unsaturated, and linear, branched or cyclic hydrocarbon group having 1 to 22 carbon atoms; and $X_1$ and $X_2$ represent oxygen atom, sulfur atom, or -CO-, -OCO-, -COO-, -N=CH-, -CONH-, -NH-, -NHCO- or - $CH_2$- group.

13. The liquid crystalline charge transfer material according to claim 12, wherein Y is (6π electron system aromatic ring)$_l$, (10π electron system aromatic ring)$_m$ or (14π electron system aromatic ring)$_n$ (where l, m and n are an integer of 0 to 4, provided that l + m + n = 1 to 4 ), and the aromatic rings may be combined through -CH=CH-, -C≡C-, -N=N-, -CH=N- or -COO- group.

14. The liquid crystalline charge transfer material according to claim 12, wherein Y is selected from radicals of metal chelate compounds, polycyclically condensed or conjugated aromatic hydrocarbons, diphenylethylene derivatives, triphenylamine derivatives, diaminocarbazole derivatives, bisstyryl derivatives, benzothiazole derivatives, benzoxazole derivatives, aromatic diamine derivatives, quinacridone compounds, perylene compounds, oxadizole derivatives, cumarin compounds and anthracene derivatives.

15. An electro-luminescent element containing in its driving path at least one material set forth in any one of claims 12 to 14.

16. An electro-luminescent element whose charge transfer part and luminescent part are made from at least one material set forth in any one of claims 12 to 14.

17. An electro-luminescent element which contains in its driving path at least one material set forth in any one of claims 12 to 14 and whose charge transfer part and luminescent part are composed of a single layer.

18. An optical sensor containing in its driving path at least one material set forth in any one of claims 12 to 14.

19. A photoconductor containing in its driving path at least one material set forth in any one of claims 12 to 14.

20. An image-displaying element containing in its driving path at least one material set forth in any one of claims 12 to 14.

21. A spacial optical modulator containing in its driving path at least one material set forth in my one of claims 12 to 14.

22. A thin-film transistor containing in its driving path at least one material set forth in any one of claims 12 to 14.

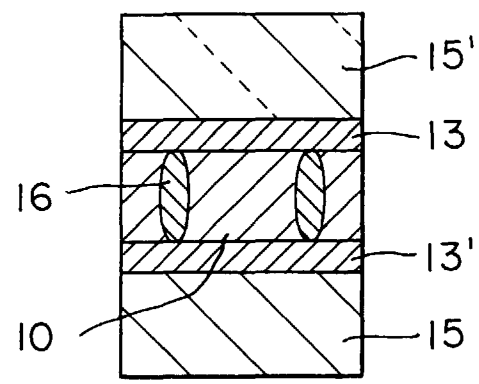


F I G. 1

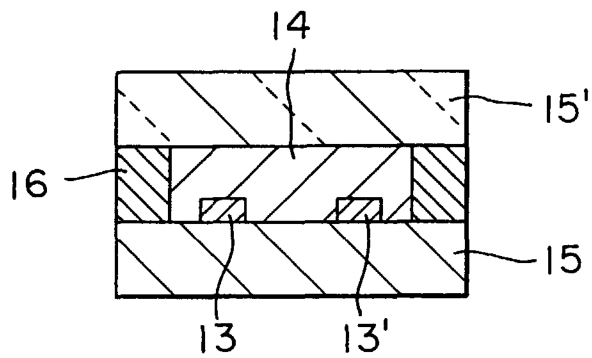


F I G. 2

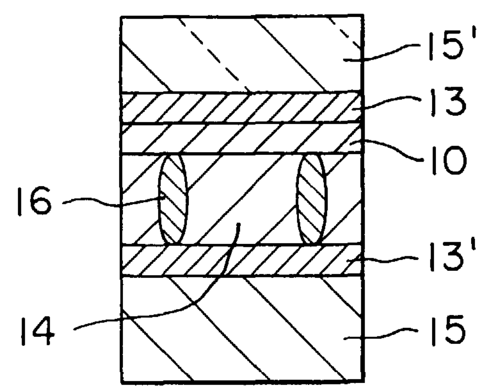


F I G. 3

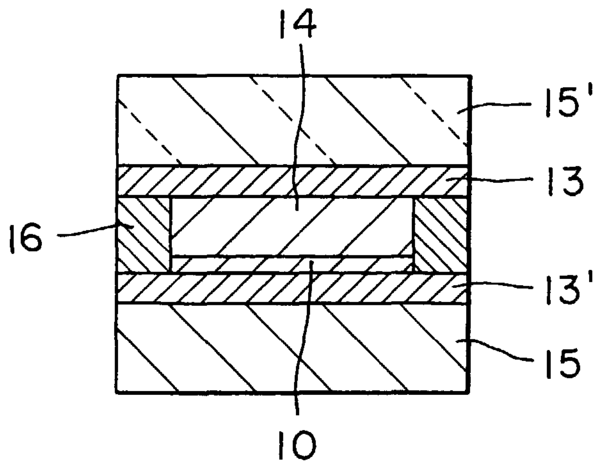


FIG. 4

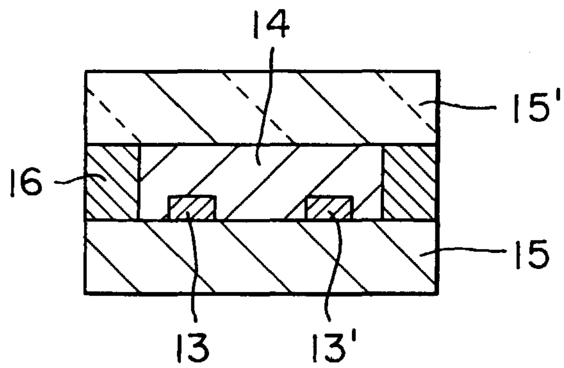


FIG. 5

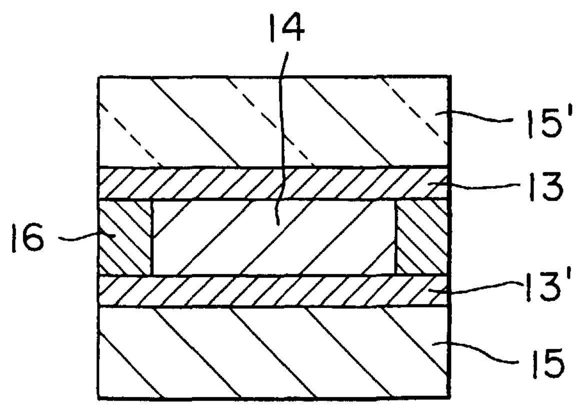


FIG. 6

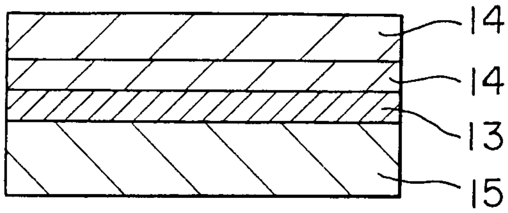


FIG. 7

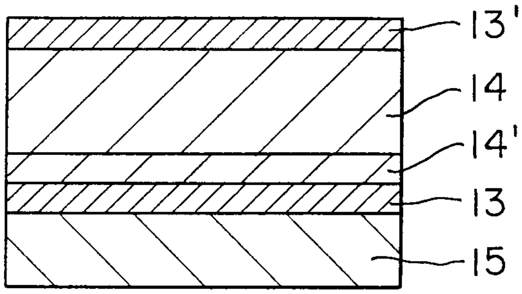


FIG. 8

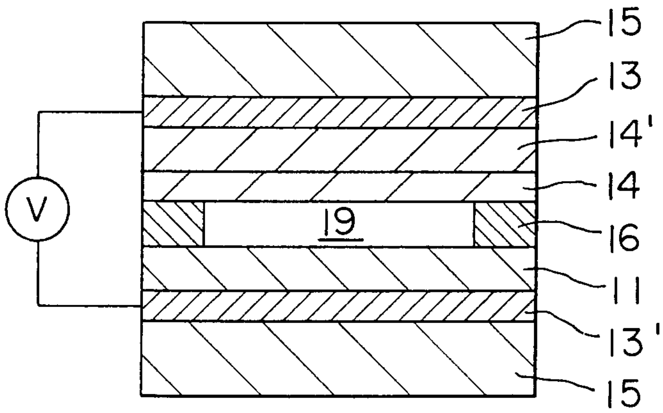


FIG. 9

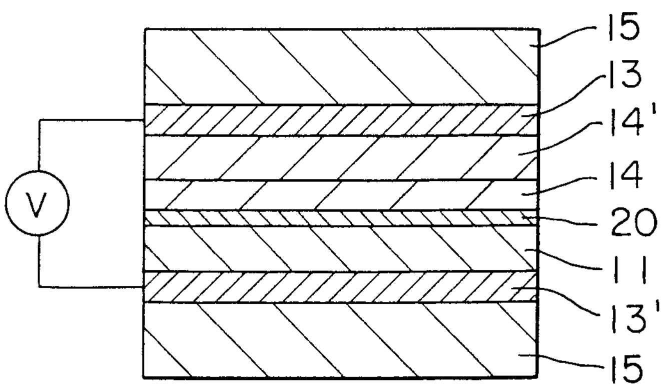


FIG. 10

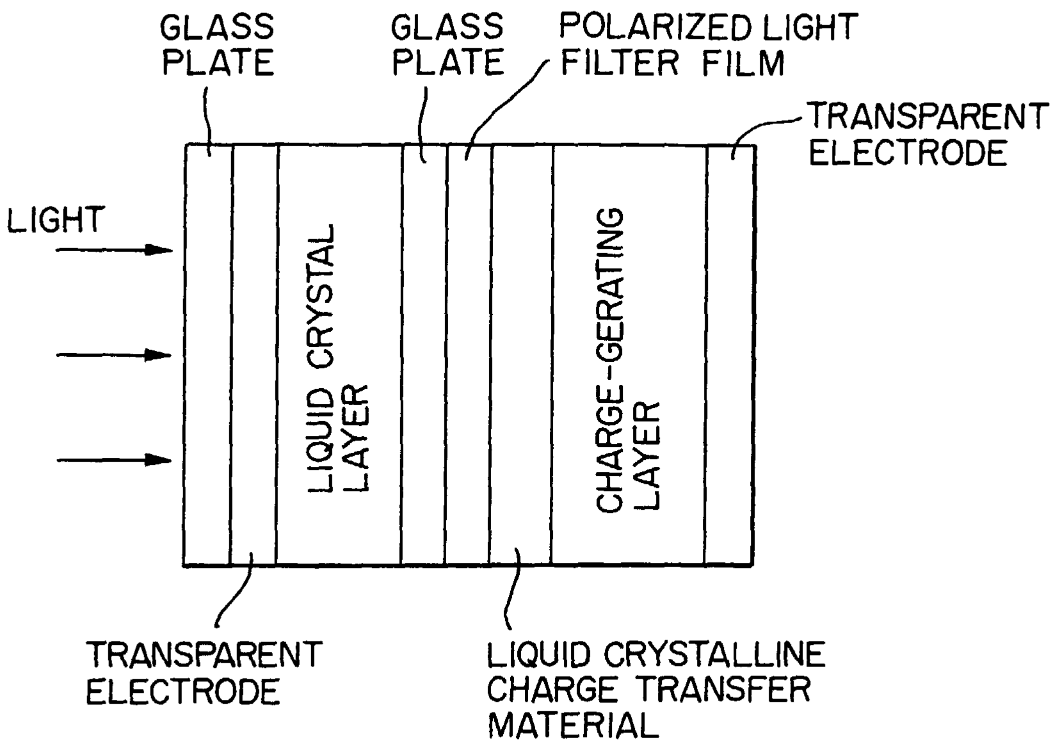
GLASS PLATE
GLASS PLATE
POLARIZED LIGHT FILTER FILM
TRANSPARENT ELECTRODE
LIGHT
LIQUID CRYSTAL LAYER
CHARGE-GERATING LAYER
TRANSPARENT ELECTRODE
LIQUID CRYSTALLINE CHARGE TRANSFER MATERIAL

FIG. 11

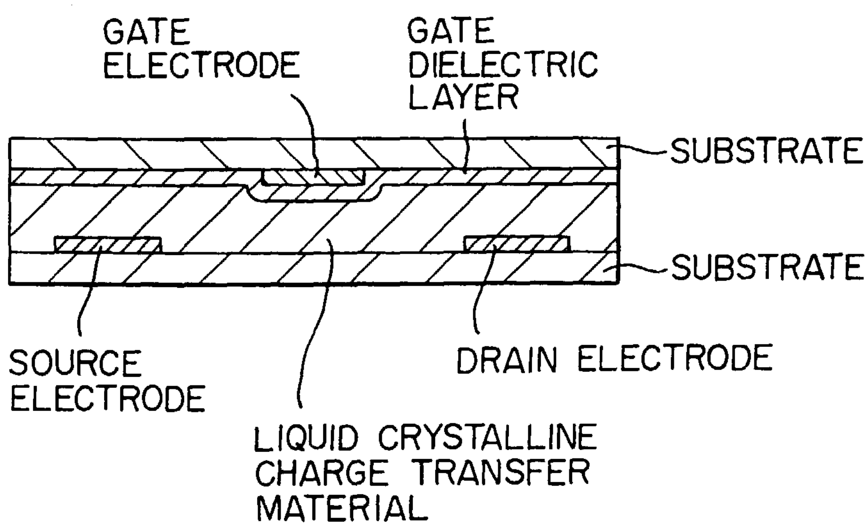
GATE ELECTRODE
GATE DIELECTRIC LAYER
SUBSTRATE
SUBSTRATE
SOURCE ELECTRODE
DRAIN ELECTRODE
LIQUID CRYSTALLINE CHARGE TRANSFER MATERIAL

FIG. 12

European Patent Office

# EUROPEAN SEARCH REPORT

Application Number
EP 98 12 0668

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | EP 0 763 532 A (DAINIPPON PRINTING CO LTD) 19 March 1997<br>* the whole document *<br>--- | 1-22 | C09K11/06<br>H05B33/14<br>C09K19/00 |
| X | WO 95 17018 A (SIEMENSMEYER KARL ;BASF AG (DE); HAARER DIETER (DE); FUNHOFF DIRK) 22 June 1995<br>* the whole document *<br>--- | 1-22 | |
| X | TOKUHISA ET AL: "Liquid crystalline oxadiazole with electron transporting capability"<br>CHEMISTRY LETTERS,April 1997, pages 303-304, XP002088494<br>* the whole document *<br>--- | 1-22 | |
| P,X | DE 198 09 944 A (MERCK PATENT GMBH) 1 October 1998<br>* the whole document *<br>--- | 1-22 | |
| P,X | EP 0 860 417 A (DAINIPPON PRINTING CO LTD) 26 August 1998<br>* the whole document *<br>--- | 1-22 | **TECHNICAL FIELDS SEARCHED (Int.Cl.6)**<br>C09K<br>H05B |
| X | TRIVEDI ET AL: "Mesomorphic heterocyclic homologous series: I. 7-(4'-n-alkoxybenzoyloxy)-3-acetylcoumarins II. 4'-formylphenyl 7-n-alkoxycoumarin-3-carboxylates"<br>MOLECULAR CRYSTALS AND LIQUID CRYSTALS, vol. 78, 1981, pages 263-270, XP002088495<br>Compounds 1-14<br>---<br>-/-- | 1-22 | |

The present search report has been drawn up for all claims

| Place of search | Date of completion of the search | Examiner |
|---|---|---|
| THE HAGUE | 18 December 1998 | Shade, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent Office

# EUROPEAN SEARCH REPORT

Application Number
EP 98 12 0668

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | NAKAI ET AL: "Thermal and dielectric properties of liquid crystals with a coumarin skeleton" BULLETIN OF THE CHEMICAL SOCIETY OF JAPAN, vol. 56, 1983, pages 3571-3577, XP002088496 * tables 1-5 * --- | 1-22 | |
| X | SHIMIZU ET AL: "Mesomorphic and photoconducting behaviour of 2-(2-hydroxy-4-alkoxybenzylideneamino)-9-methylcarbazoles" MOLECULAR CRYSTALS AND LIQUID CRYSTALS, vol. 140, 1986, pages 105-117, XP002088497 * page 105 - page 106 * --- | 1-22 | |
| X | EP 0 677 565 A (CANON KK) 18 October 1995 * page 8 - page 153 * --- | 1-22 | |
| X | EP 0 357 372 A (SUMITOMO CHEMICAL CO) 7 March 1990 * page 13, line 30 - page 19, line 24 * ----- | 1-22 | TECHNICAL FIELDS SEARCHED (Int.Cl.6) |

The present search report has been drawn up for all claims

| Place of search | Date of completion of the search | Examiner |
|---|---|---|
| THE HAGUE | 18 December 1998 | Shade, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 98 12 0668

This annex lists the patent family members relating to the patent documents cited in the above-mentioned European search report.
The members are as contained in the European Patent Office EDP file on
The European Patent Office is in no way liable for these particulars which are merely given for the purpose of information.

18-12-1998

| Patent document cited in search report | Publication date | Patent family member(s) | Publication date |
|---|---|---|---|
| EP 0763532 A | 19-03-1997 | JP 9059266 A | 04-03-1997 |
| | | JP 9059267 A | 04-03-1997 |
| | | JP 9255670 A | 30-09-1997 |
| | | US 5766510 A | 16-06-1998 |
| | | JP 9316442 A | 09-12-1997 |
| WO 9517018 A | 22-06-1995 | DE 4343412 A | 22-06-1995 |
| | | CN 1137841 A | 11-12-1996 |
| | | EP 0734592 A | 02-10-1996 |
| | | JP 9506646 T | 30-06-1997 |
| DE 19809944 A | 01-10-1998 | NONE | |
| EP 0860417 A | 26-08-1998 | JP 10231260 A | 02-09-1998 |
| EP 0677565 A | 18-10-1995 | JP 8092558 A | 09-04-1996 |
| | | US 5688437 A | 18-11-1997 |
| EP 0357372 A | 07-03-1990 | DE 68919391 D | 22-12-1994 |
| | | DE 68919391 T | 18-05-1995 |
| | | JP 2131443 A | 21-05-1990 |
| | | JP 2727675 B | 11-03-1998 |
| | | US 5385693 A | 31-01-1995 |
| | | US 5124070 A | 23-06-1992 |
| | | US 5264151 A | 23-11-1993 |
| | | JP 2131448 A | 21-05-1990 |
| | | JP 2725397 B | 11-03-1998 |
| | | JP 2174743 A | 06-07-1990 |
| | | JP 2734676 B | 02-04-1998 |
| | | JP 2167251 A | 27-06-1990 |
| | | JP 2743506 B | 22-04-1998 |
| | | JP 2196755 A | 03-08-1990 |
| | | JP 2811788 B | 15-10-1998 |

EPO FORM P0459

For more details about this annex : see Official Journal of the European Patent Office, No. 12/82